# EUROPEAN PATENT APPLICATION

(11) **EP 2 843 708 A1**
(43) Date of publication of application: **04.03.2015**
(21) Application number: 14182215.5
(22) Date of filing: 26.08.2014
(51) Int. Cl.: H01L 29/78, H01L 29/66

(54) **Nitride-based transistors and methods of fabricating the same**

(30) Priority: 28.08.2013 KR 20130102768; 25.10.2013 KR 20130127760; 25.10.2013 KR 20130127810; 22.11.2013 KR 20130142826
(71) Applicant: Seoul Semiconductor Co., Ltd., Ansan-si 425-090 (KR)
(72) Inventor: Takeya, Motonobu, Gyeonggi-do, 425-090 (KR); Lee, Kwan Hyun, Gyeonggi-do, 425-090 (KR)
(74) Representative: Stolmár & Partner

(57) **Abstract**

A method of fabricating a nitride-based transistor is provided. The method includes sequentially forming a first nitride-based semiconductor layer doped with first type dopants, a second nitride-based semiconductor layer doped with second type dopants, and a third nitride-based semiconductor layer doped with the first type dopants on a substrate. A first trench is formed to penetrate the third and second nitride-based semiconductor layers and to extend into the first nitride-based semiconductor layer. A fourth nitride-based semiconductor layer doped with the first type dopants is formed to fill the first trench. A second trench is formed in the fourth nitride-based semiconductor layer. A gate electrode is formed in the second trench. A source electrode is formed to be electrically connected to at least one of the third and fourth nitride-based semiconductor layers, and a drain electrode is formed to be electrically connected to the first nitride-based semiconductor layer.

## Description

### CROSS-REFERENCE TO RELATED APPLICATIONS

The present application claims priority under 35 U.S.C 119(a) to Korean Application Nos. 10-2013-0102768, 10-2013-0127760, 10-2013-0127810 and 10-2013-0142826, filed on August 28, 2013, October 25, 2013, October 25, 2013 and November 22, 2013, respectively, in the Korean intellectual property Office, which are incorporated herein by references in their entirety as set forth in full.

### BACKGROUND

### 1. Technical Field

Embodiments of the present disclosure relate to transistors and methods of fabricating the same and, more particularly, to nitride-based transistors and methods of fabricating the same.

### 2. Related Art

In the electronics industry, high voltage transistors operating at a high speed are increasingly in demand with the development of information and communication techniques. In response to such a demand, Group III - V compound semiconductor transistors, for example, gallium nitride (GaN) transistors have been proposed. The GaN transistors may exhibit a relatively fast switching characteristic and a relatively high breakdown voltage characteristic as compared with the conventional silicon transistors. Thus, the GaN transistors may be very attractive as candidates for improving the performance of communication systems.

In general, these GaN transistors are fabricated to have a planar-type configuration or a vertical-type configuration. Each of the planar-type GaN transistors may include a source region, a channel region and a drain region which are coplanar with each other. Thus, carriers may be drifted in a horizontal direction along a surface of the channel region. In such a case, there may be a limitation in improving the carrier mobility. This is because an electric field at a channel surface disturbs movement of the carriers. Further, when the planar-type GaN transistors operate, an electric field may be concentrated at corners of gate electrodes of the planar-type GaN transistors. This may lead to degradation of the breakdown voltage characteristic of the planar-type GaN transistors.

Recently, vertical GaN transistors have been proposed to solve the above disadvantages. For example, current aperture vertical electron transistors (CAVETs) are taught in U.S. patent publication No. US 2012/0319127 A1 to Chowdhury et al., entitled *"current aperture vertical electron transistors with ammonia molecular beam epitaxy grown P-type gallium nitride as a current blocking layer*". According to the U.S. patent publication No. US 2012/0319127 A1, a source electrode and a drain electrode are disposed to vertically face each other, and a P-type gallium nitride (P-GaN) layer acting as a current blocking layer is disposed between the source and drain electrodes. Accordingly, a channel current flows in a vertical direction from the drain electrode toward the source electrode through an aperture provided by the P-type gallium nitride (P-GaN) layer.

In order to commercialize the vertical GaN transistors, a carrier mobility in a channel region has to be still improved and a leakage current between the source electrode and the drain electrode has to be reduced to improve the reliability of the vertical GaN transistors.

### SUMMARY

Various embodiments are directed to nitride-based transistors and methods of fabricating the same.

According to some embodiments, a method of fabricating a nitride-based transistor includes sequentially forming a first nitride-based semiconductor layer doped with dopants having a first type, a second nitride-based semiconductor layer doped with dopants having a second type, and a third nitride-based semiconductor layer doped with dopants having the first type on a substrate. A first trench is formed to penetrate the third nitride-based semiconductor layer and the second nitride-based semiconductor layer and to extend into the first nitride-based semiconductor layer. A fourth nitride-based semiconductor layer doped with dopants having the first type is formed to fill the first trench. A second trench is formed in the fourth nitride-based semiconductor layer. A gate electrode is formed in the second trench. A source electrode is formed to be electrically connected to at least one of the third and fourth nitride-based semiconductor layers, and a drain electrode is formed to be electrically connected to the first nitride-based semiconductor layer.

According to further embodiments, a nitride-based transistor includes a first nitride-based semiconductor layer doped with dopants having a first type, a pair of second nitride-based semiconductor patterns doped with dopants having a second type and disposed in the first nitride-based semiconductor layer, a third nitride-based semiconductor layer doped with dopants having the first type and disposed on the first nitride-based semiconductor layer, a gate dielectric layer disposed on sidewalls and a bottom surface of a trench vertically penetrating the first nitride-based semiconductor layer between the pair of second nitride-based semiconductor patterns, a gate electrode disposed in the trench surrounded by the gate dielectric layer, a source electrode electrically connected to the third nitride-based semiconductor layer, and a drain electrode electrically connected to the first nitride-based semiconductor layer.

According to further embodiments, a method of fabricating a vertical nitride-based transistor includes sequentially forming a first nitride-based semiconductor layer doped with dopants having a first type, a current blocking insulation layer, a second nitride-based semiconductor layer doped with dopants having a second type, and a third nitride-based semiconductor layer doped with dopants having the first type on a substrate. A first trench is formed to penetrate the third and second nitride-based semiconductor layers and the current blocking insulation layer and to extend into the first nitride-based semiconductor layer. A fourth nitride-based semiconductor layer doped with dopants having the first type is formed to fill the first trench. A second trench is formed in the fourth nitride-based semiconductor layer. A gate electrode is formed in the second trench. A source electrode is formed to be electrically connected to at least one of the third and fourth nitride-based semiconductor layers, and a drain electrode is formed to be electrically connected to the first nitride-based semiconductor layer.

According to further embodiments, a method of fabricating a vertical nitride-based transistor includes sequentially forming a lower nitride-based semiconductor layer heavily doped with dopants having a first type, a first nitride-based semiconductor layer lightly doped with dopants having the first type, a current blocking insulation layer, a second nitride-based semiconductor layer doped with dopants having a second type, and a third nitride-based semiconductor layer doped with dopants having the first type on a substrate. A first trench is formed to penetrate the third and second nitride-based semiconductor layers and the current blocking insulation layer and to extend into the first nitride-based semiconductor layer. A fourth nitride-based semiconductor layer doped with dopants having the first type is formed on the third nitride-based semiconductor layer to fill the first trench. An upper nitride-based semiconductor layer heavily doped with dopants having the first type is formed on the fourth nitride-based semiconductor layer. At least the upper nitride-based semiconductor layer and the fourth nitride-based semiconductor layer are patterned to form a second trench in the first trench. A gate electrode is formed in the second trench. A source electrode is formed to contact the upper nitride-based semiconductor layer and a drain electrode is formed to contact the lower nitride-based semiconductor layer. The source electrode is formed of a material exhibiting an ohmic contact with respect to the upper nitride-based semiconductor layer, and the drain electrode is formed of a material exhibiting an ohmic contact with respect to the lower nitride-based semiconductor layer.

According to further embodiments, a method of fabricating a vertical nitride-based transistor includes sequentially forming a lower nitride-based semiconductor layer heavily doped with dopants having a first type, a first nitride-based semiconductor layer lightly doped with dopants having the first type, a current blocking insulation layer, a second nitride-based semiconductor layer doped with dopants having a second type, and an upper nitride-based semiconductor layer doped with dopants having the first type on a substrate. A first trench is formed to penetrate the upper and second nitride-based semiconductor layers and the current blocking insulation layer and to extend into the first nitride-based semiconductor layer. A third nitride-based semiconductor layer doped with dopants having the first type is formed to fill the first trench. The third nitride-based semiconductor layer is patterned to form a second trench in the first trench. A gate electrode is formed in the second trench. A source electrode is formed to contact the upper nitride-based semiconductor layer and a drain electrode is formed to contact the lower nitride-based semiconductor layer. The source electrode is formed of a material exhibiting an ohmic contact with respect to the upper nitride-based semiconductor layer, and the drain electrode is formed of a material exhibiting an ohmic contact with respect to the lower nitride-based semiconductor layer.

According to further embodiments, a vertical nitride-based transistor includes a first nitride-based semiconductor layer doped with dopants having a first type, a pair of second nitride-based semiconductor patterns doped with dopants having a second type and disposed in the first nitride-based semiconductor layer, current blocking insulation patterns disposed between the first nitride-based semiconductor layer and bottom surfaces of the second nitride-based semiconductor patterns, a third nitride-based semiconductor layer doped with dopants having the first type and disposed on the first nitride-based semiconductor layer, a gate dielectric layer disposed on sidewalls and a bottom surface of a trench vertically penetrating the first nitride-based semiconductor layer between the pair of second nitride-based semiconductor patterns, a gate electrode disposed in the trench surrounded by the gate dielectric layer, a source electrode electrically connected to the third nitride-based semiconductor layer, and a drain electrode electrically connected to the first nitride-based semiconductor layer.

According to further embodiments, a method of fabricating a vertical nitride-based transistor includes forming nitride seed patterns on a substrate, forming a nitride buffer layer on the substrate to cover the nitride seed patterns, forming mask patterns on the nitride buffer layer to overlap with the nitride seed patterns, and growing a lower nitride-based semiconductor layer heavily doped with dopants having a first type on the nitride buffer layer to cover the mask patterns. A first nitride-based semiconductor layer doped with dopants having the first type, a second nitride-based semiconductor layer doped with dopants having a second type, and a third nitride-based semiconductor layer doped with dopants having the first type are sequentially formed on the lower nitride-based semiconductor layer. A first trench is formed to penetrate the third and second nitride-based semiconductor layers and to extend into the first nitride-based semiconductor layer. A fourth nitride-based semiconductor layer doped with dopants having the first type is formed on the third nitride-based semiconductor layer to fill the first trench. An upper nitride-based semiconductor layer heavily doped with dopants having the first type is formed on the fourth nitride-based semiconductor layer. At least the upper and fourth nitride-based semiconductor layers are patterned to form a second trench in the first trench. A gate electrode is formed in the second trench. A source electrode is formed to contact the upper nitride-based semiconductor layer and a drain electrode is formed to contact the lower nitride-based semiconductor layer. The source electrode exhibits an ohmic contact with respect to the upper nitride-based semiconductor layer and the drain electrode exhibits an ohmic contact with respect to the lower nitride-based semiconductor layer.

According to further embodiments, a method of fabricating a vertical nitride-based transistor includes forming nitride seed patterns on a substrate, forming a nitride buffer layer on the substrate to cover the nitride seed patterns, forming mask patterns on the nitride buffer layer to overlap with the nitride seed patterns, and growing a lower nitride-based semiconductor layer heavily doped with dopants having a first type on the nitride buffer layer to cover the mask patterns. A first nitride-based semiconductor layer doped with dopants having the first type, a second nitride-based semiconductor layer doped with dopants having a second type, and an upper nitride-based semiconductor layer doped with dopants having the first type are sequentially formed on the lower nitride-based semiconductor layer. A first trench is formed to penetrate the upper and second nitride-based semiconductor layers and to extend into the first nitride-based semiconductor layer. A third nitride-based semiconductor layer doped with dopants having the first type is formed to fill the first trench. The third nitride-based semiconductor layer is patterned to form a second trench in the first trench. A gate electrode is formed in the second trench. A source electrode is formed to contact the upper nitride-based semiconductor layer and a drain electrode is formed to contact the lower nitride-based semiconductor layer. The source electrode is formed of a material exhibiting an ohmic contact with respect to the upper nitride-based semiconductor layer, and the drain electrode is formed of a material exhibiting an ohmic contact with respect to the lower nitride-based semiconductor layer.

According to further embodiments, a method of fabricating a vertical nitride-based transistor includes forming a first nitride-based semiconductor layer doped with dopants having a first type on a substrate, forming mask patterns on the first nitride-based semiconductor layer, growing a second nitride-based semiconductor layer doped with dopants having a second type on the first nitride-based semiconductor layer to cover the mask patterns, forming a third nitride-based semiconductor layer doped with dopants having the first type on the second nitride-based semiconductor layer, forming a first trench that penetrates the third and second nitride-based semiconductor layers and extends into the first nitride-based semiconductor layer, forming a fourth nitride-based semiconductor layer doped with dopants having the first type to fill the first trench, forming a second trench in the fourth nitride-based semiconductor layer, forming a gate electrode in the second trench, forming a source electrode electrically connected to the fourth nitride-based semiconductor layer, and forming a drain electrode electrically connected to the first nitride-based semiconductor layer.

According to further embodiments, a method of fabricating a vertical nitride-based transistor includes sequentially forming a lower nitride-based semiconductor layer heavily doped with dopants having a first type and a first nitride-based semiconductor layer doped with dopants having the first type on a substrate, forming mask patterns on the first nitride-based semiconductor layer, growing a second nitride-based semiconductor layer doped with dopants having a second type on the first nitride-based semiconductor layer to cover the mask patterns, forming a third nitride-based semiconductor layer doped with dopants having the first type on the second nitride-based semiconductor layer, forming a first trench that penetrates the third and second nitride-based semiconductor layers and extends into the first nitride-based semiconductor layer, forming a fourth nitride-based semiconductor layer doped with dopants having the first type to fill the first trench, forming an upper nitride-based semiconductor layer heavily doped with dopants having the first type on the fourth nitride-based semiconductor layer, patterning at least the upper and fourth nitride-based semiconductor layers to form a second trench in the first trench, forming a gate electrode in the second trench, forming a source electrode that contacts the upper nitride-based semiconductor layer and exhibits an ohmic contact with respect to the upper nitride-based semiconductor layer, and forming a drain electrode that contacts the lower nitride-based semiconductor layer and exhibits an ohmic contact with respect to the lower nitride-based semiconductor layer.

According to further embodiments, a method of fabricating a vertical nitride-based transistor includes sequentially forming a lower nitride-based semiconductor layer heavily doped with dopants having a first type and a first nitride-based semiconductor layer doped with dopants having the first type on a substrate, forming mask patterns on the first nitride-based semiconductor layer, growing a second nitride-based semiconductor layer doped with dopants having a second type on the first nitride-based semiconductor layer to cover the mask patterns, sequentially forming a third nitride-based semiconductor layer doped with dopants having the first type and an upper nitride-based semiconductor layer heavily doped with dopants having the first type on the second nitride-based semiconductor layer, forming a first trench that penetrates the upper, third and second nitride-based semiconductor layers and extends into the first nitride-based semiconductor layer, forming a fourth nitride-based semiconductor layer doped with dopants having the first type to fill the first trench, patterning the fourth nitride-based semiconductor layers to form a second trench in the first trench, forming a gate electrode in the second trench, forming a source electrode that contacts the upper nitride-based semiconductor layer and exhibits an ohmic contact with respect to the upper nitride-based semiconductor layer, and forming a drain electrode that contacts the lower nitride-based semiconductor layer and exhibits an ohmic contact with respect to the lower nitride-based semiconductor layer.

### BRIEF DESCRIPTION OF THE DRAWINGS

Embodiments of the present disclosure will become more apparent in view of the attached drawings and accompanying detailed description, in which:
FIG. 1 is a cross-sectional view illustrating a nitride-based transistor according to a first embodiment of the present disclosure;
FIG. 2 is a cross-sectional view illustrating a nitride-based transistor according to a second embodiment of the present disclosure;
FIGS. 3 to 14 are cross-sectional views illustrating a method of fabricating a nitride-based transistor according to an embodiment of the present disclosure;
FIGS. 15 to 26 are cross-sectional views illustrating a method of fabricating a nitride-based transistor according to another embodiment of the present disclosure;
FIG. 27 is a cross-sectional view illustrating a nitride-based transistor according to a third embodiment of the present disclosure;
FIG. 28 is a cross-sectional view illustrating a nitride-based transistor according to a fourth embodiment of the present disclosure;
FIGS. 29 to 40 are cross-sectional views illustrating a method of fabricating a nitride-based transistor according to yet another embodiment of the present disclosure;
FIGS. 41 to 52 are cross-sectional views illustrating a method of fabricating a nitride-based transistor according to still another embodiment of the present disclosure;
FIGS. 53 to 69 are cross-sectional views illustrating a method of fabricating a vertical nitride-based transistor according to an embodiment of the present disclosure;
FIGS. 70 to 78 are cross-sectional views illustrating a method of fabricating a vertical nitride-based transistor according to another embodiment of the present disclosure;
FIGS. 79 to 93 are cross-sectional views illustrating a method of fabricating a vertical nitride-based transistor according to yet another embodiment of the present disclosure; and
FIGS. 94 to 104 are cross-sectional views illustrating a method of fabricating a vertical nitride-based transistor according to still another embodiment of the present disclosure.

### DETAILED DESCRIPTION OF THE EMBODIMENTS

Various embodiments will now be described more fully hereinafter with reference to the accompanying drawings. The following embodiments are provided to fully convey the inventive concept to those skilled in the art. Thus, these embodiments may be embodied in different forms and should not be construed as limited to the embodiments set forth herein. In the drawings, the widths, lengths and thicknesses of layers and regions are exaggerated for clarity.

In the present specification, it will be understood that when an element is referred to as being "on," "above", "below," or "under" another element, it can be directly "on," "above", "below," or "under" the other element, respectively, or intervening elements may also be present. Moreover, spatially relative terms, such as "beneath," "below," "lower," "above," "upper," "top," "bottom" and the like, may be used to describe an element and/or feature's relationship to another element(s) and/or feature(s) as, for example, illustrated in the figures. It will be understood that the spatially relative terms are intended to encompass different orientations of the device in use and/or operation in addition to the orientation depicted in the figures. For example, when the device in the figures is turned over, elements described as below and/or beneath other elements or features would then be oriented above the other elements or features.

In the drawings, like reference numerals refer to like elements throughout. In addition, the singular terms "a," "an" and "the" used herein are intended to include the plural forms as well, unless the context clearly indicates otherwise. It will be further understood that the terms "comprise," "comprising," "includes," "including," "have", "having" and variants thereof specify the presence of stated features, integers, steps, operations, elements, and/or components, but do not preclude the presence and/or addition of one or more other features, integers, steps, operations, elements, components, and/or groups thereof.

In the specification, it will also be understood that a channel formed in a vertical direction means a channel through which carriers are vertically drifted from a source electrode toward a drain electrode. Thus, the channel may include not only a channel region that is formed to be generally orthogonal to a reference surface such as a surface of a substrate but also a channel region that is formed to be non-orthogonal to the reference surface at a predetermined angle. When the channel region is formed by etching a gallium nitride (GaN) layer, an inclined angle of the channel region with respect to a surface of the GaN layer may be different according to an etch process applied to the GaN layer. In some cases, the inclined angle of the channel region may be within a range of about 30 degrees to about 90 degrees according to a lattice plane of the GaN layer to which the etch process is applied. In more detail, the inclined angle of the channel region may be within a range of about 60 degrees to about 70 degrees when the channel region is formed by etching a GaN layer with a dry etch process or a wet etch process.

In the specification, the terms "source electrode" and "drain electrode" may be used to describe a direction of a current flowing through a channel region. Thus, if a polarity of a voltage applied between the source electrode and the drain electrode is changed, the source electrode could be termed the drain electrode and the drain electrode could be termed the source electrode.

In the specification, an interface region between a first layer and a second layer may be construed as including an interface between the first and second layers as well as internal regions of the first and second layers adjacent to the interface.

In the specification, it will also be understood that when a layer such as a nitride-based semiconductor layer is referred to as being doped with N-type impurities or P-type impurities, the layer can be doped to have a P-type impurity concentration of about 1×10¹⁷ /cm³ to about 1×10²⁰ /cm³ or an N-type impurity concentration of about 1×10¹⁶ /cm³ to about 1×10¹⁹ /cm³. Furthermore, it will be understood that when a layer such as a nitride-based semiconductor layer is referred to as being "heavily" doped with N-type impurities or P-type impurities, the layer can be doped to have a P-type impurity concentration over about 1×10²⁰ /cm³ or an N-type impurity concentration over about 1×10¹⁹ /cm³.

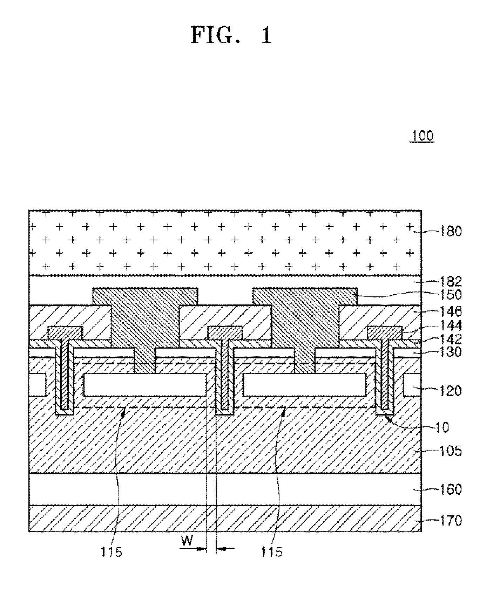

FIG. 1 is a cross-sectional view illustrating a nitride-based transistor 100 according to a first embodiment of the present disclosure. Referring to FIG. 1, the nitride-based transistor 100 may include a first nitride-based semiconductor layer 105, second nitride-based semiconductor patterns 120 and a third nitride-based semiconductor layer 130. In addition, the nitride-based transistor 100 may further include trenches 10 disposed in the first nitride-based semiconductor layer 105 between the second nitride-based semiconductor patterns 120. Moreover, the nitride-based transistor 100 may further include a gate dielectric layer 142 and a gate electrode 144 disposed in each of the trenches 10. Furthermore, the nitride-based transistor 100 may further include source electrodes 150 electrically connected to the third nitride-based semiconductor layer 130 and a drain electrode 170 electrically connected to the first nitride-based semiconductor layer 105.

Referring again to FIG. 1, the first nitride-based semiconductor layer 105 may include a nitride layer doped with impurities having a first type. The first type may denote a conductivity type of dopants injected into the nitride layer, for example, a semiconductor layer. That is, the first type may be an N-type or a P-type. In some embodiments, the N-type dopants may be silicon ions and the P-type dopants may be beryllium (Be) ions, magnesium (Mg) ions, calcium (Ca) ions, carbon (C) ions, iron (Fe) ions or manganese (Mn) ions. The first nitride-based semiconductor layer 105 may include a nitride layer such as an AlₓIn_{y}Ga_{1-x-y}N (where, 0≤x≤1 and 0≤y≤1) layer. In some embodiments, the first nitride-based semiconductor layer 105 may be, for example, an N-type GaN layer which is formed using an epitaxial growth technique.

The second nitride-based semiconductor patterns 120 may be disposed in the first nitride-based semiconductor layer 105. That is, the second nitride-based semiconductor patterns 120 may be surrounded by the first nitride-based semiconductor layer 105. Each of the second nitride-based semiconductor patterns 120 may have a predetermined width, a predetermined length and a predetermined thickness, and the second nitride-based semiconductor patterns 120 may be separated from each other. The second nitride-based semiconductor patterns 120 may include a nitride layer doped with dopants having a second type which is different from the first type. For example, if the first nitride-based semiconductor layer 105 is doped to have an N-type, the second nitride-based semiconductor patterns 120 may be doped to have a P-type. Alternatively, if the first nitride-based semiconductor layer 105 is doped to have a P-type, the second nitride-based semiconductor patterns 120 may be doped to have an N-type.

The third nitride-based semiconductor layer 130 may be disposed on the first nitride-based semiconductor layer 105. The third nitride-based semiconductor layer 130 may include a nitride layer heavily doped with dopants having the first type. The third nitride-based semiconductor layer 130 may be doped to have the same type as the first nitride-based semiconductor layer 105. The third nitride-based semiconductor layer 130 may be electrically connected to the source electrodes 150.

The following embodiment will be described in conjunction with an example in which the first nitride-based semiconductor layer 105 includes a GaN layer doped with dopants having an N-type, each of the second nitride-based semiconductor patterns 120 includes a GaN layer doped with dopants having a P-type, and the third nitride-based semiconductor layer 130 includes a GaN layer heavily doped with dopants having an N-type. However, the inventive concept is not limited to the following embodiment. That is, the following embodiment may be modified in various different forms to which substantially the same operation as the following embodiment is applied.

Referring again to FIG. 1, the trenches 10 may be formed in the first nitride-based semiconductor layer 105 between the second nitride-based semiconductor patterns 120. The gate dielectric layer 142 and the gate electrode 144 may be disposed in each of the trenches 10.

The gate dielectric layer 142 may be disposed on sidewalls and bottom surfaces of the trenches 10 in the form of a thin film. The gate dielectric layer 142 may include, for example, an oxide layer, a nitride layer or an oxynitride layer. In some embodiments, the gate dielectric layer 142 may include a silicon oxide layer.

The gate electrodes 144 may be disposed on the gate dielectric layer 142, and each of the gate electrodes 144 may be formed to fill one of the trenches 10. In some embodiments, each of the gate electrodes 144 may include a P-type GaN semiconductor layer doped with beryllium (Be) ions, magnesium (Mg) ions, calcium (Ca) ions, carbon (C) ions, iron (Fe) ions, manganese (Mn) ions, or a combination thereof. Alternatively, each of the gate electrodes 144 may include a metal layer such as a nickel (Ni) layer, a gold (Au) layer, a titanium (Ti) layer, an aluminum (Al) layer or the like.

The gate electrodes 144 may be used in control of a width of depletion regions formed in the first nitride-based semiconductor layer 105 located between the trenches 10 and the second nitride-based semiconductor patterns 120. As illustrated in FIG. 1, if the second nitride-based semiconductor patterns 120 are disposed to directly contact the first nitride-based semiconductor layer 105, depletion regions 115 may be formed at interface regions between the first nitride-based semiconductor layer 105 and the second nitride-based semiconductor patterns 120 due to P-N junctions. For the purpose of ease and convenience in explanation, the depletion regions 115 are illustrated only in the first nitride-based semiconductor layer 105. Moreover, although not shown in FIG. 1, additional depletion regions may be formed in the first nitride-based semiconductor layer 105 adjacent to the gate dielectric layer 142 at an equilibrium state due to a work function difference between the gate electrodes 144 and the first nitride-based semiconductor layer 105.

Specifically, if the first nitride-based semiconductor layer 105 includes an N-type GaN layer and each of the second nitride-based semiconductor patterns 120 includes a P-type GaN layer, depletion regions 115 in which electrons are depleted may be formed in the first nitride-based semiconductor layer 105 located between the trenches 10 and the second nitride-based semiconductor patterns 120.

A width W of the depletion regions 115 may be controlled by applying a gate voltage to the gate electrodes 144. In more detail, if a gate voltage (e.g., a positive voltage) higher than a threshold voltage is applied to the gate electrodes 144, the width W of the depletion regions 115 may be reduced to form channel regions (i.e., channel layers) that are located between the trenches 10 and the second nitride-based semiconductor patterns 120 to act as current paths. If the channel layers are formed in a vertical direction, electrons may be drifted from the third nitride-based semiconductor layer 130 toward the drain electrode 170 through the channel layers.

The source electrodes 150 may be disposed to be physically spaced apart from the gate electrodes 144 and to be in contact with the third nitride-based semiconductor layer 130. Each of the source electrodes 150 may include a material exhibiting an ohmic contact with respect to the third nitride-based semiconductor layer 130. For example, each of the source electrodes 150 may include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. As illustrated in FIG. 1, the source electrodes 150 may also be disposed to contact the second nitride-based semiconductor patterns 120. Thus, the second nitride-based semiconductor patterns 120 and the third nitride-based semiconductor layer 130 may be grounded through the source electrodes 150 when the nitride-based transistor 100 operates. That is, the second nitride-based semiconductor patterns 120 and the third nitride-based semiconductor layer 130 may have a stable potential if a ground voltage is applied to the source electrodes 150. An insulation layer 146 may be disposed between the source electrodes 150 and the gate electrodes 142 to electrically insulate the source electrodes 150 from the gate electrodes 142.

A fourth nitride-based semiconductor layer 160 heavily doped with dopants having the first type may be disposed on a bottom surface of the first nitride-based semiconductor layer 105 opposite to the third nitride-based semiconductor layer 130. In some embodiments, if the first nitride-based semiconductor layer 105 includes a GaN layer doped with dopants having the first type, the fourth nitride-based semiconductor layer 160 may include a GaN layer heavily doped with dopants having the first type.

The drain electrode 170 may be disposed on a bottom surface of the fourth nitride-based semiconductor layer 160 opposite to the first nitride-based semiconductor layer 105. The drain electrode 170 may include a material exhibiting an ohmic contact with respect to the fourth nitride-based semiconductor layer 160. For example, the drain electrode 170 may include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof.

Referring again to FIG. 1, a heat sink 180 may be disposed on the source electrodes 150. The heat sink 180 may be attached to the source electrodes 150 using an adhesion member 182. The adhesion member 182 may include a solder material or a metal paste material having an excellent heat conductivity, but not limited thereto. For example, in some embodiments, the adhesion member 182 may include another adhesion member well known in the art. The heat sink 180 may act as a heat radiator for emitting heat generated in the nitride-based transistor 100. Thus, the heat sink 180 may include a material having an excellent heat conductivity, for example, a metal material.

Hereinafter, a method of operating the nitride-based transistor 100 will be described with reference to FIG. 1. First, the first nitride-based semiconductor layer 105 located between the second nitride-based semiconductor patterns 120 and the gate electrodes 144 may be fully depleted to form the depletion regions 115 at an equilibrium state. Even though an operating voltage is applied between the source electrode 150 and the drain electrode 170 without a gate bias, no carriers may be drifted from the source electrodes 150 toward the drain electrode 170 because of the presence of the depletion regions 115. If a gate voltage (e.g., a positive gate voltage) higher than a threshold voltage is applied to the gate electrodes 144, the width W of the depletion regions 115 may be reduced or the depletion regions 115 may be removed. As a result, channel layers may be formed in the first nitride-based semiconductor layer 105 adjacent to sidewalls of the trenches 10. In some embodiments, if the first nitride-based semiconductor layer 105 includes an N-type GaN layer and each of the second nitride-based semiconductor patterns 120 includes a P-type GaN layer, the channel layers, that is, N-type channel layers may be vertically formed in the first nitride-based semiconductor layer 105 adjacent to the sidewalls of the trenches 10 because of the positive gate voltage applied to the gate electrodes 144. In such a case, electrons emitted from the source electrodes 150 may be drifted toward the drain electrode 170 through the third nitride-based semiconductor layer 130, the channel layers, the first nitride-based semiconductor layer 105, and the fourth nitride-based semiconductor layer 160. According to the present embodiment, the channel layers controlled by the gate electrodes 144 may be formed in a vertical direction and may be formed in an N-type GaN layer to increase a mobility of carriers (i.e., electrons) drifted therein.

As a first comparative example, a nitride-based transistor including a first N-type nitride-based region (acting as a source region), a P-type nitride-based region (acting as a channel body), and a second N-type nitride-based region (acting as a drain region) may be proposed. In such a case, an N-type channel layer may be formed in the P-type nitride-based region using a gate bias. However, according to the first comparative example, it may be difficult to improve an electron mobility in the N-type channel layer formed in the P-type nitride-based region. In general, the P-type nitride-based region may be formed by doping a GaN layer with P-type dopants such as magnesium (Mg) ions. In such a case, a dose of the P-type dopants has to increase to obtain a high threshold voltage appropriate for a high voltage operation. However, if a dose of the P-type dopants increases, it may be difficult to fully activate the P-type dopants injected into the GaN layer. This may lead to a difficulty in improving an electron mobility in the N-type channel layer formed in the P-type nitride-based region. Moreover, as a second comparative example, a nitride-based transistor including a first N-type nitride-based region (acting as a source region), a P-type nitride-based region (acting as a channel body), and a second N-type nitride-based region (acting as a drain region) may be proposed and a two-dimension electron gas (2DEG) layer may be formed between the P-type nitride-based region and a gate electrode due to a junction of an AlGaN layer and a GaN layer. In such a case, since the 2DEG layer acts as a channel layer, a channel mobility may be improved. However, a threshold voltage of the nitride-based transistor according to the second comparative example may be too low to use the nitride-based transistor as a high voltage transistor. That is, it may be difficult to modulate the 2DEG layer acting as a channel layer with a gate bias. For example, it may be difficult to obtain a threshold voltage higher than 3 volts.

In contrast, according to the embodiment described above, the depletion regions 115 may be formed in the first nitride-based semiconductor layer 105 adjacent to the gate electrode 144 at an equilibrium state and a width of the depletion regions 115 may be modulated by a gate voltage applied to the gate electrodes 144. Thus, a channel mobility may be improved and a high threshold voltage over 3 volts may be obtained. Accordingly, the embodiment described with reference to FIG. 1 may overcome the disadvantages (e.g., a low channel mobility and a low threshold voltage) of the first and second comparative examples.

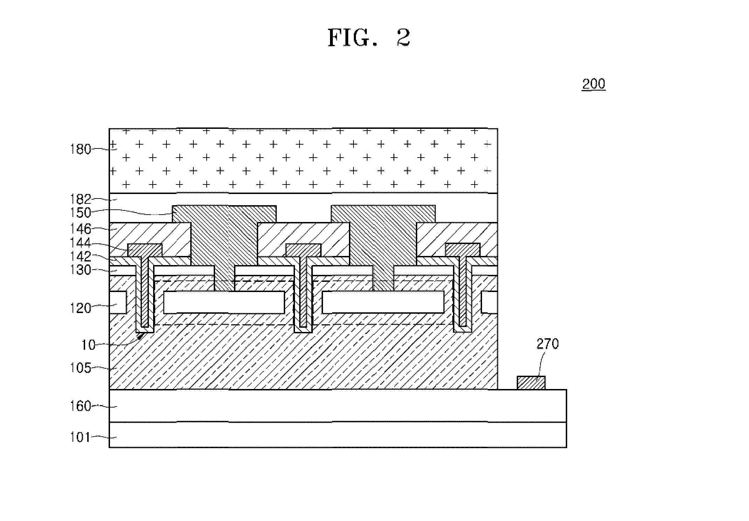

FIG. 2 is a cross-sectional view illustrating a nitride-based transistor 200 according to a second embodiment of the present disclosure. Referring to FIG. 2, the nitride-based transistor 200 may have substantially the same configuration as the nitride-based transistor 100 illustrated in FIG. 1 except that the fourth nitride-based semiconductor layer 160 is disposed on a substrate 101 and a drain electrode 270 is disposed on a portion of the fourth nitride-based semiconductor layer 160.

In some embodiments, the substrate 101 may be one selected from the group consisting of a sapphire substrate, a GaN substrate, a silicon carbide (SiC) substrate, a silicon substrate and an aluminum nitride (AlN) substrate. However, these substrates are merely examples of suitable substrates for the nitride-based transistor 200. Any substrate having an electrical insulation property can also be used as the substrate 101.

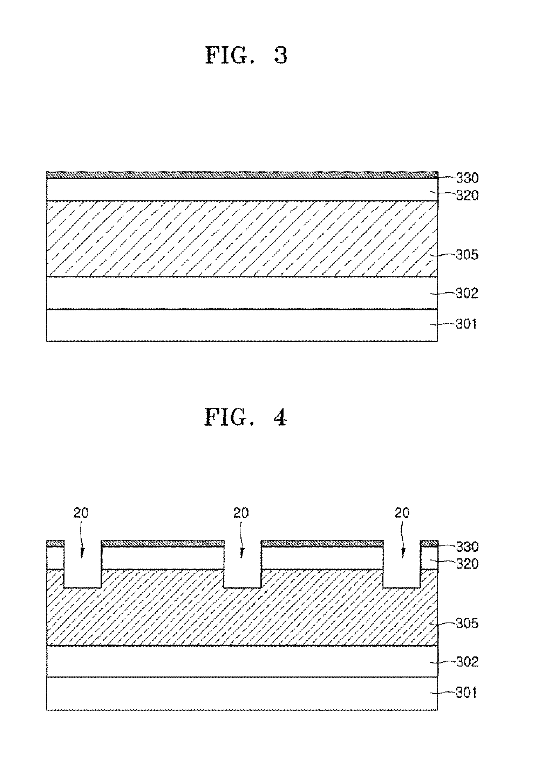

FIGS. 3 to 14 are cross-sectional views illustrating a method of fabricating a nitride-based transistor according to an embodiment of the present disclosure. In the following embodiment, a nitride-based semiconductor layer may include a nitride material such as an AlₓIn_{y}Ga_{1-x-y}N (where, 0≤x≤1 and 0≤y≤1) layer. In some embodiments, the nitride-based semiconductor layer may be formed using a metal organic chemical vapor deposition (MOCVD) process, a molecular beam epitaxy (MBE) process, or a hydride vapor phase epitaxy process.

Referring to FIG. 3, a first nitride-based semiconductor layer 305 doped with dopants having a first type, a second nitride-based semiconductor layer 320 doped with dopants having a second type, and a third nitride-based semiconductor layer 330 doped with dopants having the first type may be sequentially formed on a substrate 301. In some embodiments, a lower nitride-based semiconductor layer heavily doped with dopants having the first type may be additionally formed between the substrate 301 and the first nitride-based semiconductor layer 305.

The substrate 301 may be one selected from the group consisting of a sapphire substrate, a GaN substrate, a SiC substrate, a silicon substrate, and an AlN substrate. However, the substrate 301 is not limited to the above-listed substrates. For example, any substrate on which a nitride-based layer can be grown may also be used as the substrate 301.

In some embodiments, the first nitride-based semiconductor layer 305, the second nitride-based semiconductor layer 320, and the third nitride-based semiconductor layer 330 may be formed of the same material layer except for the conductivity type. If the first type is an N-type, the second type may be a P-type. On the contrary, if the first type is a P-type, the second type may be an N-type. In some embodiments, the dopants having an N-type may include silicon ions and the dopants having a P-type may include beryllium (Be) ions, magnesium (Mg) ions, calcium (Ca) ions, carbon (C) ions, iron (Fe) ions and manganese (Mn) ions.

Referring to FIG. 4, first trenches 20 may be formed to penetrate the third and second nitride-based semiconductor layers 330 and 320 and to extend into the first nitride-based semiconductor layer 305. The first trenches 20 may be formed by etching the third, second and first nitride-based semiconductor layers 330, 320 and 305. Each of the first trenches 20 may be formed to include a bottom surface and sidewalls perpendicular to the bottom surface. Alternatively, each of the first trenches 20 may be formed to include a bottom surface and sidewalls non-perpendicular to the bottom surface. In such a case, the sidewalls of the first trenches 20 may have a sloped profile. A tilt angle of the sloped sidewalls of the first trenches 20 to the bottom surfaces of the first trenches 20 may be different according to the etch process for forming the first trenches 20. In addition, the tilt angle of the sloped sidewalls of the first trenches 20 to the bottom surfaces of the first trenches 20 may be within a range of about 30 degrees to about 90 degrees according to a lattice plane of the first, second and third nitride-based semiconductor layers 305, 320 and 330 (e.g., GaN layers). In some embodiments, the tilt angle of the sloped sidewalls of the first trenches 20 to the bottom surfaces of the first trenches 20 may be within a range of about 60 degrees to about 70 degrees when the first trenches 20 are formed using a dry etch process or a wet etch process.

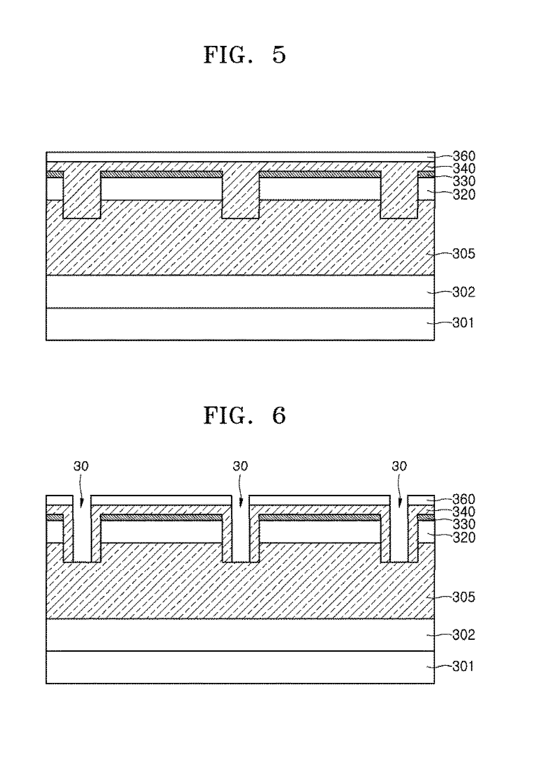

Referring to FIG. 5, a fourth nitride-based semiconductor layer 340 doped with dopants having the first type may be formed on the third nitride-based semiconductor layer 330 to fill the first trenches 20. That is, the fourth nitride-based semiconductor layer 340 may be formed in the first trenches 20 and on the third nitride-based semiconductor layer 330. Subsequently, an upper nitride-based semiconductor layer 360 heavily doped with dopants having the first type may be formed on the fourth nitride-based semiconductor layer 340. In some embodiments, the fourth nitride-based semiconductor layer 340 may be formed of an N-type GaN layer having an impurity concentration of about 1×10¹⁶ /cm³ to about 1×10¹⁷ /cm³, and the upper nitride-based semiconductor layer 360 may be formed of an N-type GaN layer having an impurity concentration which is equal to or higher than 1×10¹⁸ /cm³. The second nitride-based semiconductor patterns 320 may be surrounded by the first nitride-based semiconductor layer 305, the third nitride-based semiconductor patterns 330 and the fourth nitride-based semiconductor layer 340.

Referring to FIG. 6, the upper nitride-based semiconductor layer 360 and the fourth nitride-based semiconductor layer 340 may be patterned to form second trenches 30. The second trenches 30 may be formed in respective ones of the first trenches 20.

More specifically, the second trenches 30 may be formed by etching the upper nitride-based semiconductor layer 360 and the fourth nitride-based semiconductor layer 340 such that portions of the fourth nitride-based semiconductor layer 340 remain on the sidewalls of the first trenches 20 to have a predetermined thickness. The remaining portions of the fourth nitride-based semiconductor layer 340 on the sidewalls of the first trenches 20 may act as channel body layers of the nitride-based transistor. Thus, a thickness (i.e., a width in a horizontal direction) of the remaining portions of the fourth nitride-based semiconductor layer 340 on the sidewalls of the first trenches 20 may be determined in consideration of a width of depletion regions which are formed between the second nitride-based semiconductor patterns 320 and gate electrodes to be formed in the second trenches 30. The second trenches 30 may be formed to have bottom surfaces whose levels are lower than levels of bottom surfaces of the second nitride-based semiconductor patterns 320. Although FIG. 6 illustrates an example in which bottom surfaces of the second trenches 30 are coplanar with bottom surfaces of the first trenches 20, the inventive concept is not limited thereto. For example, the second trenches 30 may be formed such that a level of the bottom surfaces of the second trenches 30 is lower or higher than a level of the bottom surfaces of the first trenches 20.

The second trenches 30 may be formed such that the sidewalls of the second trenches 30 are perpendicular to the bottom surfaces of the second trenches 30. Alternatively, the second trenches 30 may be formed such that the sidewalls of the second trenches 30 are non-perpendicular to the bottom surfaces of the second trenches 30. In such a case, the sidewalls of the second trenches 30 may have a sloped profile. A tilt angle of the sloped sidewalls of the second trenches 30 to the bottom surfaces of the second trenches 30 may be different according to the etch process for forming the second trenches 30. In addition, the tilt angle of the sloped sidewalls of the second trenches 30 to the bottom surfaces of the second trenches 30 may be within a range of about 30 degrees to about 90 degrees according to a lattice plane of the fourth and upper nitride-based semiconductor layers 340 and 360 (e.g., GaN layers). In some embodiments, the tilt angle of the sloped sidewalls of the second trenches 30 to the bottom surfaces of the second trenches 30 may be within a range of about 60 degrees to about 70 degrees when the second trenches 30 are formed using a dry etch process or a wet etch process.

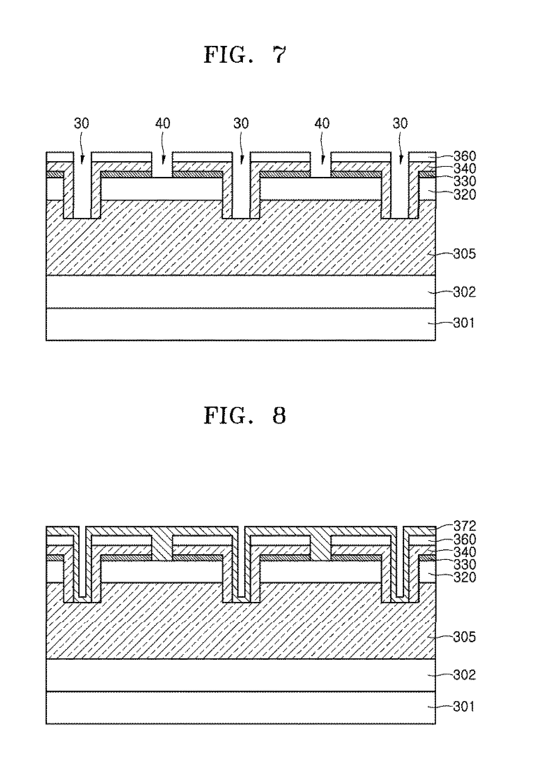

Referring to FIG. 7, the upper nitride-based semiconductor layer 360, the fourth nitride-based semiconductor layer 340 and the third nitride-based semiconductor patterns 330 may be etched to form third trenches 40 that are disposed between the second trenches 30 to expose portions of the second nitride-based semiconductor patterns 320. The third trenches 40 may be formed such that sidewalls of the third trenches 40 are perpendicular to bottom surfaces of the third trenches 40. Alternatively, the third trenches 40 may be formed such that the sidewalls of the third trenches 40 are non-perpendicular to the bottom surfaces of the third trenches 40. That is, the sidewalls of the third trenches 40 may have a sloped profile. The third trenches 40 may function as source contact holes in which source electrodes 380 are formed in a subsequent process.

Referring to FIG. 8, a gate dielectric layer 372 may be formed in the second and third trenches 30 and 40 and on the upper nitride-based semiconductor layer 360. As illustrated in FIG. 8, the gate dielectric layer 372 may be formed to fill the third trenches 40, but the gate dielectric layer 372 may be conformably formed in the second trenches 30.

The gate dielectric layer 372 may be formed to include an oxide layer, a nitride layer or an oxynitride layer. The gate dielectric layer 372 may be formed using a CVD process, a sputtering process, an atomic layer deposition (ALD) process or an evaporation process.

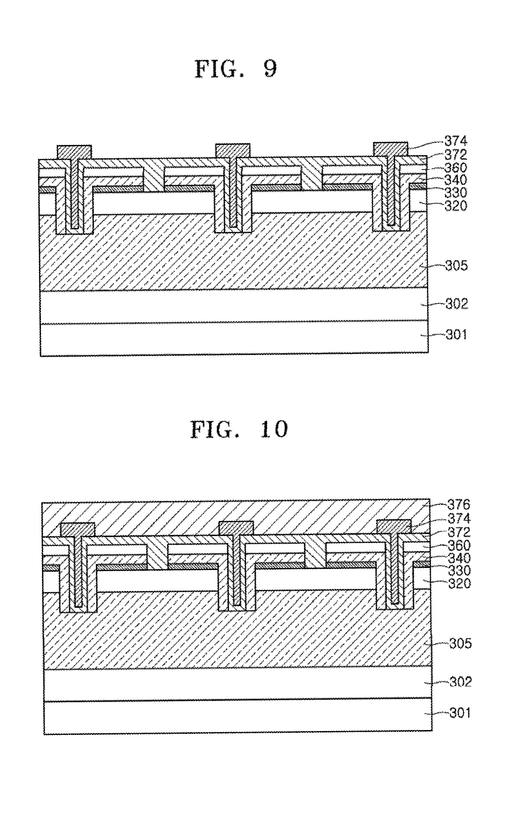

Referring to FIG. 9, a gate conductive layer may be formed on the gate dielectric layer 372 to fill the second trenches 30. The gate conductive layer may be patterned to form gate electrodes 374 covering the second trenches 30. The gate conductive layer may be formed to include a GaN layer doped with P-type dopants such as beryllium (Be) ions, magnesium (Mg) ions, calcium (Ca) ions, carbon (C) ions, iron (Fe) ions, manganese (Mn) ions, or mixed ions containing at least two different ions among the above-listed ions. Alternatively, gate conductive layer may be formed to include a metal layer such as a nickel (Ni) layer, a gold (Au) layer, a titanium (Ti) layer or an aluminum (Al) layer. The gate conductive layer may be formed using a CVD process, a sputtering process, an ALD process or an evaporation process.

Referring to FIG. 10, an interlayer insulation layer 376 may be formed on the gate dielectric layer 372 and the gate electrodes 374. The interlayer insulation layer 376 may be formed to include an oxide layer, a nitride layer or an oxynitride layer. The interlayer insulation layer 376 may be formed using a CVD process, a sputtering process, an ALD process or an evaporation process.

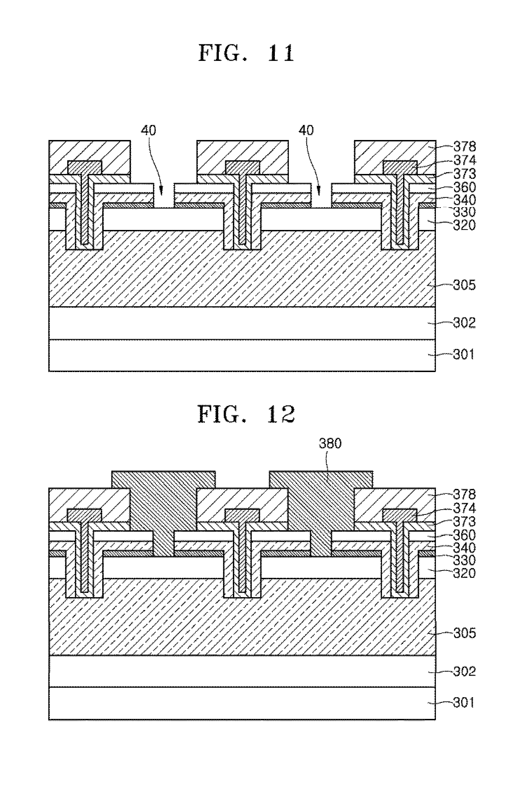

Referring to FIG. 11, the interlayer insulation layer 376 and the gate dielectric layer 372 may be etched to form interlayer insulation patterns 378 and gate dielectric patterns 373. As a result of the etch process for forming the interlayer insulation patterns 378 and gate dielectric patterns 373, the gate dielectric layer 372 in the third trenches 40 may be removed to expose the sidewalls and bottom surfaces of the third trenches 40. That is, the interlayer insulation layer 376 and the gate dielectric layer 372 may be etched to expose portions of the second nitride-based semiconductor patterns 320. The third trenches 40 may function as source contact holes in which source electrodes 380 are formed in a subsequent process.

Referring to FIG. 12, source electrodes 380 may be formed in the source contact holes 40. The source electrodes 380 may be formed to extend into gap regions between the interlayer insulation patterns 378. The source electrodes 380 may be formed of a material exhibiting an ohmic contact with respect to the third nitride-based semiconductor patterns 330, the fourth nitride-based semiconductor layer 340 or the upper nitride-based semiconductor patterns 360. In some embodiments, the source electrodes 380 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. The source electrodes 380 may be formed using a CVD process, a sputtering process, an ALD process or an evaporation process.

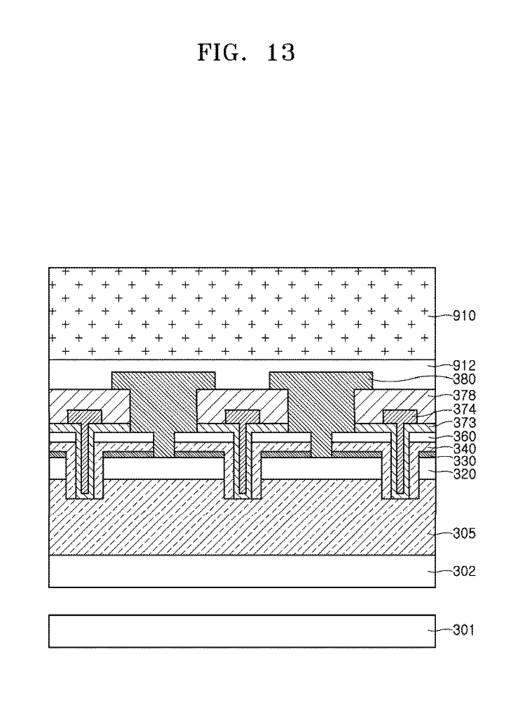

Referring to FIG. 13, a heat sink 910 may be formed on the source electrodes 380. The heat sink 910 may act as a heat radiator for emitting heat generated in a nitride-based transistor. Thus, the heat sink 910 may be formed to include a material having an excellent heat conductivity, for example, a metal material. The heat sink 910 may be attached to the source electrodes 380 using an adhesion member 912. The adhesion member 912 may include a solder material or a metal paste material having an excellent heat conductivity, but not limited thereto. For example, in some embodiments, the adhesion member 912 may include another adhesion member well known in the art.

Referring again to FIG. 13, the substrate 301 may be detached from the lower nitride-based semiconductor layer 302. The substrate 301 may be detached from the lower nitride-based semiconductor layer 302 using a laser lift-off process.

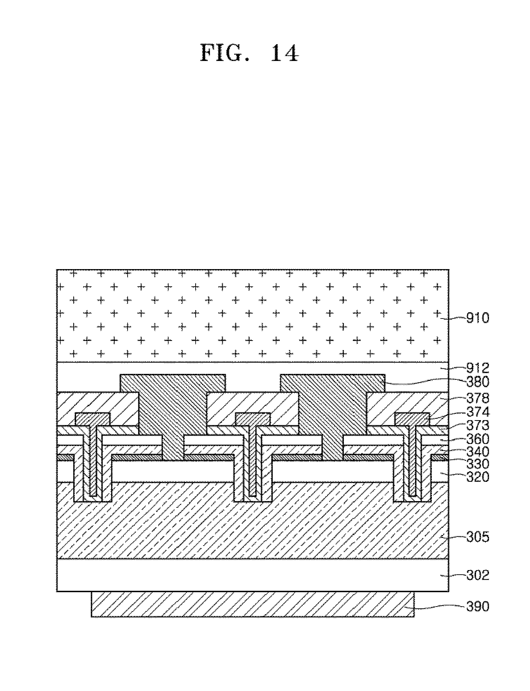

Referring to FIG. 14, a drain electrode 390 may be formed on the exposed surface of the lower nitride-based semiconductor layer 302 opposite to the first nitride-based semiconductor layer 305. The drain electrode 390 may be formed of a material exhibiting an ohmic contact with respect to the lower nitride-based semiconductor layer 302. In some embodiments, the drain electrode 390 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. The drain electrode 390 may be formed using a CVD process, a sputtering process, an ALD process or an evaporation process. A nitride-based transistor according to an embodiment may be fabricated through the aforementioned processes.

In some other embodiments, after the source electrodes 380 illustrated in FIG. 12 are formed, the first, second, third, fourth and upper nitride-based semiconductor layers 305, 320, 330, 340 and 360 may be patterned to expose a portion of the lower nitride-based semiconductor layer 302. Subsequently, the drain electrode 390 may be formed on the exposed portion of the lower nitride-based semiconductor layer 302. As a result, the nitride-based transistor 200 illustrated in FIG. 2 can be fabricated. Even in this case, a heat sink may also be additionally formed on the source electrodes 380.

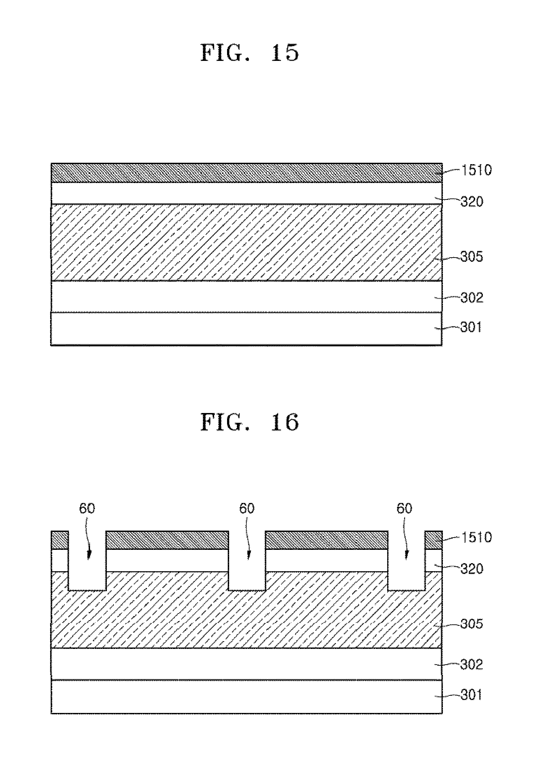

FIGS. 15 to 26 are cross-sectional views illustrating a method of fabricating a nitride-based transistor according to another embodiment of the present disclosure. In the following embodiment, a nitride-based semiconductor layer may include a nitride material such as an AlₓIn_{y}Ga_{1-x-y}N (where, 0≤x≤1 and 0≤y≤1) layer. In some embodiments, the nitride-based semiconductor layer may be formed using a metal organic chemical vapor deposition (MOCVD) process, a molecular beam epitaxy (MBE) process, or a hydride vapor phase epitaxy process. To avoid duplicate explanation, detailed descriptions of the same elements as set forth in the previous embodiment illustrated in FIGS. 3 to 14 will be omitted in this embodiment.

Referring to FIG. 15, a lower nitride-based semiconductor layer 302 heavily doped with dopants having a first type, a first nitride-based semiconductor layer 305 doped with dopants having the first type, a second nitride-based semiconductor layer 320 doped with dopants having a second type, and an upper nitride-based semiconductor layer 1510 heavily doped with dopants having the first type may be sequentially formed on a substrate 301. In some embodiments, the lower nitride-based semiconductor layer 302 may be formed of a GaN layer heavily doped with N-type dopants, and the first nitride-based semiconductor layer 305 may be formed of a GaN layer lightly doped with N-type dopants. Moreover, the second nitride-based semiconductor layer 320 may be formed of a GaN layer doped with P-type dopants, and the upper nitride-based semiconductor layer 1510 may be formed of a GaN layer heavily doped with N-type dopants. The lower nitride-based semiconductor layer 302 and the upper nitride-based semiconductor layer 1510 may be doped to have an impurity concentration which is equal to or higher than about 1×10¹⁸ /cm³, and the first nitride-based semiconductor layer 305 may be doped to have an impurity concentration of about 1×10¹⁶ /cm³ to about 1×10¹⁷ /cm³.

Referring to FIG. 16, first trenches 60 may be formed to penetrate the upper and second nitride-based semiconductor layers 1510 and 320 and to extend into the first nitride-based semiconductor layer 305. The first trenches 60 may be formed by etching the upper, second and first nitride-based semiconductor layers 1510, 320 and 305. Each of the first trenches 60 may be formed to include a bottom surface and sidewalls perpendicular to the bottom surface. Alternatively, each of the first trenches 60 may be formed to include a bottom surface and sidewalls non-perpendicular to the bottom surface. In such a case, the sidewalls of the first trenches 60 may have a sloped profile.

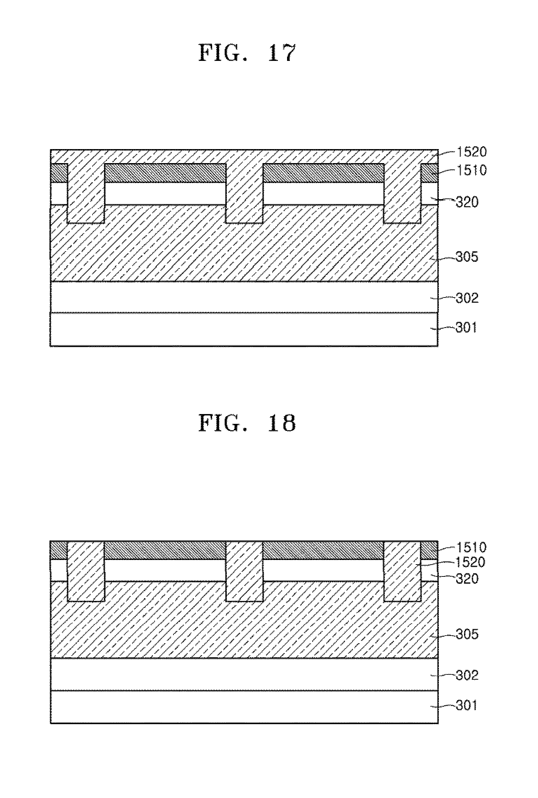

Referring to FIG. 17, a third nitride-based semiconductor layer 1520 doped with dopants having the first type may be formed on the upper nitride-based semiconductor layer 1510 to fill the first trenches 60. That is, the third nitride-based semiconductor layer 1520 may be formed in the first trenches 60 and on the upper nitride-based semiconductor layer 1510. In some embodiments, the third nitride-based semiconductor layer 1520 may be formed of an N-type GaN layer having an impurity concentration of about 1×10¹⁶ /cm³ to about 1×10¹⁷ /cm³. The second nitride-based semiconductor patterns 320 may be surrounded by the first nitride-based semiconductor layer 305, the upper nitride-based semiconductor patterns 1510 and the third nitride-based semiconductor layer 1520.

Referring to FIG. 18, the third nitride-based semiconductor layer 1520 may be planarized to expose top surfaces of the upper nitride-based semiconductor patterns 1510. The third nitride-based semiconductor layer 1520 may be planarized using a chemical mechanical polishing (CMP) process, a dry etch process or a wet etch process.

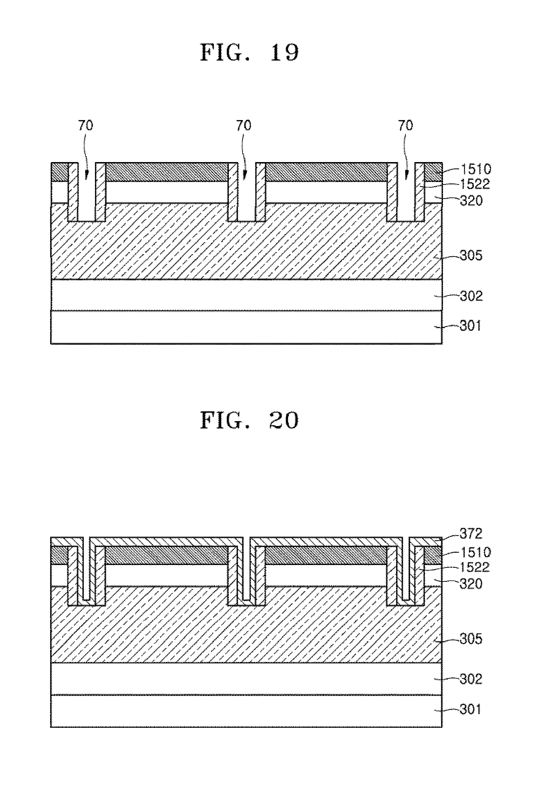

Referring to FIG. 19, the third nitride-based semiconductor patterns 1520 in the first trenches 60 may be patterned to form second trenches 70. The second trenches 70 may be formed in respective ones of the first trenches 60. More specifically, the second trenches 70 may be formed by etching the third nitride-based semiconductor patterns 1520 such that portions of the third nitride-based semiconductor patterns 1520 remain on the sidewalls of the first trenches 60 to have a predetermined thickness. The remaining portions of the third nitride-based semiconductor patterns 1520 on the sidewalls of the first trenches 60 may act as channel body layers of the nitride-based transistor. Thus, a thickness (i.e., a width in a horizontal direction) of the remaining portions of the third nitride-based semiconductor layer 1520 on the sidewalls of the first trenches 60 may be determined in consideration of a width of depletion regions which are formed between the second nitride-based semiconductor patterns 320 and gate electrodes to be formed in the second trenches 70.

Although FIG. 19 illustrates an example in which bottom surfaces of the second trenches 70 are coplanar with bottom surfaces of the first trenches 60, the inventive concept is not limited thereto. For example, the second trenches 70 may be formed such that a level of the bottom surfaces of the second trenches 70 is lower or higher than a level of the bottom surfaces of the first trenches 60.

Referring to FIG. 20, a gate dielectric layer 372 may be formed in the second trenches 70 and on the upper nitride-based semiconductor patterns 1510. As illustrated in FIG. 20, the gate dielectric layer 372 may be conformably formed in the second trenches 70.

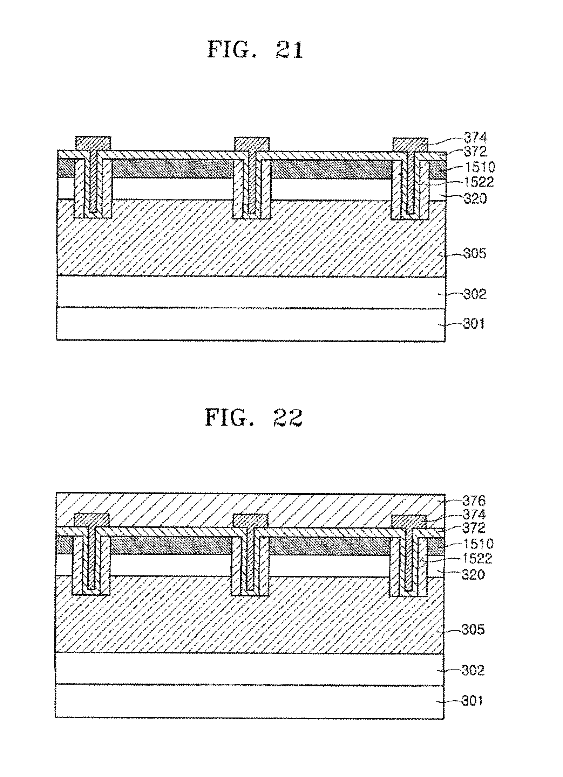

Referring to FIG. 21, a gate conductive layer may be formed on the gate dielectric layer 372 to fill the second trenches 70. The gate conductive layer may be patterned to form gate electrodes 374 covering the second trenches 70.

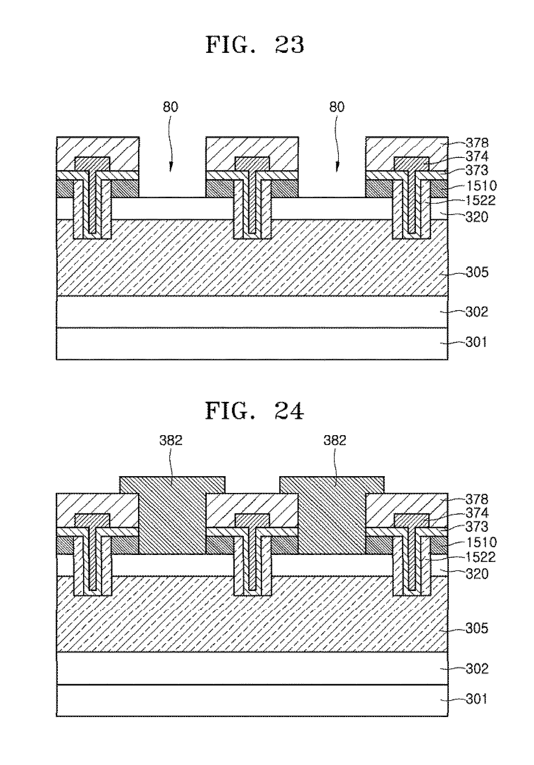

Referring to FIG. 22, an interlayer insulation layer 376 may be formed on the gate dielectric layer 372 and the gate electrodes 374. Referring to FIG. 23, the interlayer insulation layer 376, the gate dielectric layer 372 and the upper nitride-based semiconductor patterns 1510 may be patterned to form insulation patterns 378 and gate dielectric patterns 373. As a result of the etch process for forming the interlayer insulation patterns 378 and gate dielectric patterns 373, third trenches 80 may be formed to expose portions of the second nitride-based semiconductor patterns 320. The third trenches 80 may function as source contact holes in which source electrodes 380 are formed in a subsequent process.

Referring to FIG. 24, source electrodes 380 may be formed in the source contact holes 80. The source electrodes 380 may be formed to extend into gap regions between the insulation patterns 378. The source electrodes 380 may be formed of a material exhibiting an ohmic contact with respect to the upper nitride-based semiconductor patterns 1510.

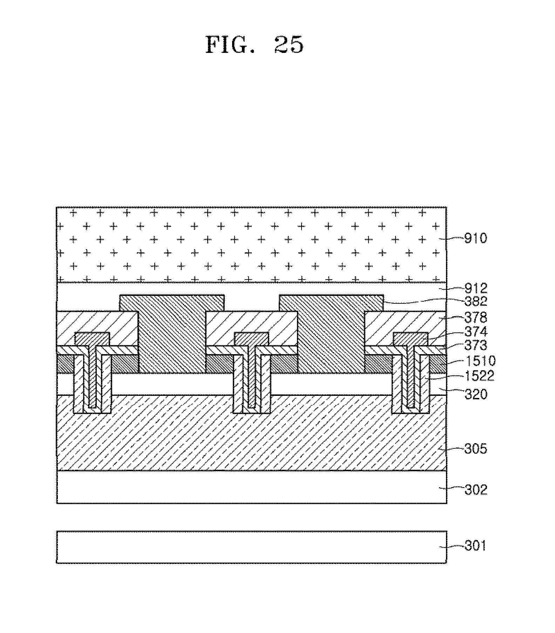

Referring to FIG. 25, a heat sink 910 may be formed on the source electrodes 380. The heat sink 910 may act as a heat radiator for emitting heat generated in the nitride-based transistor. The heat sink 910 may be attached to the source electrodes 380 using an adhesion member 912. The adhesion member 912 may include a solder material or a metal paste material having an excellent heat conductivity, but not limited thereto. For example, in some embodiments, the adhesion member 912 may include another adhesion member well known in the art.

Referring again to FIG. 25, the substrate 301 may be detached from the lower nitride-based semiconductor layer 302. The substrate 301 may be detached from the lower nitride-based semiconductor layer 302 using a laser lift-off process.

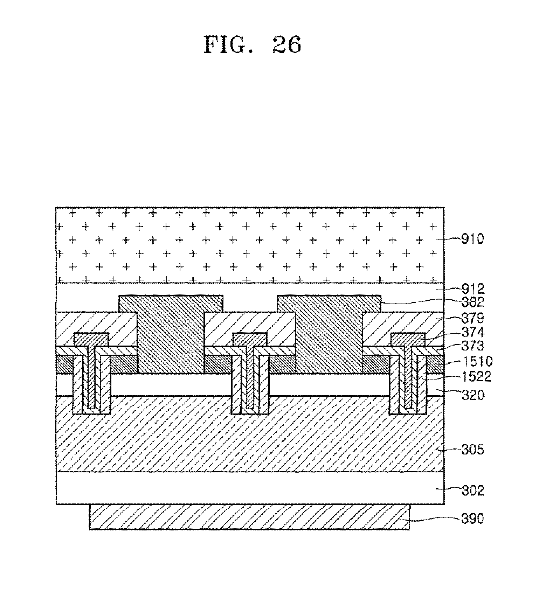

Referring to FIG. 26, a drain electrode 390 may be formed on the exposed surface of the lower nitride-based semiconductor layer 302 opposite to the first nitride-based semiconductor layer 305. The drain electrode 390 may be formed of a material exhibiting an ohmic contact with respect to the lower nitride-based semiconductor layer 302. A nitride-based transistor according to an embodiment may be fabricated through the aforementioned processes.

In some other embodiments, after the source electrodes 380 illustrated in FIG. 24 are formed, the first, second and upper nitride-based semiconductor layers 305, 320 and 1510 may be patterned to expose a portion of the lower nitride-based semiconductor layer 302. Subsequently, the drain electrode 390 may be formed on the exposed portion of the lower nitride-based semiconductor layer 302. As a result, a nitride-based transistor having substantially the same configuration as the nitride-based transistor 200 illustrated in FIG. 2 can be fabricated. Even in this case, a heat sink may also be additionally formed on the source electrodes 380.

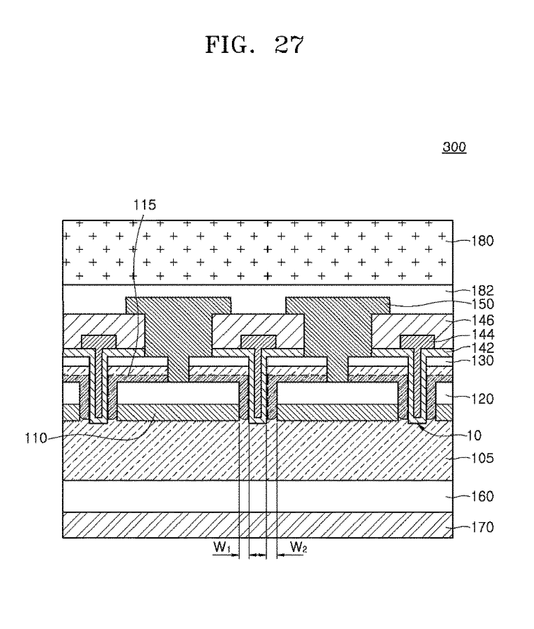

FIG. 27 is a cross-sectional view illustrating a vertical nitride-based transistor 300 according to a third embodiment of the present disclosure. Referring to FIG. 27, the vertical nitride-based transistor 300 may include a first nitride-based semiconductor layer 105, a current blocking insulation patterns 110, second nitride-based semiconductor patterns 120 and a third nitride-based semiconductor layer 130. In addition, the vertical nitride-based transistor 300 may further include trenches 10 disposed in the first nitride-based semiconductor layer 105 between the second nitride-based semiconductor patterns 120. Moreover, the vertical nitride-based transistor 300 may further include a gate dielectric layer 142 and a gate electrode 144 disposed in each of the trenches 10. Furthermore, the vertical nitride-based transistor 300 may further include source electrodes 150 electrically connected to the third nitride-based semiconductor layer 130 and a drain electrode 170 electrically connected to the first nitride-based semiconductor layer 105. The second nitride-based semiconductor patterns 120

Referring again to FIG. 27, the first nitride-based semiconductor layer 105 may include a nitride layer doped with impurities having a first type. The first type may denote a conductivity type of dopants injected into the nitride layer, for example, a semiconductor layer. That is, the first type may be an N-type or a P-type. In some embodiments, the N-type dopants may be silicon ions and the P-type dopants may be beryllium (Be) ions, magnesium (Mg) ions, calcium (Ca) ions, carbon (C) ions, iron (Fe) ions or manganese (Mn) ions. The first nitride-based semiconductor layer 105 may include a nitride layer such as an AlₓIn_{y}Ga_{1-x-y}N (where, 0≤x≤1 and 0≤y≤1) layer. In some embodiments, the first nitride-based semiconductor layer 105 may be, for example, an N-type GaN layer which is formed using an epitaxial growth technique.

The second nitride-based semiconductor patterns 120 may be disposed in the first nitride-based semiconductor layer 105. That is, the second nitride-based semiconductor patterns 120 may be surrounded by the first nitride-based semiconductor layer 105. Each of the second nitride-based semiconductor patterns 120 may have a predetermined width, a predetermined length and a predetermined thickness, and the second nitride-based semiconductor patterns 120 may be separated from each other. The second nitride-based semiconductor patterns 120 may include a nitride layer doped with dopants having a second type which is different from the first type. For example, if the first nitride-based semiconductor layer 105 is doped to have an N-type, the second nitride-based semiconductor patterns 120 may be doped to have a P-type. Alternatively, if the first nitride-based semiconductor layer 105 is doped to have a P-type, the second nitride-based semiconductor patterns 120 may be doped to have an N-type.

Current blocking insulation patterns 110 may be disposed between the first nitride-based semiconductor layer 105 and bottom surfaces of the second nitride-based semiconductor patterns 120. Each of the current blocking insulation patterns 110 may include a nitride-based semiconductor material doped with carbon ions or iron ions. For example, each of the current blocking insulation patterns 110 may include a GaN material doped with carbon ions or iron ions. The current blocking insulation patterns 110 may prevent leakage currents between the source electrodes 150 and the drain electrode 170 from flowing through the second nitride-based semiconductor patterns 120. All of the first nitride-based semiconductor layer 105, second nitride-based semiconductor patterns 120, and the current blocking insulation patterns 110 may be formed of the same nitride-based semiconductor material, for example, a GaN material. That is, the first nitride-based semiconductor layer 105, second nitride-based semiconductor patterns 120 and the current blocking insulation patterns 110 may have the same lattice constant. Thus, no deformation occurs in the first nitride-based semiconductor layer 105, second nitride-based semiconductor patterns 120 and the current blocking insulation patterns 110 because the first nitride-based semiconductor layer 105, second nitride-based semiconductor patterns 120 and the current blocking insulation patterns 110 have the same lattice constant.

The third nitride-based semiconductor layer 130 may be disposed on the first nitride-based semiconductor layer 105. The third nitride-based semiconductor layer 130 may include a nitride layer heavily doped with dopants having the first type. The third nitride-based semiconductor layer 130 may be doped to have the same type as the first nitride-based semiconductor layer 105. The third nitride-based semiconductor layer 130 may be electrically connected to the source electrodes 150.

The following embodiment will be described in conjunction with an example in which the first nitride-based semiconductor layer 105 includes a GaN layer doped with dopants having an N-type, each of the current blocking insulation patterns 110 includes a GaN layer doped with carbon ions or iron ions, each of the second nitride-based semiconductor patterns 120 includes a GaN layer doped with dopants having a P-type, and the third nitride-based semiconductor layer 130 includes a GaN layer heavily doped with dopants having an N-type. However, the inventive concept is not limited to the following embodiment. That is, the following embodiment may be modified in various different forms to which substantially the same operation as the following embodiment is applied.

Referring again to FIG. 27, the trenches 10 may be formed in the first nitride-based semiconductor layer 105 between the second nitride-based semiconductor patterns 120. The gate dielectric layer 142 and the gate electrode 144 may be disposed in each of the trenches 10.

The gate dielectric layer 142 may be disposed on sidewalls and bottom surfaces of the trenches 10 in the form of a thin film. The gate dielectric layer 142 may include, for example, an oxide layer, a nitride layer or an oxynitride layer. In some embodiments, the gate dielectric layer 142 may include a silicon oxide layer.

The gate electrodes 144 may be disposed on the gate dielectric layer 142, and each of the gate electrodes 144 may be formed to fill one of the trenches 10. In some embodiments, each of the gate electrodes 144 may include a P-type GaN semiconductor layer doped with beryllium (Be) ions, magnesium (Mg) ions, calcium (Ca) ions, carbon (C) ions, iron (Fe) ions, manganese (Mn) ions, or a combination thereof. Alternatively, each of the gate electrodes 144 may include a metal layer such as a nickel (Ni) layer, a gold (Au) layer, a titanium (Ti) layer, an aluminum (Al) layer or the like.

The gate electrodes 144 may be used in control of a width of depletion regions formed in the first nitride-based semiconductor layer 105 located between the trenches 10 and the second nitride-based semiconductor patterns 120. As illustrated in FIG. 27, if the second nitride-based semiconductor patterns 120 are disposed to directly contact the first nitride-based semiconductor layer 105, depletion regions 115 may be formed at interface regions between the first nitride-based semiconductor layer 105 and the second nitride-based semiconductor patterns 120 due to P-N junctions. Moreover, additional depletion regions may be formed in the first nitride-based semiconductor layer 105 adjacent to the gate dielectric layer 142 at an equilibrium state due to a work function difference between the gate electrodes 144 and the first nitride-based semiconductor layer 105. FIG. 27 illustrates depletion regions 115 which are formed in the first nitride-based semiconductor layer 105 because of presence of the second nitride-based semiconductor patterns 120 and the gate electrodes 144.

Specifically, if the first nitride-based semiconductor layer 105 includes an N-type GaN layer and each of the second nitride-based semiconductor patterns 120 includes a P-type GaN layer, electrons may be depleted in the depletion regions 115 which are formed in the first nitride-based semiconductor layer 105 located between the trenches 10 and the second nitride-based semiconductor patterns 120.

A width W1 and a width W2 of the depletion regions 115 adjacent to the sidewalls of the trenches 10 may be controlled by applying a gate voltage to the gate electrodes 144. In more detail, if a gate voltage (e.g., a positive voltage) higher than a threshold voltage is applied to the gate electrodes 144, the widths W1 and W2 of the depletion regions 115 may be reduced to form channel regions (i.e., channel layers) that are located between the trenches 10 and the second nitride-based semiconductor patterns 120 to act as current paths. If the channel layers are formed in a vertical direction, electrons may be drifted from the third nitride-based semiconductor layer 130 toward the drain electrode 170 through the channel layers.

The source electrodes 150 may be disposed to be physically spaced apart from the gate electrodes 144 and to be in contact with the third nitride-based semiconductor layer 130. Each of the source electrodes 150 may include a material exhibiting an ohmic contact with respect to the third nitride-based semiconductor layer 130. For example, each of the source electrodes 150 may include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. As illustrated in FIG. 27, the source electrodes 150 may also be disposed to contact the second nitride-based semiconductor patterns 120. Thus, the second nitride-based semiconductor patterns 120 and the third nitride-based semiconductor layer 130 may be grounded through the source electrodes 150 when the nitride-based transistor 100 operates. That is, the second nitride-based semiconductor patterns 120 and the third nitride-based semiconductor layer 130 may have a stable potential if a ground voltage is applied to the source electrodes 150. An insulation layer 146 may be disposed between the source electrodes 150 and the gate electrodes 142 to electrically insulate the source electrodes 150 from the gate electrodes 142.

A fourth nitride-based semiconductor layer 160 heavily doped with dopants having the first type may be disposed on a bottom surface of the first nitride-based semiconductor layer 105 opposite to the third nitride-based semiconductor layer 130. In some embodiments, if the first nitride-based semiconductor layer 105 includes a GaN layer doped with dopants having the first type, the fourth nitride-based semiconductor layer 160 may include a GaN layer heavily doped with dopants having the first type.

The drain electrode 170 may be disposed on a bottom surface of the fourth nitride-based semiconductor layer 160 opposite to the first nitride-based semiconductor layer 105. The drain electrode 170 may include a material exhibiting an ohmic contact with respect to the fourth nitride-based semiconductor layer 160. For example, the drain electrode 170 may include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof.

Referring again to FIG. 27, a heat sink 180 may be disposed on the source electrodes 150. The heat sink 180 may be attached to the source electrodes 150 using an adhesion member 182. The adhesion member 182 may include a solder material or a metal paste material having an excellent heat conductivity, but not limited thereto. For example, in some embodiments, the adhesion member 182 may include another adhesion member well known in the art. The heat sink 180 may act as a heat radiator for emitting heat generated in the nitride-based transistor 300. Thus, the heat sink 180 may include a material having an excellent heat conductivity, for example, a metal material.

Hereinafter, a method of operating the nitride-based transistor 300 will be described with reference to FIG. 27. First, the first nitride-based semiconductor layer 105 located between the second nitride-based semiconductor patterns 120 and the gate electrodes 144 may be fully depleted to form the depletion regions 115 at an equilibrium state. Thus, even though an operating voltage is applied between the source electrode 150 and the drain electrode 170 without a gate bias, no carriers may be drifted from the source electrodes 150 toward the drain electrode 170 because of the presence of the depletion regions 115. If a gate voltage (e.g., a positive gate voltage) higher than a threshold voltage is applied to the gate electrodes 144, the widths W1 and W2 of the depletion regions 115 may be reduced or the depletion regions 115 may be removed. As a result, channel layers may be formed in the first nitride-based semiconductor layer 105 adjacent to sidewalls of the trenches 10. In some embodiments, if the first nitride-based semiconductor layer 105 includes an N-type GaN layer and each of the second nitride-based semiconductor patterns 120 includes a P-type GaN layer, the channel layers, that is, N-type channel layers may be vertically formed in the first nitride-based semiconductor layer 105 adjacent to the sidewalls of the trenches 10 because of the positive gate voltage applied to the gate electrodes 144. In such a case, electrons emitted from the source electrodes 150 may be drifted toward the drain electrode 170 through the third nitride-based semiconductor layer 130, the channel layers, the first nitride-based semiconductor layer 105, and the fourth nitride-based semiconductor layer 160. According to the present embodiment, the channel layers controlled by the gate electrodes 144 may be formed in a vertical direction and may be formed in an N-type GaN layer to increase a mobility of carriers (i.e., electrons) drifted therein.

As a first comparative example, a nitride-based transistor including a first N-type nitride-based region (acting as a source region), a P-type nitride-based region (acting as a channel body), and a second N-type nitride-based region (acting as a drain region) may be proposed. In such a case, an N-type channel layer may be formed in the P-type nitride-based region using a gate bias. However, according to the first comparative example, it may be difficult to improve an electron mobility in the N-type channel layer formed in the P-type nitride-based region. In general, the P-type nitride-based region may be formed by doping a GaN layer with P-type dopants such as magnesium (Mg) ions. In such a case, a dose of the P-type dopants has to increase to obtain a high threshold voltage appropriate for a high voltage operation. However, if a dose of the P-type dopants increases, it may be difficult to fully activate the P-type dopants injected into the GaN layer. This may lead to a difficulty in improving an electron mobility in the N-type channel layer formed in the P-type nitride-based region. Moreover, as a second comparative example, a nitride-based transistor including a first N-type nitride-based region (acting as a source region), a P-type nitride-based region (acting as a channel body), and a second N-type nitride-based region (acting as a drain region) may be proposed, and a two-dimension electron gas (2DEG) layer may be formed between the P-type nitride-based region and a gate electrode due to a junction of an AlGaN layer and a GaN layer. In such a case, since the 2DEG layer acts as a channel layer, a channel mobility may be improved. However, a threshold voltage of the nitride-based transistor according to the second comparative example may be too low to use the nitride-based transistor as a high voltage transistor. That is, it may be difficult to modulate the 2DEG layer acting as a channel layer with a gate bias. For example, it may be difficult to obtain a threshold voltage higher than 3 volts.

In contrast, according to the embodiment described above, the depletion regions 115 may be formed in the first nitride-based semiconductor layer 105 adjacent to the gate electrode 144 at an equilibrium state and a width of the depletion regions 115 may be modulated by a gate voltage applied to the gate electrodes 144. Thus, a channel mobility may be improved and a high threshold voltage over 3 volts may be obtained. Accordingly, the embodiment described with reference to FIG. 27 may overcome the disadvantages (e.g., a low channel mobility and a low threshold voltage) of the first and second comparative examples.

In addition, the current blocking insulation patterns 110 may be disposed under the second nitride-based semiconductor patterns 120 to block the leakage currents that flow from the source electrode 150 toward the drain electrode 170 through the second nitride-based semiconductor patterns 120. Moreover, the current blocking insulation patterns 110 may include a nitride-based material having the substantially the same lattice constant as the first nitride-based semiconductor layer 105 and the second nitride-based semiconductor patterns 120. Thus, no deformation occurs in the first nitride-based semiconductor layer 105, second nitride-based semiconductor patterns 120 and the current blocking insulation patterns 110 because the first nitride-based semiconductor layer 105, second nitride-based semiconductor patterns 120 and the current blocking insulation patterns 110 have the same lattice constant.

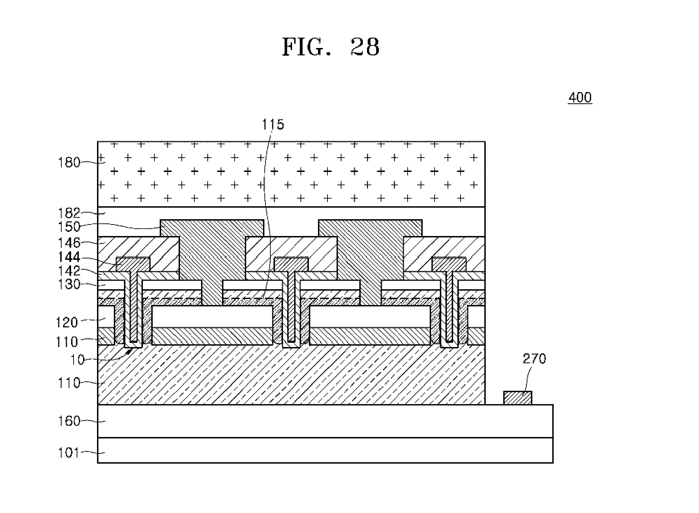

FIG. 28 is a cross-sectional view illustrating a nitride-based transistor 400 according to a fourth embodiment of the present disclosure. Referring to FIG. 28, the nitride-based transistor 400 may have substantially the same configuration as the nitride-based transistor 300 illustrated in FIG. 27 except that the fourth nitride-based semiconductor layer 160 is disposed on a substrate 101 and a drain electrode 270 is disposed on a portion of the fourth nitride-based semiconductor layer 160.

In some embodiments, the substrate 101 may be one selected from the group consisting of a sapphire substrate, a GaN substrate, a silicon carbide (SiC) substrate, a silicon substrate and an aluminum nitride (AlN) substrate. However, these substrates are merely examples of suitable substrates for the nitride-based transistor 400. Any substrate having an electrical insulation property can also be used as the substrate 101.

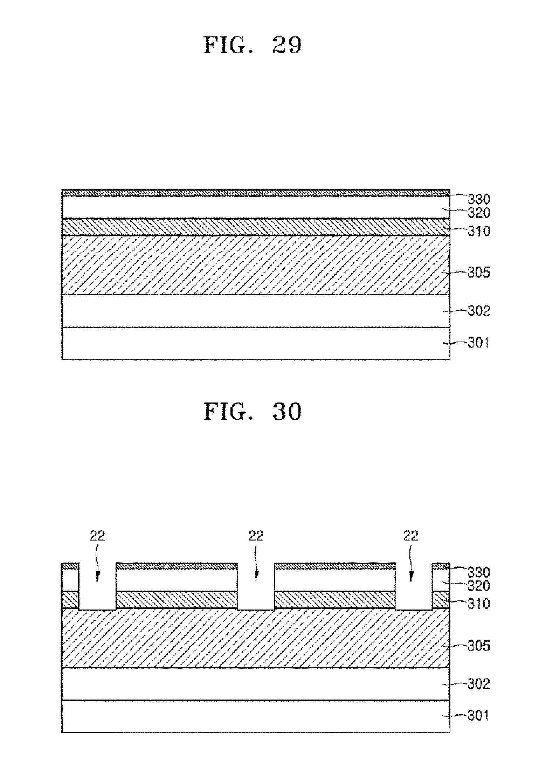

FIGS. 29 to 40 are cross-sectional views illustrating a method of fabricating a nitride-based transistor according to yet another embodiment of the present disclosure. In the following embodiment, a nitride-based semiconductor layer may include a nitride material such as an AlₓIn_{y}Ga_{1-x-y}N (where, 0≤x≤1 and 0≤y≤1) layer. In some embodiments, the nitride-based semiconductor layer may be formed using a MOCVD process, an MBE process, or a hydride vapor phase epitaxy process.

Referring to FIG. 29, a first nitride-based semiconductor layer 305 doped with dopants having a first type, a current blocking insulation layer 310, a second nitride-based semiconductor layer 320 doped with dopants having a second type, and a third nitride-based semiconductor layer 330 doped with dopants having the first type may be sequentially formed on a substrate 301. In some embodiments, a lower nitride-based semiconductor layer 302 heavily doped with dopants having the first type may be additionally formed between the substrate 301 and the first nitride-based semiconductor layer 305. That is, an impurity concentration of the lower nitride-based semiconductor layer 302 may be higher than that of the first nitride-based semiconductor layer 305.

The substrate 301 may be one selected from the group consisting of a sapphire substrate, a GaN substrate, a silicon carbide (SiC) substrate, a silicon substrate and an aluminum nitride (AlN) substrate. However, these substrates are merely examples of suitable substrates for fabrication of the nitride-based transistor. That is, any substrate on which a nitride-based layer can be grown may also be used as the substrate 301.

In some embodiments, the first nitride-based semiconductor layer 305, the second nitride-based semiconductor layer 320, and the third nitride-based semiconductor layer 330 may be formed of the same material layer except for the conductivity type. If the first type is an N-type, the second type may be a P-type. On the contrary, if the first type is a P-type, the second type may be an N-type. In some embodiments, the dopants having an N-type may include silicon ions and the dopants having a P-type may include beryllium (Be) ions, magnesium (Mg) ions, calcium (Ca) ions, carbon (C) ions, iron (Fe) ions and manganese (Mn) ions.

The current blocking insulation layer 310 may include a nitride-based semiconductor material doped with carbon ions or iron ions. In some embodiments, when the current blocking insulation layer 310 is formed using a MOCVD process, an MBE process or a hydride vapor phase epitaxy process, a carbon tetrabromide (CBr₄) gas or a carbon tetrachloride (CCl₄) gas may be used as a dopant gas for producing carbon ions. Alternatively, when the current blocking insulation layer 310 is formed using a MOCVD process, an MBE process or a hydride vapor phase epitaxy process, a bis(cyclopentadienyl)iron (Cp2Fe) material may be used as a precursor for producing iron ions.

Referring to FIG. 30, first trenches 22 may be formed to penetrate the third and second nitride-based semiconductor layers 330 and 320 as well as the current blocking insulation layer 310 and to extend into the first nitride-based semiconductor layer 305. The first trenches 22 may be formed by etching the third and second nitride-based semiconductor layers 330 and 320 and the current blocking insulation layer 310. Each of the first trenches 22 may be formed to include a bottom surface and sidewalls perpendicular to the bottom surface. Alternatively, each of the first trenches 22 may be formed to include a bottom surface and sidewalls non-perpendicular to the bottom surface. In such a case, the sidewalls of the first trenches 22 may have a sloped profile. A tilt angle of the sloped sidewalls of the first trenches 22 to the bottom surfaces of the first trenches 22 may be different according to the etch process for forming the first trenches 22. In addition, the tilt angle of the sloped sidewalls of the first trenches 22 to the bottom surfaces of the first trenches 22 may be within a range of about 30 degrees to about 90 degrees according to lattice planes of the first, second and third nitride-based semiconductor layers 305, 320 and 330 and the current blocking insulation layer 310 (e.g., GaN layers). In some embodiments, the tilt angle of the sloped sidewalls of the first trenches 22 to the bottom surfaces of the first trenches 22 may be within a range of about 60 degrees to about 70 degrees when the first trenches 22 are formed using a dry etch process or a wet etch process.

The first trenches 22 may be formed to have bottom surfaces whose levels are coplanar with or lower than a level of an interface between the first nitride-based semiconductor layer 305 and the current blocking insulation layer 310.

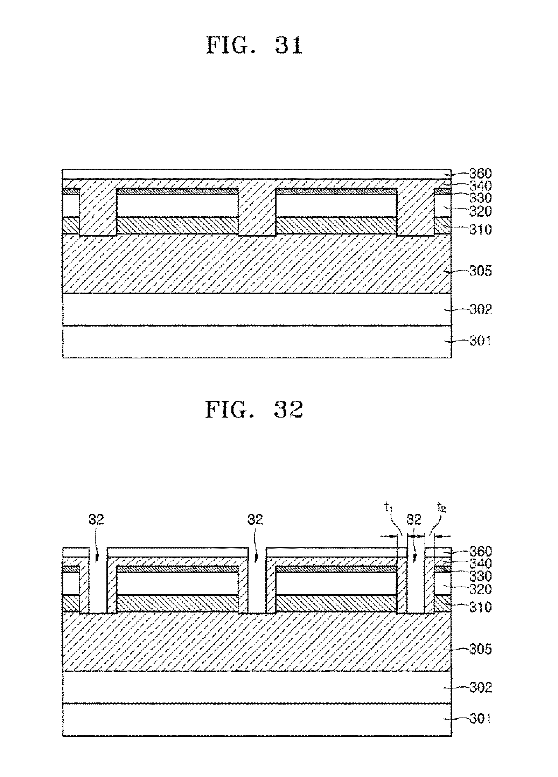

Referring to FIG. 31, a fourth nitride-based semiconductor layer 340 doped with dopants having the first type may be formed on the third nitride-based semiconductor layer 330 to fill the first trenches 22. That is, the fourth nitride-based semiconductor layer 340 may be formed in the first trenches 22 and on the third nitride-based semiconductor layer 330. Subsequently, an upper nitride-based semiconductor layer 360 heavily doped with dopants having the first type may be formed on the fourth nitride-based semiconductor layer 340. In some embodiments, the fourth nitride-based semiconductor layer 340 may be formed of an N-type GaN layer having an impurity concentration of about 1×10¹⁷ /cm³ to about 1×10¹⁹ /cm³, and the upper nitride-based semiconductor layer 360 may be formed of an N-type GaN layer having an impurity concentration which is equal to or higher than 1×10¹⁹ /cm³. The second nitride-based semiconductor patterns 320 may be surrounded by the first nitride-based semiconductor layer 305, the current blocking insulation layer 310, the third nitride-based semiconductor patterns 330 and the fourth nitride-based semiconductor layer 340.

Referring to FIG. 32, the upper nitride-based semiconductor layer 360 and the fourth nitride-based semiconductor layer 340 may be patterned to form second trenches 32. The second trenches 32 may be formed in respective ones of the first trenches 22.

More specifically, the second trenches 32 may be formed by etching the upper nitride-based semiconductor layer 360 and the fourth nitride-based semiconductor layer 340 such that portions of the fourth nitride-based semiconductor layer 340 remain on the sidewalls of the first trenches 22 to have predetermined thicknesses T1 and T2. The remaining portions of the fourth nitride-based semiconductor layer 340 on the sidewalls of the first trenches 22 may act as channel body layers of the nitride-based transistor. Thus, the thicknesses T1 and T2 (i.e., widths in a horizontal direction) of the remaining portions of the fourth nitride-based semiconductor layer 340 on the sidewalls of the first trenches 22 may be determined in consideration of a width of depletion regions which are formed between the second nitride-based semiconductor patterns 320 and gate electrodes to be formed in the second trenches 32. The second trenches 32 may be formed to have bottom surfaces whose levels are lower than levels of bottom surfaces of the second nitride-based semiconductor patterns 320. Although FIG. 32 illustrates an example in which bottom surfaces of the second trenches 32 are coplanar with bottom surfaces of the first trenches 22, the inventive concept is not limited thereto. For example, the second trenches 32 may be formed such that a level of the bottom surfaces of the second trenches 32 is lower or higher than a level of the bottom surfaces of the first trenches 22.

The second trenches 32 may be formed such that the sidewalls of the second trenches 32 are perpendicular to the bottom surfaces of the second trenches 32. Alternatively, the second trenches 32 may be formed such that the sidewalls of the second trenches 32 are non-perpendicular to the bottom surfaces of the second trenches 32. In such a case, the sidewalls of the second trenches 32 may have a sloped profile. A tilt angle of the sloped sidewalls of the second trenches 32 to the bottom surfaces of the second trenches 32 may be different according to the etch process for forming the second trenches 32. In addition, the tilt angle of the sloped sidewalls of the second trenches 32 to the bottom surfaces of the second trenches 32 may be within a range of about 30 degrees to about 90 degrees according to lattice planes of the fourth and upper nitride-based semiconductor layers 340 and 360 (e.g., GaN layers). In some embodiments, the tilt angle of the sloped sidewalls of the second trenches 32 to the bottom surfaces of the second trenches 32 may be within a range of about 60 degrees to about 70 degrees when the second trenches 32 are formed using a dry etch process or a wet etch process.

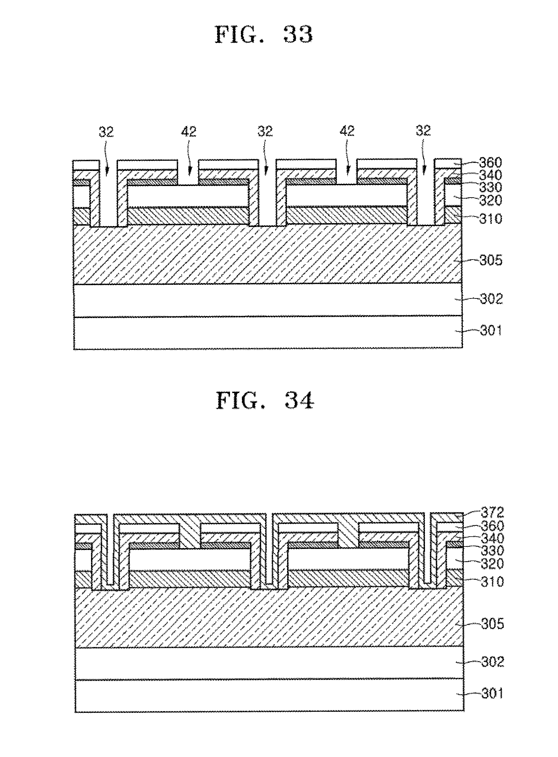

Referring to FIG. 33, the upper nitride-based semiconductor layer 360, the fourth nitride-based semiconductor layer 340 and the third nitride-based semiconductor patterns 330 may be etched to form third trenches 42 that are disposed between the second trenches 32 to expose portions of the second nitride-based semiconductor patterns 320. The third trenches 42 may be formed such that sidewalls of the third trenches 42 are perpendicular to bottom surfaces of the third trenches 42. Alternatively, the third trenches 42 may be formed such that the sidewalls of the third trenches 42 are non-perpendicular to the bottom surfaces of the third trenches 42. That is, the sidewalls of the third trenches 42 may have may be formed to have a sloped profile. The third trenches 42 may function as source contact holes in which source electrodes 380 are formed in a subsequent process.

Referring to FIG. 34, a gate dielectric layer 372 may be formed in the second and third trenches 32 and 42 and on the upper nitride-based semiconductor layer 360. As illustrated in FIG. 34, the gate dielectric layer 372 may be formed to fill the third trenches 42, but the gate dielectric layer 372 may be conformably formed in the second trenches 32.

The gate dielectric layer 372 may be formed to include an oxide layer, a nitride layer or an oxynitride layer. The gate dielectric layer 372 may be formed using a CVD process, a sputtering process, an ALD process or an evaporation process.

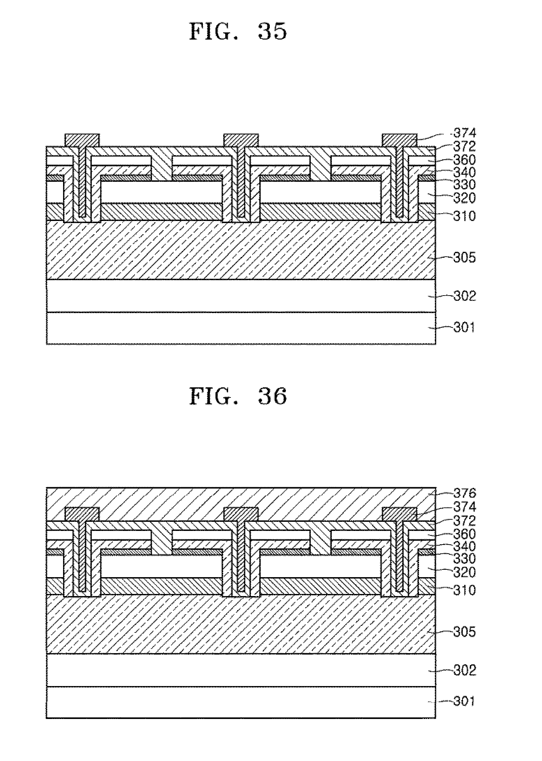

Referring to FIG. 35, a gate conductive layer may be formed on the gate dielectric layer 372 to fill the second trenches 32. The gate conductive layer may be patterned to form gate electrodes 374 covering the second trenches 32. The gate conductive layer may be formed to include a GaN layer doped with P-type dopants such as beryllium (Be) ions, magnesium (Mg) ions, calcium (Ca) ions, carbon (C) ions, iron (Fe) ions, manganese (Mn) ions, or mixed ions containing at least two different ions among the above-listed ions. Alternatively, gate conductive layer may be formed to include a metal layer such as a nickel (Ni) layer, a gold (Au) layer, a titanium (Ti) layer or an aluminum (Al) layer. The gate conductive layer may be formed using a CVD process, a sputtering process, an ALD process or an evaporation process.

Referring to FIG. 36, an interlayer insulation layer 376 may be formed on the gate dielectric layer 372 and the gate electrodes 374. The interlayer insulation layer 376 may be formed to include an oxide layer, a nitride layer or an oxynitride layer. The interlayer insulation layer 376 may be formed using a CVD process, a sputtering process, an ALD process or an evaporation process.

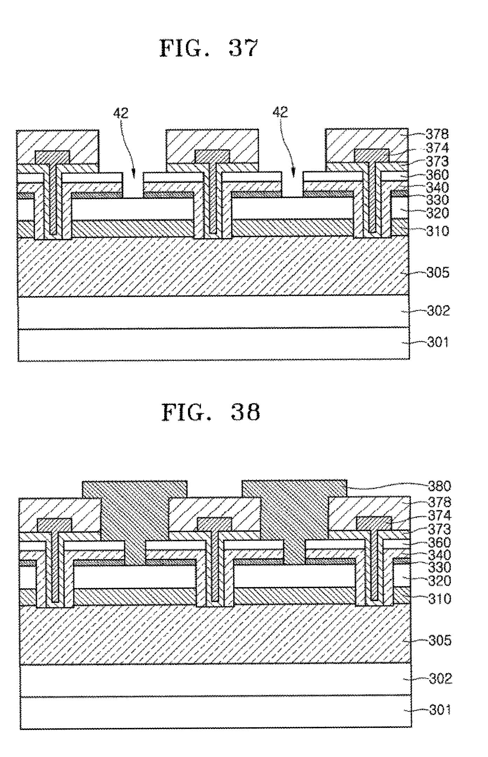

Referring to FIG. 37, the interlayer insulation layer 376 and the gate dielectric layer 372 may be patterned to form interlayer insulation patterns 378 and gate dielectric patterns 373. As a result of the etch process for forming the interlayer insulation patterns 378 and gate dielectric patterns 373, the gate dielectric layer 372 in the third trenches 42 may be removed to expose the sidewalls and bottom surfaces of the third trenches 42. That is, the interlayer insulation layer 376 and the gate dielectric layer 372 may be etched to expose portions of the second nitride-based semiconductor patterns 320. The third trenches 42 may function as source contact holes in which source electrodes 380 are formed in a subsequent process. In some embodiments, after forming the source contact holes 42, a thermal treatment process may be performed to remove hydrogen atoms in the second nitride-based semiconductor patterns 320 and the third nitride-based semiconductor patterns 330.

Referring to FIG. 38, source electrodes 380 may be formed in the source contact holes 42. The source electrodes 380 may be formed to extend into gap regions between the interlayer insulation patterns 378. The source electrodes 380 may be formed of a material exhibiting an ohmic contact with respect to the third nitride-based semiconductor patterns 330, the fourth nitride-based semiconductor layer 340 or the upper nitride-based semiconductor patterns 360. In some embodiments, the source electrodes 380 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. The source electrodes 380 may be formed using a CVD process, a sputtering process, an ALD process or an evaporation process.

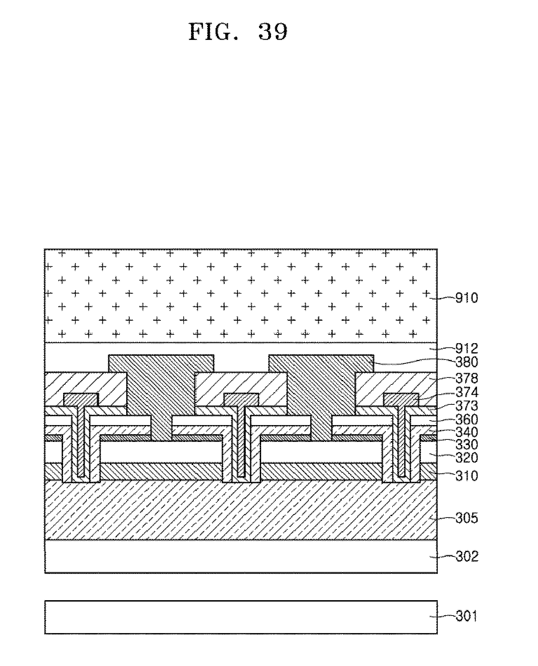

Referring to FIG. 39, a heat sink 910 may be formed on the source electrodes 380. The heat sink 910 may act as a heat radiator for emitting heat generated in a nitride-based transistor. Thus, the heat sink 910 may be formed to include a material having an excellent heat conductivity, for example, a metal material. The heat sink 910 may be attached to the source electrodes 380 using an adhesion member 912. The adhesion member 912 may include a solder material or a metal paste material having an excellent heat conductivity, but not limited thereto. For example, in some embodiments, the adhesion member 912 may be formed to include another adhesion member well known in the art.

Referring again to FIG. 39, the substrate 301 may be detached from the lower nitride-based semiconductor layer 302. The substrate 301 may be detached from the lower nitride-based semiconductor layer 302 using a laser lift-off process.

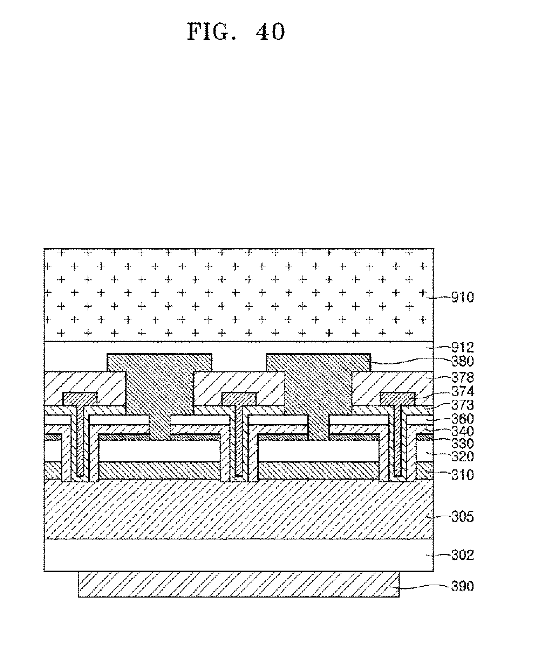

Referring to FIG. 40, a drain electrode 390 may be formed on the exposed surface of the lower nitride-based semiconductor layer 302 opposite to the first nitride-based semiconductor layer 305. The drain electrode 390 may be formed of a material exhibiting an ohmic contact with respect to the lower nitride-based semiconductor layer 302. In some embodiments, the drain electrode 390 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. The drain electrode 390 may be formed using a CVD process, a sputtering process, an ALD process or an evaporation process. A nitride-based transistor according to an embodiment may be fabricated through the aforementioned processes.

In some other embodiments, after the source electrodes 380 illustrated in FIG. 38 are formed, the first, second, third, fourth and upper nitride-based semiconductor layers 305, 320, 330, 340 and 360 and the current blocking insulation layer 310 may be patterned to expose a portion of the lower nitride-based semiconductor layer 302. Subsequently, the drain electrode 390 may be formed on the exposed portion of the lower nitride-based semiconductor layer 302. Even in this case, a heat sink may also be additionally formed on the source electrodes 380.

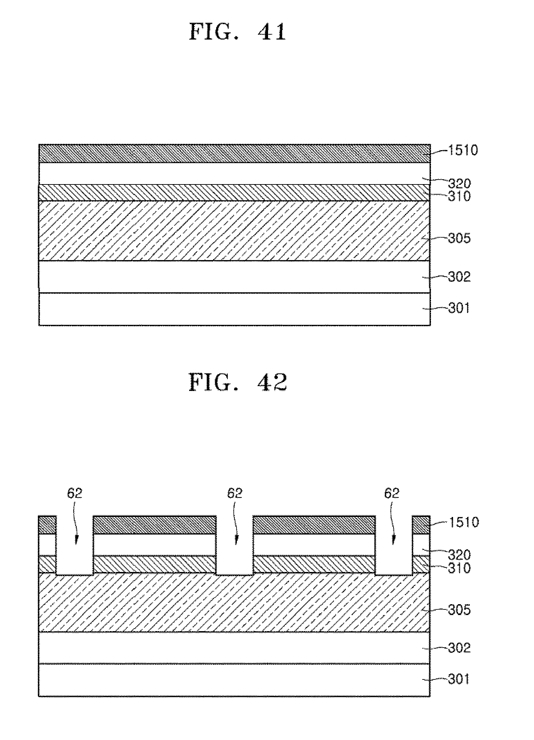

FIGS. 41 to 52 are cross-sectional views illustrating a method of fabricating a nitride-based transistor according to still another embodiment of the present disclosure. In the following embodiment, a nitride-based semiconductor layer may include a nitride material such as an AlₓIn_{y}Ga_{1-x-y}N (where, 0≤x≤1 and 0≤y≤1) layer. In some embodiments, the nitride-based semiconductor layer may be formed using an MOCVD process, an MBE process, or a hydride vapor phase epitaxy process. To avoid duplicate explanation, detailed descriptions of the same elements as set forth in the previous embodiment illustrated in FIGS. 29 to 40 will be omitted in this embodiment.

Referring to FIG. 41, a lower nitride-based semiconductor layer 302 heavily doped with dopants having a first type, a first nitride-based semiconductor layer 305 doped with dopants having the first type, a current blocking insulation layer 310, a second nitride-based semiconductor layer 320 doped with dopants having a second type, and an upper nitride-based semiconductor layer 1510 heavily doped with dopants having the first type may be sequentially formed on a substrate 301. In some embodiments, the lower nitride-based semiconductor layer 302 may be formed of a GaN layer heavily doped with N-type dopants, and the first nitride-based semiconductor layer 305 may be formed of a GaN layer lightly doped with N-type dopants. Moreover, the second nitride-based semiconductor layer 320 may be formed of a GaN layer doped with P-type dopants, and the upper nitride-based semiconductor layer 1510 may be formed of a GaN layer heavily doped with N-type dopants. The lower nitride-based semiconductor layer 302 and the upper nitride-based semiconductor layer 1510 may be doped to have an impurity concentration which is equal to or higher than about 1×10¹⁸ /cm³, and the first nitride-based semiconductor layer 305 may be doped to have an impurity concentration of about 1×10¹⁶ /cm³ to about 1×10¹⁸ /cm³.

The current blocking insulation layer 310 may be formed to include a nitride-based semiconductor material doped with carbon ions or iron ions. In some embodiments, when the current blocking insulation layer 310 is formed using a MOCVD process, an MBE process or a hydride vapor phase epitaxy process, a carbon tetrabromide (CBr₄) gas or a carbon tetrachloride (CCl₄) gas may be used as a dopant gas for producing carbon ions. Alternatively, when the current blocking insulation layer 310 is formed using a MOCVD process, an MBE process or a hydride vapor phase epitaxy process, a bis(cyclopentadienyl)iron (Cp2Fe) material may be used as a precursor for producing iron ions.

Referring to FIG. 42, first trenches 62 may be formed to penetrate the upper and second nitride-based semiconductor layers 1510 and 320 as well as the current blocking insulation layer 310 and to extend into the first nitride-based semiconductor layer 305. The first trenches 62 may be formed by etching the upper, second and first nitride-based semiconductor layers 1510, 320 and 305 and the current blocking insulation layer 310. Each of the first trenches 62 may be formed to include a bottom surface and sidewalls perpendicular to the bottom surface. Alternatively, each of the first trenches 62 may be formed to include a bottom surface and sidewalls non-perpendicular to the bottom surface. In such a case, the sidewalls of the first trenches 62 may have a sloped profile.

The first trenches 62 may be formed to have bottom surfaces which are coplanar with or lower than an interface between the first nitride-based semiconductor layer 305 and the current blocking insulation layer 310.

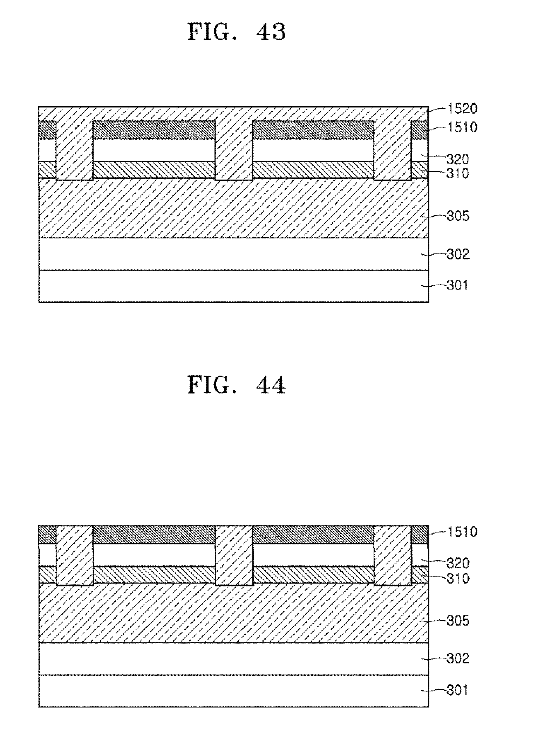

Referring to FIG. 43, a third nitride-based semiconductor layer 1520 doped with dopants having the first type may be formed on the upper nitride-based semiconductor layer 1510 to fill the first trenches 62. That is, the third nitride-based semiconductor layer 1520 may be formed in the first trenches 62 and on the upper nitride-based semiconductor layer 1510. In some embodiments, the third nitride-based semiconductor layer 1520 may be formed of an N-type GaN layer having an impurity concentration of about 1×10¹⁷ /cm³ to about 1×10¹⁹ /cm³. The second nitride-based semiconductor patterns 320 may be surrounded by the first nitride-based semiconductor layer 305, the current blocking insulation patterns 310, the upper nitride-based semiconductor patterns 1510 and the third nitride-based semiconductor layer 1520.

Referring to FIG. 44, the third nitride-based semiconductor layer 1520 may be planarized to expose top surfaces of the upper nitride-based semiconductor patterns 1510. The third nitride-based semiconductor layer 1520 may be planarized using a chemical mechanical polishing (CMP) process, a dry etch process or a wet etch process.

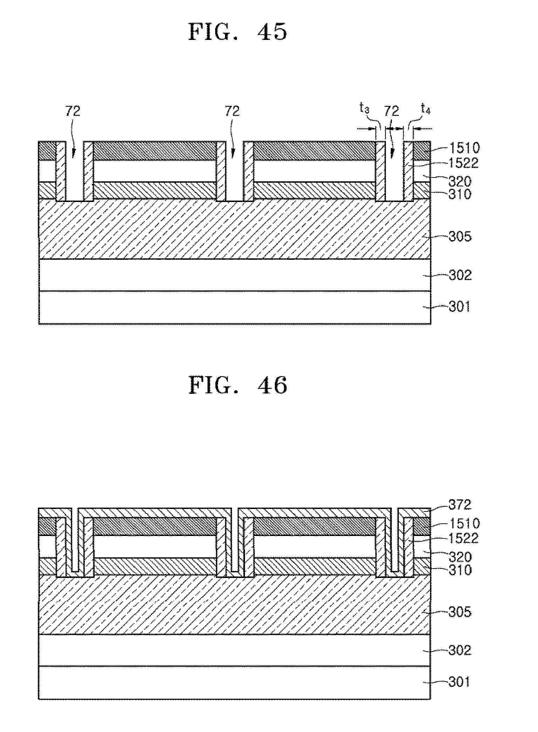

Referring to FIG. 45, the third nitride-based semiconductor patterns 1520 in the first trenches 62 may be patterned to form second trenches 72. The second trenches 72 may be formed in respective ones of the first trenches 62. More specifically, the second trenches 72 may be formed by etching the third nitride-based semiconductor patterns 1520 such that portions of the third nitride-based semiconductor patterns 1520 remain on the sidewalls of the first trenches 62 to have predetermined thicknesses T3 and T4. The remaining portions of the third nitride-based semiconductor patterns 1520 on the sidewalls of the first trenches 62 may act as channel body layers of the nitride-based transistor. Thus, the thicknesses T3 and T4 (i.e., widths in a horizontal direction) of the remaining portions of the third nitride-based semiconductor layer 1520 on the sidewalls of the first trenches 62 may be determined in consideration of a width of depletion regions which are formed between the second nitride-based semiconductor patterns 320 and gate electrodes to be formed in the second trenches 72.

Although FIG. 45 illustrates an example in which bottom surfaces of the second trenches 72 are coplanar with bottom surfaces of the first trenches 62, the inventive concept is not limited thereto. For example, the second trenches 72 may be formed such that a level of the bottom surfaces of the second trenches 72 is lower or higher than a level of the bottom surfaces of the first trenches 62.

Referring to FIG. 46, a gate dielectric layer 372 may be formed in the second trenches 72 and on the upper nitride-based semiconductor patterns 1510. As illustrated in FIG. 46, the gate dielectric layer 372 may be conformably formed in the second trenches 72.

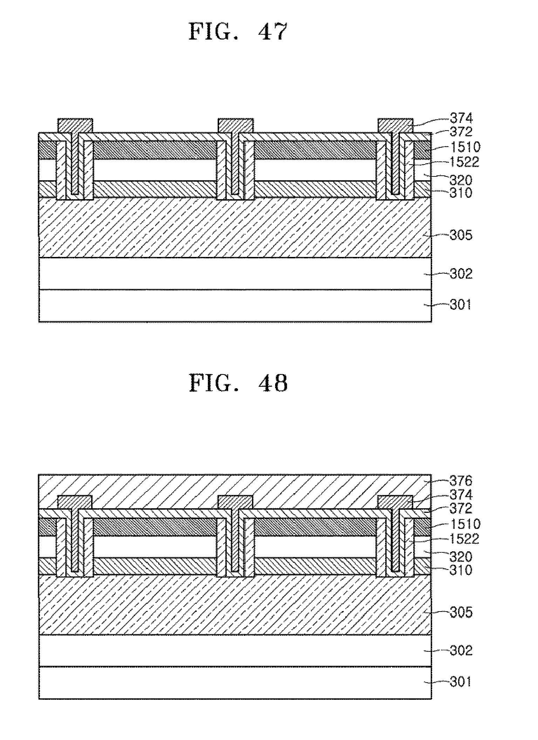

Referring to FIG. 47, a gate conductive layer may be formed on the gate dielectric layer 372 to fill the second trenches 72. The gate conductive layer may be patterned to form gate electrodes 374 covering the second trenches 72.

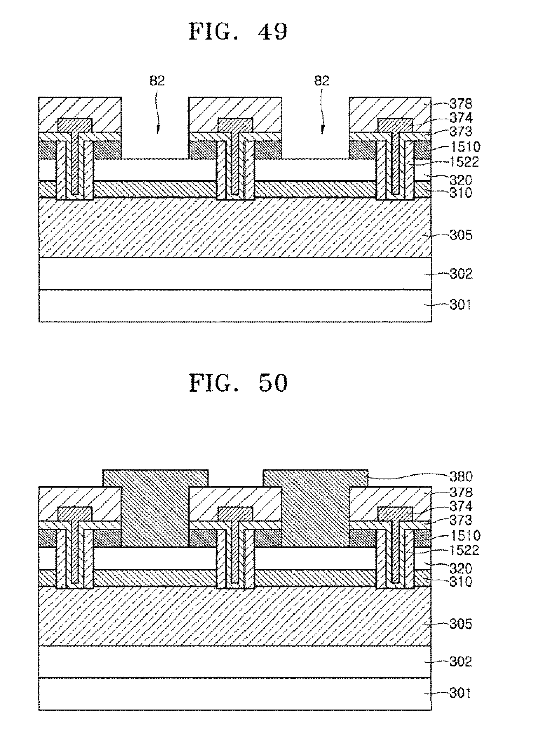

Referring to FIG. 48, an interlayer insulation layer 376 may be formed on the gate dielectric layer 372 and the gate electrodes 374. Referring to FIG. 49, the interlayer insulation layer 376, the gate dielectric layer 372 and the upper nitride-based semiconductor patterns 1510 may be patterned to form insulation patterns 378 and gate dielectric patterns 373. As a result of the etch process for forming the interlayer insulation patterns 378 and gate dielectric patterns 373, third trenches 82 may be formed to expose portions of the second nitride-based semiconductor patterns 320. The third trenches 82 may function as source contact holes in which source electrodes 380 are formed in a subsequent process.

Referring to FIG. 50, source electrodes 380 may be formed in the source contact holes 82. The source electrodes 380 may be formed to extend into gap regions between the insulation patterns 378. The source electrodes 380 may be formed of a material exhibiting an ohmic contact with respect to the upper nitride-based semiconductor patterns 1510.

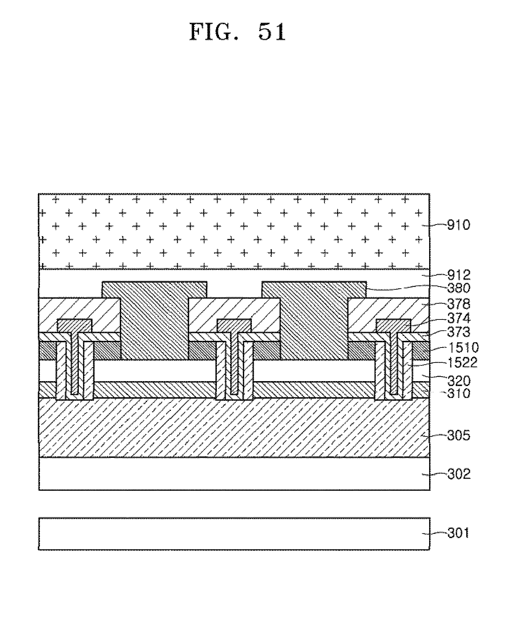

Referring to FIG. 51, a heat sink 910 may be formed on the source electrodes 380. The heat sink 910 may act as a heat radiator for emitting heat generated in the nitride-based transistor. The heat sink 910 may be attached to the source electrodes 380 using an adhesion member 912. The adhesion member 912 may include a solder material or a metal paste material having an excellent heat conductivity, but not limited thereto. For example, in some embodiments, the adhesion member 912 may include another adhesion member well known in the art.

Referring again to FIG. 51, the substrate 301 may be detached from the lower nitride-based semiconductor layer 302. The substrate 301 may be detached from the lower nitride-based semiconductor layer 302 using a laser lift-off process.

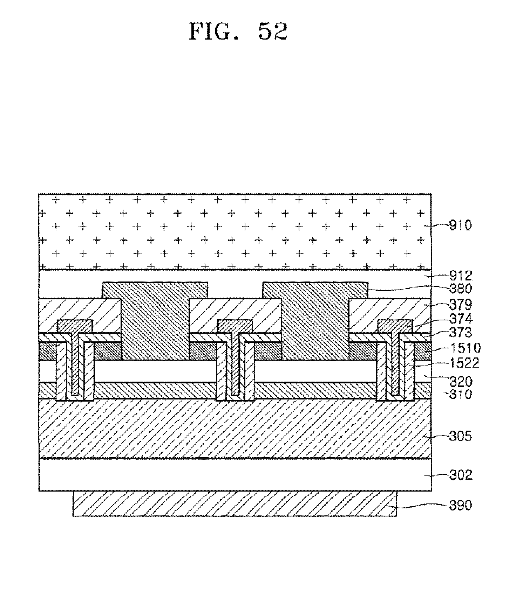

Referring to FIG. 52, a drain electrode 390 may be formed on the exposed surface of the lower nitride-based semiconductor layer 302 opposite to the first nitride-based semiconductor layer 305. The drain electrode 390 may be formed of a material exhibiting an ohmic contact with respect to the lower nitride-based semiconductor layer 302. A nitride-based transistor according to an embodiment may be fabricated through the aforementioned processes.

In some other embodiments, after the source electrodes 380 illustrated in FIG. 50 are formed, the first, second and upper nitride-based semiconductor layers 305, 320 and 1510 and the current blocking insulation layer 310 may be patterned to expose a portion of the lower nitride-based semiconductor layer 302. Subsequently, the drain electrode 390 may be formed on the exposed portion of the lower nitride-based semiconductor layer 302. As a result, a nitride-based transistor having substantially the same configuration as the nitride-based transistor 200 illustrated in FIG. 28 can be fabricated. Even in this case, a heat sink may also be additionally formed on the source electrodes 380.

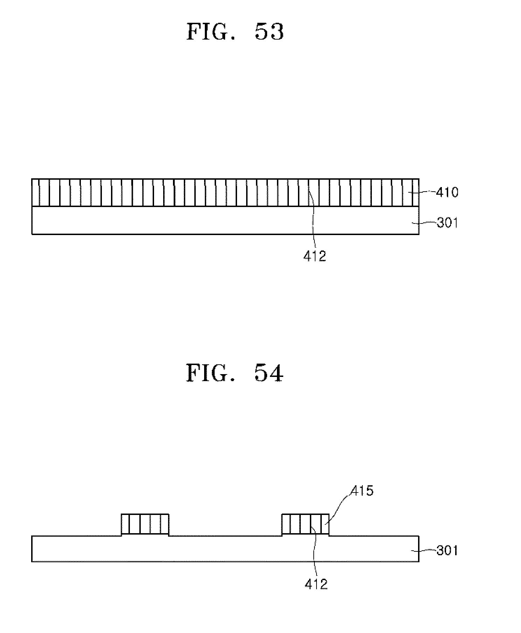

FIGS. 53 to 69 are cross-sectional views illustrating a method of fabricating a vertical nitride-based transistor according to an embodiment of the present disclosure. In the following embodiment, a nitride-based semiconductor layer may include a nitride material such as an AlₓIn_{y}Ga_{1-x-y}N (where, 0≤x≤1 and 0≤y≤1) layer. In some embodiments, the nitride-based semiconductor layer may be formed using a metal organic chemical vapor deposition (MOCVD) process, a molecular beam epitaxy (MBE) process, or a hydride vapor phase epitaxy process.

Referring to FIG. 53, a nitride layer 410 may be formed on a substrate 301. The substrate 301 may be one selected from the group consisting of a silicon substrate, a sapphire substrate, a SiC substrate, and an AlN substrate. However, the substrate 301 is not limited to the above-listed substrates. For example, any substrate on which a nitride-based layer can be grown may be used as the substrate 301.

The nitride layer 410 may include a nitride-based semiconductor layer such as an AlₓIn_{y}Ga_{1-x-y}N (where, 0≤x≤1 and 0≤y≤1) layer. In some embodiments, if the substrate 301 is a sapphire substrate, the nitride layer 410 may be a GaN layer. While the nitride layer 410 is formed on the substrate 301, line-shaped dislocations 412 (also, referred to as vertical threading dislocations) may be formed in the nitride layer 410 due to a lattice constant difference between the substrate 301 and the nitride layer 410. The line-shaped dislocations 412 may be formed in a vertical direction which is orthogonal to a surface of the substrate 301.

Referring to FIG. 54, the nitride layer 410 may be patterned to nitride seed patterns 415. The nitride seed patterns 415 may be formed by selectively etching portions of the nitride layer 410 with a mask (not shown). In such a case, the substrate 301 between the nitride seed patterns 415 may be recessed by an over-etch step. The etch process for forming the nitride seed patterns 415 may be performed using an anisotropic etch process. In some embodiments, the etch process for forming the nitride seed patterns 415 may be performed using a dry etch process, a wet etch process or a combination thereof.

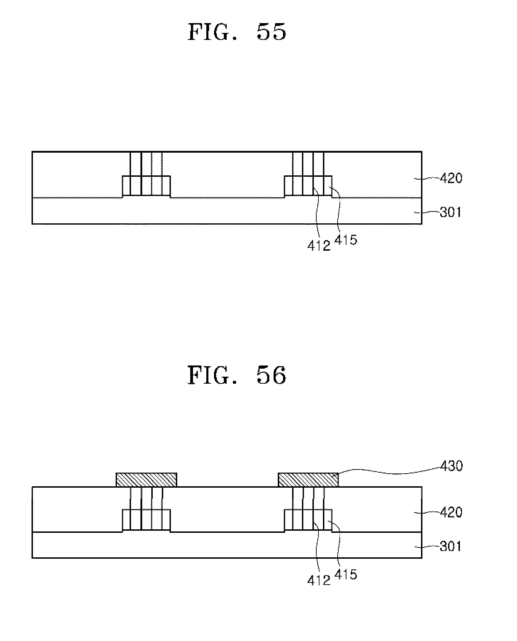

Referring to FIG. 55, a nitride buffer layer 420 may be grown on the nitride seed patterns 415 and the substrate 301 using the nitride seed patterns 415 as seed layers. The nitride buffer layer 420 may be grown to include a nitride-based semiconductor layer such as an AlₓIn_{y}Ga_{1-x-y}N (where, 0≤x≤1 and 0≤y≤1) layer. In some embodiments, the nitride buffer layer 420 may be grown to include a GaN layer, an AlGaN layer, or a combination thereof. The nitride buffer layer 420 may be doped with dopants having a first type while the nitride buffer layer 420 is grown or after the nitride buffer layer 420 is grown.

The nitride buffer layer 420 may be vertically and laterally grown. In such a case, the line-shaped dislocations 412 may be formed to extend in a vertical direction orthogonal to a surface of the substrate 301. Thus, the line-shaped dislocations 412 may be formed in portions of the nitride buffer layer 420, which are vertically grown on top surfaces of the nitride seed patterns 415. In contrast, the line-shaped dislocations 412 are not grown in a lateral direction. Thus, no line-shaped dislocations may be formed in portions of the nitride buffer layer 420 between the nitride seed patterns 415. This is due to the nature of an epitaxial growth process for growing the nitride buffer layer 420. That is, if the line-shaped dislocations 412 in the nitride seed patterns 415 are formed to be parallel with a vertical direction, the line-shaped dislocations 412 may be grown only in the vertical direction during a subsequent epitaxial growth process.

Referring to FIG. 56, mask patterns 430 may be formed on the nitride buffer layer 420. The mask patterns 430 may be formed to overlap with the nitride seed patterns 415 when viewed from a plan view. The mask patterns 430 may be formed of, for example, an oxide layer, a nitride layer or an oxynitride layer. In some embodiments, the mask patterns 430 may be formed of a silicon oxide layer. The mask patterns 430 may be formed to have an amorphous structure using a CVD process, an evaporation process or a coating process. Moreover, the mask patterns 430 may be formed of a material having a composition and a lattice structure which are different from those of the nitride buffer layer 420. Accordingly, the line-shaped dislocations 412 in the nitride buffer layer 420 are not grown into the mask patterns 430.

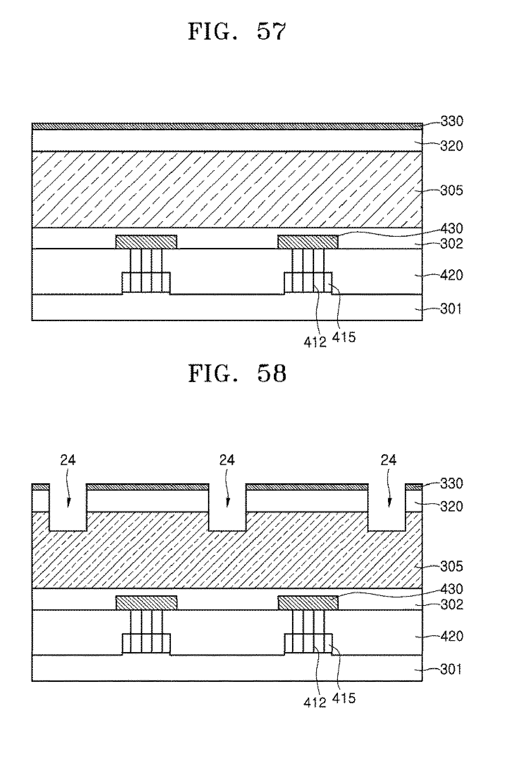

Referring to FIG. 57, a lower nitride-based semiconductor layer 302 heavily doped with dopants having the first type may be grown on the nitride buffer layer 420 to cover the mask patterns 430. Subsequently, a first nitride-based semiconductor layer 305 doped with dopants having the first type, a second nitride-based semiconductor layer 320 doped with dopants having a second type, and a third nitride-based semiconductor layer 330 doped with dopants having the first type may be sequentially formed on the lower nitride-based semiconductor layer 302.

The first nitride-based semiconductor layer 305, the second nitride-based semiconductor layer 320, and the third nitride-based semiconductor layer 330 may be formed of the same material layer except for the conductivity type. If the first type is an N-type, the second type may be a P-type. On the contrary, if the first type is a P-type, the second type may be an N-type. In some embodiments, the dopants having an N-type may include silicon ions, and the dopants having a P-type may include beryllium (Be) ions, magnesium (Mg) ions, calcium (Ca) ions, carbon (C) ions, iron (Fe) ions and manganese (Mn) ions.

In some embodiments, the nitride buffer layer 420 may be formed of a GaN layer doped with N-type dopants and the lower nitride-based semiconductor layer 302 may be formed of a GaN layer heavily doped with N-type dopants. In addition, each of the first and third nitride-based semiconductor layers 305 and 330 may be formed of a GaN layer doped with N-type dopants and the second nitride-based semiconductor layer 320 may be formed of a GaN layer doped with P-type dopants.

The lower nitride-based semiconductor layer 302 may be vertically and laterally grown on the nitride buffer layer 420 using an epitaxial growth process. During the epitaxial growth process, N-type dopants may be injected into the lower nitride-based semiconductor layer 302.

While the lower nitride-based semiconductor layer 302 is grown on the nitride buffer layer 420, the line-shaped dislocations 412 in the nitride buffer layer 420 may also be grown to extend into the lower nitride-based semiconductor layer 302. However, in such a case, a density of the line-shaped dislocations 412 in the lower nitride-based semiconductor layer 302 may be remarkably lower than that of the line-shaped dislocations 412 in the nitride buffer layer 420. This is because the lower nitride-based semiconductor layer 302 on the top surfaces of the mask patterns 430 is not directly grown from the nitride buffer layer 420 but indirectly and laterally grown from the nitride buffer layer 420. That is, the mask patterns 430 may function as blocking masks that disturb vertical growth of the line-shaped dislocations 412 under the mask patterns 430. Accordingly, a density of the line-shaped dislocations 412 in the lower nitride-based semiconductor layer 302 may be remarkably lower than that of the line-shaped dislocations 412 in the nitride buffer layer 420, as described above.

Referring to FIG. 58, first trenches 24 may be formed to penetrate the third and second nitride-based semiconductor layers 330 and 320 and to extend into the first nitride-based semiconductor layer 305. The first trenches 24 may be formed by etching the third, second and first nitride-based semiconductor layers 330, 320 and 305. Each of the first trenches 24 may be formed to include a bottom surface and sidewalls perpendicular to the bottom surface. Alternatively, each of the first trenches 24 may be formed to include a bottom surface and sidewalls non-perpendicular to the bottom surface. In such a case, the sidewalls of the first trenches 24 may have a sloped profile. A tilt angle of the sloped sidewalls of the first trenches 24 to the bottom surfaces of the first trenches 24 may be different according to the etch process for forming the first trenches 24. In addition, the tilt angle of the sloped sidewalls of the first trenches 24 to the bottom surfaces of the first trenches 24 may be within a range of about 30 degrees to about 90 degrees according to lattice planes of the first, second and third nitride-based semiconductor layers 305, 320 and 330 (e.g., GaN layers). In some embodiments, the tilt angle of the sloped sidewalls of the first trenches 24 to the bottom surfaces of the first trenches 24 may be within a range of about 60 degrees to about 70 degrees when the first trenches 24 are formed using a dry etch process or a wet etch process.

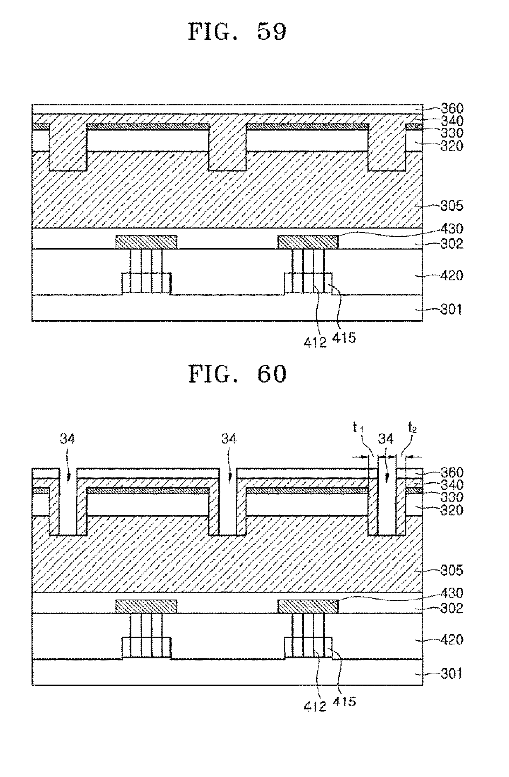

Referring to FIG. 59, a fourth nitride-based semiconductor layer 340 doped with dopants having the first type may be formed on the third nitride-based semiconductor layer 330 to fill the first trenches 24. That is, the fourth nitride-based semiconductor layer 340 may be formed in the first trenches 24 and on the third nitride-based semiconductor layer 330. Subsequently, an upper nitride-based semiconductor layer 360 heavily doped with dopants having the first type may be formed on the fourth nitride-based semiconductor layer 340. In some embodiments, the fourth nitride-based semiconductor layer 340 may be formed of an N-type GaN layer having an impurity concentration of about 1×10¹⁷ /cm³ to about 1×10¹⁹ /cm³, and the upper nitride-based semiconductor layer 360 may be formed of an N-type GaN layer having an impurity concentration which is equal to or higher than 1×10¹⁹ /cm³. The second nitride-based semiconductor patterns 320 may be surrounded by the first nitride-based semiconductor layer 305, the third nitride-based semiconductor patterns 330 and the fourth nitride-based semiconductor layer 340.

Referring to FIG. 60, the upper nitride-based semiconductor layer 360 and the fourth nitride-based semiconductor layer 340 may be patterned to form second trenches 34. The second trenches 34 may be formed in respective ones of the first trenches 24.

More specifically, the second trenches 34 may be formed by etching the upper nitride-based semiconductor layer 360 and the fourth nitride-based semiconductor layer 340 such that portions of the fourth nitride-based semiconductor layer 340 remain on the sidewalls of the first trenches 24 to have predetermined thicknesses T1 and T2. The remaining portions of the fourth nitride-based semiconductor layer 340 on the sidewalls of the first trenches 24 may act as channel body layers of the nitride-based transistor. Thus, the thicknesses T1 and T2 (i.e., widths in a horizontal direction) of the remaining portions of the fourth nitride-based semiconductor layer 340 on the sidewalls of the first trenches 24 may be determined in consideration of a width of depletion regions which are formed between the second nitride-based semiconductor patterns 320 and gate electrodes to be formed in the second trenches 34. The second trenches 34 may be formed to have bottom surfaces whose levels are lower than levels of bottom surfaces of the second nitride-based semiconductor patterns 320. Although FIG. 60 illustrates an example in which bottom surfaces of the second trenches 34 are coplanar with bottom surfaces of the first trenches 24, the inventive concept is not limited thereto. For example, the second trenches 34 may be formed such that a level of the bottom surfaces of the second trenches 34 is lower or higher than a level of the bottom surfaces of the first trenches 24.

The second trenches 34 may be formed such that the sidewalls of the second trenches 34 are perpendicular to the bottom surfaces of the second trenches 34. Alternatively, the second trenches 34 may be formed such that the sidewalls of the second trenches 34 are non-perpendicular to the bottom surfaces of the second trenches 34. In such a case, the sidewalls of the second trenches 34 may have a sloped profile. A tilt angle of the sloped sidewalls of the second trenches 34 to the bottom surfaces of the second trenches 34 may be different according to the etch process for forming the second trenches 34. In addition, the tilt angle of the sloped sidewalls of the second trenches 34 to the bottom surfaces of the second trenches 34 may be within a range of about 30 degrees to about 90 degrees according to lattice planes of the fourth and upper nitride-based semiconductor layers 340 and 360 (e.g., GaN layers). In some embodiments, the tilt angle of the sloped sidewalls of the second trenches 34 to the bottom surfaces of the second trenches 34 may be within a range of about 60 degrees to about 70 degrees when the second trenches 34 are formed using a dry etch process or a wet etch process.

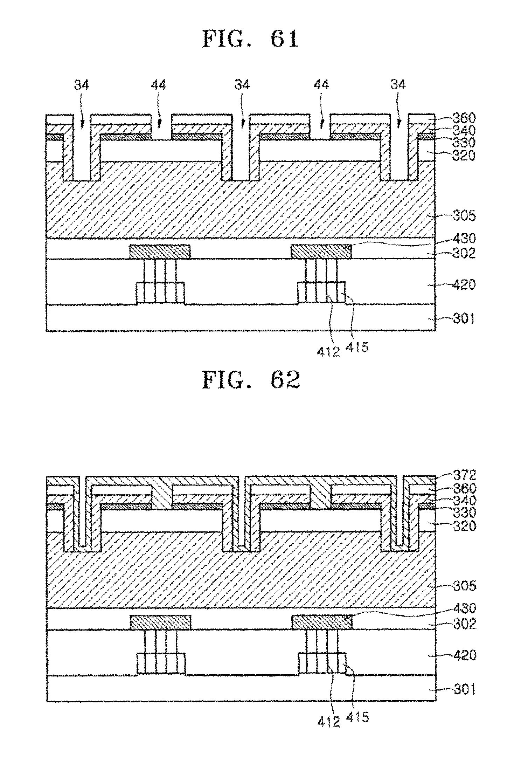

Referring to FIG. 61, the upper nitride-based semiconductor layer 360, the fourth nitride-based semiconductor layer 340 and the third nitride-based semiconductor patterns 330 may be patterned to form third trenches 40 that are disposed between the second trenches 34 to expose portions of the second nitride-based semiconductor patterns 320. The third trenches 44 may be formed such that sidewalls of the third trenches 44 are perpendicular to bottom surfaces of the third trenches 44. Alternatively, the third trenches 44 may be formed such that the sidewalls of the third trenches 44 are non-perpendicular to the bottom surfaces of the third trenches 44. That is, the sidewalls of the third trenches 44 may have a sloped profile. The third trenches 44 may function as source contact holes in which source electrodes 380 are formed in a subsequent process.

Referring to FIG. 62, a gate dielectric layer 372 may be formed in the second and third trenches 34 and 44 and on the upper nitride-based semiconductor layer 360. As illustrated in FIG. 62, the gate dielectric layer 372 may be formed to fill the third trenches 44, but the gate dielectric layer 372 may be conformably formed in the second trenches 34.

The gate dielectric layer 372 may be formed to include an oxide layer, a nitride layer or an oxynitride layer. The gate dielectric layer 372 may be formed using a CVD process, a sputtering process, an ALD process or an evaporation process.

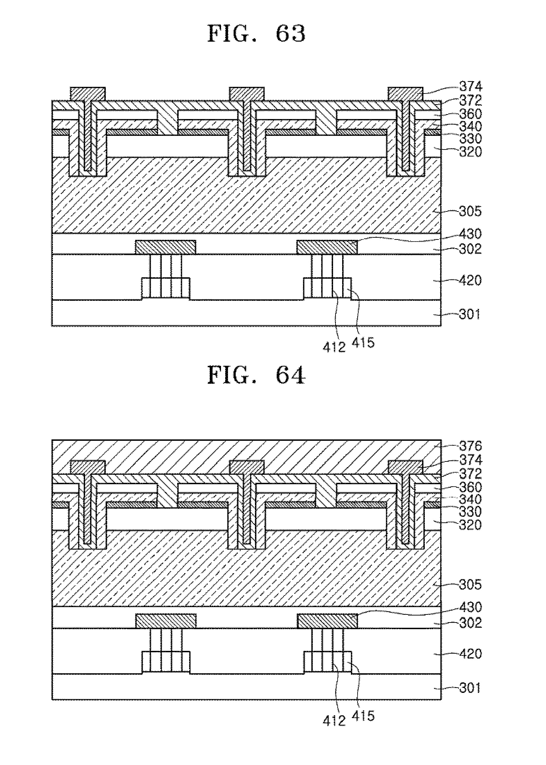

Referring to FIG. 63, a gate conductive layer may be formed on the gate dielectric layer 372 to fill the second trenches 34. The gate conductive layer may be patterned to form gate electrodes 374 covering the second trenches 34. The gate conductive layer may be formed to include a GaN layer doped with P-type dopants such as beryllium (Be) ions, magnesium (Mg) ions, calcium (Ca) ions, carbon (C) ions, iron (Fe) ions, manganese (Mn) ions, or mixed ions containing at least two different ions among the above-listed ions. Alternatively, gate conductive layer may be formed to include a metal layer such as a nickel (Ni) layer, a gold (Au) layer, a titanium (Ti) layer or an aluminum (Al) layer. The gate conductive layer may be formed using a CVD process, a sputtering process, an ALD process or an evaporation process.

Referring to FIG. 64, an interlayer insulation layer 376 may be formed on the gate dielectric layer 372 and the gate electrodes 374. The interlayer insulation layer 376 may be formed to include an oxide layer, a nitride layer or an oxynitride layer. The interlayer insulation layer 376 may be formed using a CVD process, a sputtering process, an ALD process or an evaporation process.

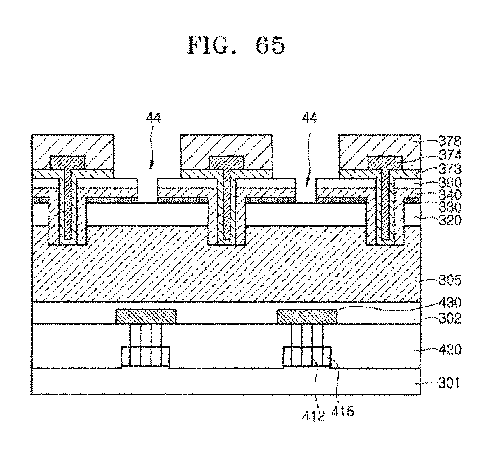

Referring to FIG. 65, the interlayer insulation layer 376 and the gate dielectric layer 372 may be patterned to form interlayer insulation patterns 378 and gate dielectric patterns 373. As a result of the etch process for forming the interlayer insulation patterns 378 and gate dielectric patterns 373, the gate dielectric layer 372 in the third trenches 44 may be removed to expose the sidewalls and bottom surfaces of the third trenches 44. That is, the interlayer insulation layer 376 and the gate dielectric layer 372 may be patterned to expose portions of the second nitride-based semiconductor patterns 320. The third trenches 44 may function as source contact holes in which source electrodes 380 are formed in a subsequent process.

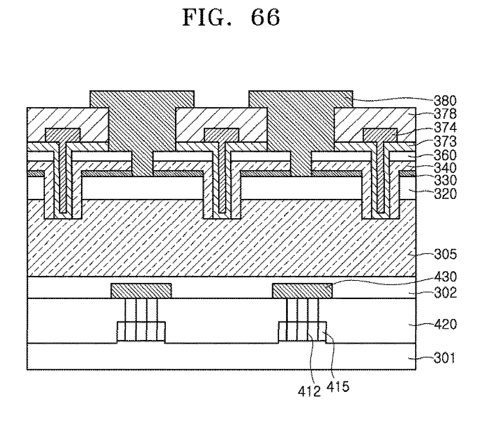

Referring to FIG. 66, source electrodes 380 may be formed in the source contact holes 44. The source electrodes 380 may be formed to extend into gap regions between the interlayer insulation patterns 378. The source electrodes 380 may be formed of a material exhibiting an ohmic contact with respect to the third nitride-based semiconductor patterns 330, the fourth nitride-based semiconductor layer 340 or the upper nitride-based semiconductor patterns 360. In some embodiments, the source electrodes 380 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. The source electrodes 380 may be formed using a CVD process, a sputtering process, an ALD process or an evaporation process.

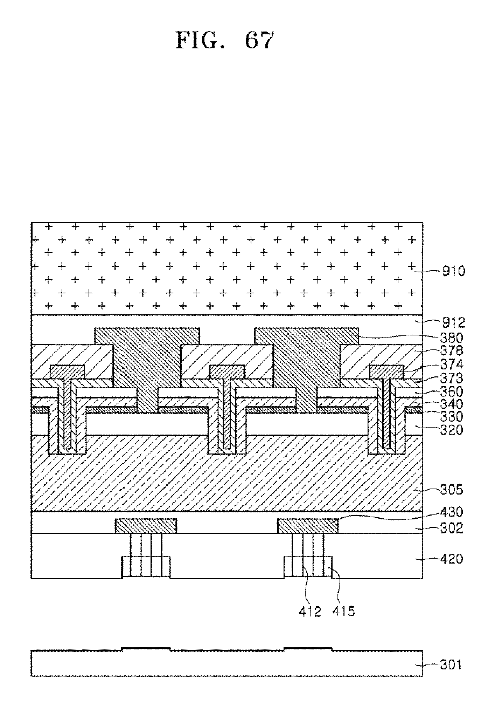

Referring to FIG. 67, a heat sink 910 may be formed on the source electrodes 380. The heat sink 910 may act as a heat radiator for emitting heat generated in a nitride-based transistor. Thus, the heat sink 910 may be formed to include a material having an excellent heat conductivity, for example, a metal material. The heat sink 910 may be attached to the source electrodes 380 using an adhesion member 912. The adhesion member 912 may include a solder material or a metal paste material having an excellent heat conductivity, but not limited thereto. For example, in some embodiments, the adhesion member 912 may include another adhesion member well known in the art.

Referring again to FIG. 67, the substrate 301 may be detached from the nitride seed patterns 415 and the nitride buffer layer 420. The substrate 301 may be detached from the nitride seed patterns 415 and the nitride buffer layer 420 using a laser lift-off process.

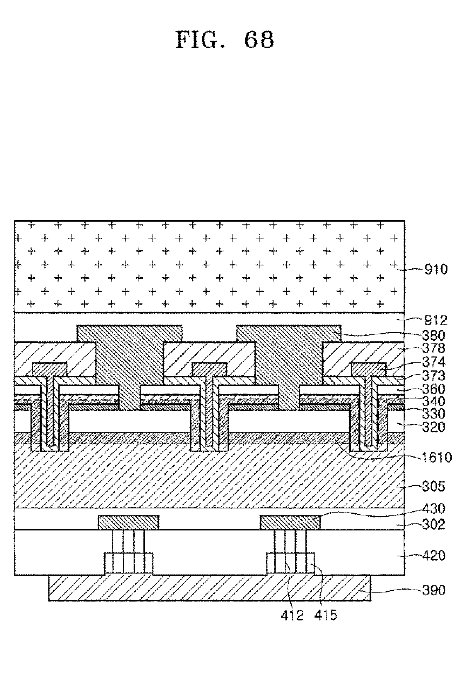

Referring to FIG. 68, a drain electrode 390 may be formed on the exposed surfaces of the nitride seed patterns 415 and the nitride buffer layer 420 opposite to the lower nitride-based semiconductor layer 302. The drain electrode 390 may be formed of a material exhibiting an ohmic contact with respect to the nitride buffer layer 420. In some embodiments, the drain electrode 390 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. The drain electrode 390 may be formed using a CVD process, a sputtering process, an ALD process or an evaporation process. A nitride-based transistor according to an embodiment may be fabricated through the aforementioned processes.

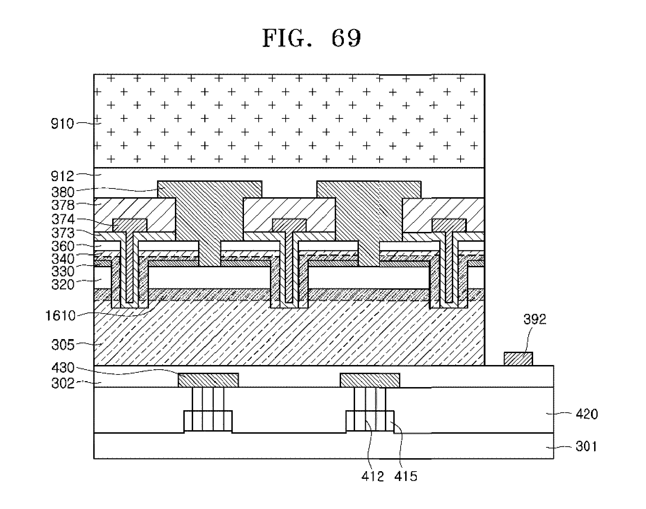

In some other embodiments, after the source electrodes 380 illustrated in FIG. 66 are formed, the first, second, third, fourth and upper nitride-based semiconductor layers 305, 320, 330, 340 and 360 may be patterned to expose a portion of the lower nitride-based semiconductor layer 302. Subsequently, a drain electrode 392 may be formed on the exposed portion of the lower nitride-based semiconductor layer 302. As a result, the nitride-based transistor illustrated in FIG. 69 can be fabricated. Even in this case, a heat sink may also be additionally formed on the source electrodes 380.

Hereinafter, a method of operating the nitride-based transistor illustrated in FIG. 68 will be described. First, the fourth nitride-based semiconductor layer 340 located between the second nitride-based semiconductor patterns 320 and the gate electrodes 374 may be fully depleted to form the depletion regions 1610 at an equilibrium state. Thus, even though an operating voltage is applied between the source electrodes 380 and the drain electrode 390 without a gate bias, no carriers may be drifted from the source electrodes 380 toward the drain electrode 390 because of the presence of the depletion regions 1610. If a gate voltage (e.g., a positive gate voltage) higher than a threshold voltage is applied to the gate electrodes 374, the width of the depletion regions 1610 may be reduced or the depletion regions 1610 may be removed. As a result, channel layers may be formed in the fourth nitride-based semiconductor layer 340 adjacent to sidewalls of the second trenches 34. In some embodiments, if the fourth nitride-based semiconductor layer 340 includes an N-type GaN layer and each of the second nitride-based semiconductor patterns 320 includes a P-type GaN layer, the channel layers, that is, N-type channel layers may be vertically formed in the fourth nitride-based semiconductor layer 340 adjacent to the sidewalls of the second trenches 34 because of the positive gate voltage applied to the gate electrodes 374. In such a case, electrons emitted from the source electrodes 380 may be drifted toward the drain electrode 390 through the third nitride-based semiconductor layer 330, the channel layers, the first nitride-based semiconductor layer 305, the lower nitride-based semiconductor layer 302, and the nitride buffer layer 420, According to the present embodiment, the channel layers controlled by the gate electrodes 374 may be formed in a vertical direction and may be formed in an N-type GaN layer to increase a mobility of carriers (i.e., electrons) drifted therein.

According to the fabrication method as set forth above, the mask patterns 430 having an amorphous structure are formed over the nitride seed patterns 415 including line-shaped dislocations 412. Thus, when the lower nitride-based semiconductor layer 302 and the first to fourth nitride-based semiconductor layers 305, 320, 330 and 340 are sequentially grown on the substrate 301, the mask patterns 430 may disturb that the line-shaped dislocations 412 are vertically grown into the lower nitride-based semiconductor layer 302 and the first to fourth nitride-based semiconductor layers 305, 320, 330 and 340. Accordingly, no leakage current flows from the drain electrode 390 toward the source electrodes 380 through the line-shaped dislocations 412 when the nitride-based transistor illustrated in FIG. 68 operates.

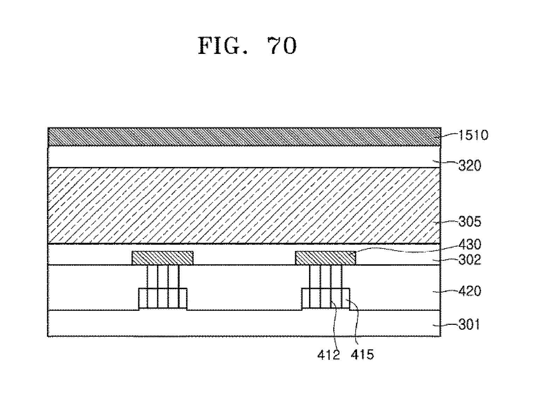

FIGS. 70 to 78 are cross-sectional views illustrating a method of fabricating a vertical nitride-based transistor according to another embodiment of the present disclosure. Referring to FIG. 70, nitride seed patterns 415 may be formed on a substrate 301. A nitride buffer layer 420 may then be formed on the nitride seed patterns 415 to fill gap regions between the nitride seed patterns 415. Subsequently, mask patterns 430 may be formed on the nitride buffer layer 420. The mask patterns 430 may be formed to overlap with the nitride seed patterns 415 when viewed from a plan view. A lower nitride-based semiconductor layer 302 heavily doped with dopants having a first type may be formed on the nitride buffer layer 420 to cover the mask patterns 430.

The nitride seed patterns 415, the nitride buffer layer 420, the mask patterns 430 and the lower nitride-based semiconductor layer 302 may be formed using the same methods as described with reference to FIGS. 53 to 57. As described with reference to FIGS. 53 to 57, a density of line-shaped dislocations 412 in the lower nitride-based semiconductor layer 302 may be remarkably lower than that of the line-shaped dislocations 412 in the nitride buffer layer 420.

Referring again to FIG. 70, a first nitride-based semiconductor layer 305 doped with dopants having the first type, a second nitride-based semiconductor layer 320 doped with dopants having a second type, and an upper nitride-based semiconductor layer 1510 heavily doped with dopants having the first type may be sequentially formed on the lower nitride-based semiconductor layer 302. In some embodiments, the lower nitride-based semiconductor layer 302 may be formed of a GaN layer heavily doped with N-type dopants, and the first nitride-based semiconductor layer 305 may be formed of a GaN layer lightly doped with N-type dopants. Moreover, the second nitride-based semiconductor layer 320 may be formed of a GaN layer doped with P-type dopants, and the upper nitride-based semiconductor layer 1510 may be formed of a GaN layer heavily doped with N-type dopants. The lower nitride-based semiconductor layer 302 and the upper nitride-based semiconductor layer 1510 may be doped to have an impurity concentration which is equal to or higher than about 1×10¹⁹ /cm³, and the first and second nitride-based semiconductor layers 305 and 320 may be doped to have an impurity concentration of about 1×10¹⁷ /cm³ to about 1×10¹⁹ /cm³.

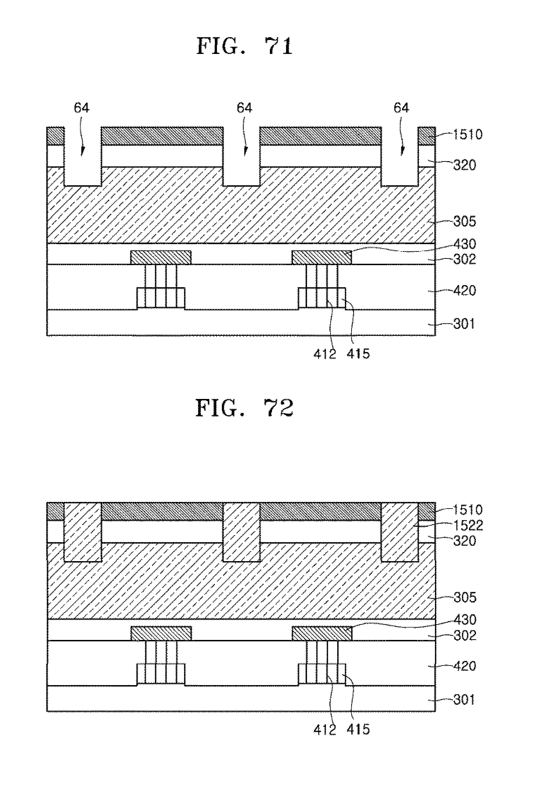

Referring to FIG. 71, first trenches 64 may be formed to penetrate the upper and second nitride-based semiconductor layers 1510 and 320 and to extend into the first nitride-based semiconductor layer 305. The first trenches 64 may be formed by etching the upper, second and first nitride-based semiconductor layers 1510, 320 and 305. Each of the first trenches 64 may be formed to include a bottom surface and sidewalls perpendicular to the bottom surface. Alternatively, each of the first trenches 64 may be formed to include a bottom surface and sidewalls non-perpendicular to the bottom surface. In such a case, the sidewalls of the first trenches 64 may be formed to have a sloped profile.

Referring to FIG. 72, third nitride-based semiconductor patterns 1520 doped with dopants having the first type may be formed in respective ones of the first trenches 64. Accordingly, the second nitride-based semiconductor patterns 320 may be surrounded by the first nitride-based semiconductor layer 305, the upper nitride-based semiconductor patterns 1510 and the third nitride-based semiconductor patterns 1520. As illustrated in FIG. 72, top surfaces of the third nitride-based semiconductor patterns 1520 may be coplanar with top surfaces of the upper nitride-based semiconductor patterns 1510.

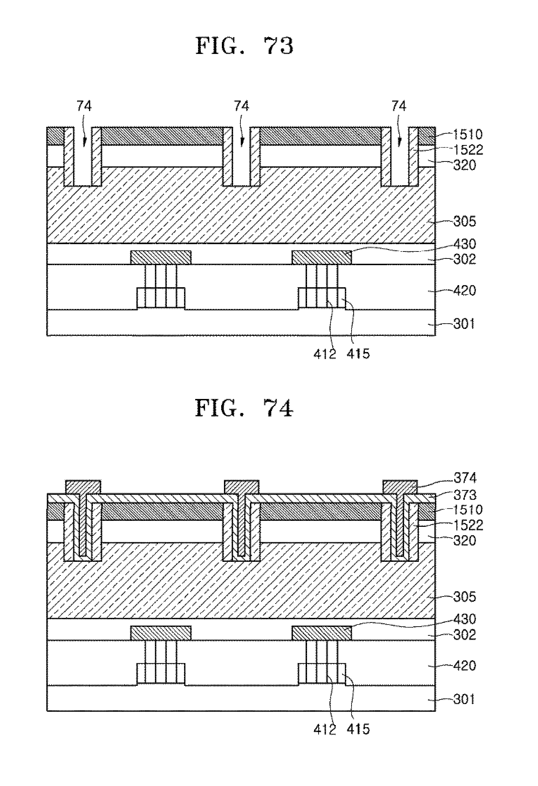

Referring to FIG. 73, the third nitride-based semiconductor patterns 1520 in the first trenches 64 may be patterned to form second trenches 74. The second trenches 74 may be formed in respective ones of the first trenches 64. More specifically, the second trenches 74 may be formed by etching the third nitride-based semiconductor patterns 1520 such that portions of the third nitride-based semiconductor patterns 1520 remain on the sidewalls of the first trenches 64 to have predetermined thicknesses T3 and T4. The remaining portions of the third nitride-based semiconductor patterns 1520 on the sidewalls of the first trenches 64 may act as channel body layers of the nitride-based transistor. Thus, thicknesses T3 and T4 (i.e., widths in a horizontal direction) of the remaining portions of the third nitride-based semiconductor layer 1520 on the sidewalls of the first trenches 64 may be determined in consideration of a width of depletion regions which are formed between the second nitride-based semiconductor patterns 320 and gate electrodes to be formed in the second trenches 74.

Referring to FIG. 74, a gate dielectric layer 372 may be formed in the second trenches 74 and on the upper nitride-based semiconductor patterns 1510. As illustrated in FIG. 20, the gate dielectric layer 372 may be conformably formed in the second trenches 74. Subsequently, a gate conductive layer may be formed on the gate dielectric layer 372 to fill the second trenches 74, and the gate conductive layer may be patterned to form gate electrodes 374 covering the second trenches 74.

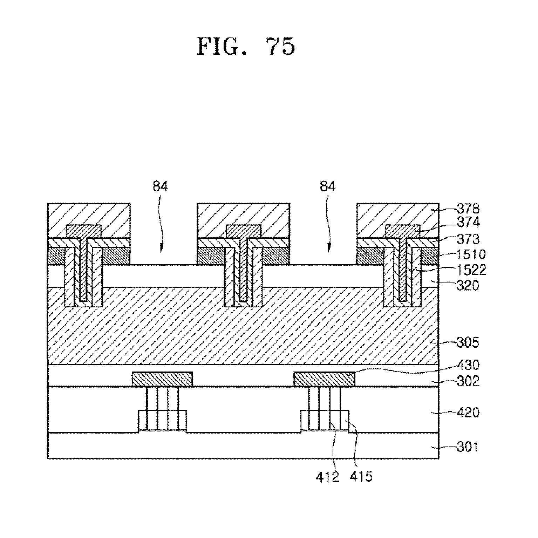

Referring to FIG. 75, an insulation layer may be formed on the gate dielectric layer 372 and the gate electrodes 374. The insulation layer, the gate dielectric layer 372 and the upper nitride-based semiconductor patterns 1510 may be patterned to form insulation patterns 378 and gate dielectric patterns 373. As a result of the etch process for forming the insulation patterns 378 and gate dielectric patterns 373, third trenches 84 may be formed to expose portions of the second nitride-based semiconductor patterns 320. The third trenches 84 may function as source contact holes in which source electrodes 380 are formed in a subsequent process.

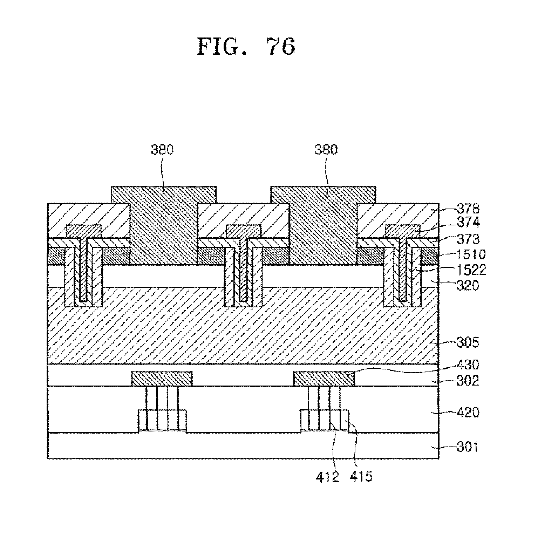

Referring to FIG. 76, source electrodes 380 may be formed in the source contact holes 84. The source electrodes 380 may be formed to extend into gap regions between the insulation patterns 378. The source electrodes 380 may be formed of a material exhibiting an ohmic contact with respect to the upper nitride-based semiconductor patterns 1510.

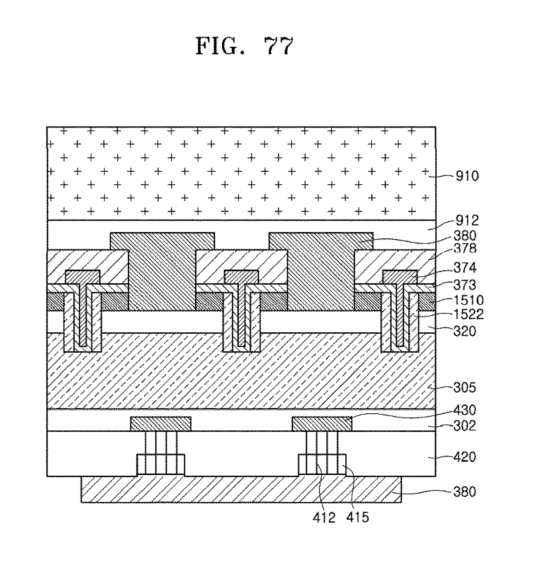

Referring to FIG. 77, a heat sink 910 may be attached to the source electrodes 380 using an adhesion member 912. The substrate 301 may be detached from the nitride seed patterns 415 and the nitride buffer layer 420. The substrate 301 may be detached from the nitride seed patterns 415 and the nitride buffer layer 420 using a laser lift-off process. A drain electrode 390 may be formed on the exposed surfaces of the nitride seed patterns 415 and the nitride buffer layer 420 opposite to the lower nitride-based semiconductor layer 302. The drain electrode 390 may be formed of a material exhibiting an ohmic contact with respect to the nitride buffer layer 420. In some embodiments, the drain electrode 390 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof.

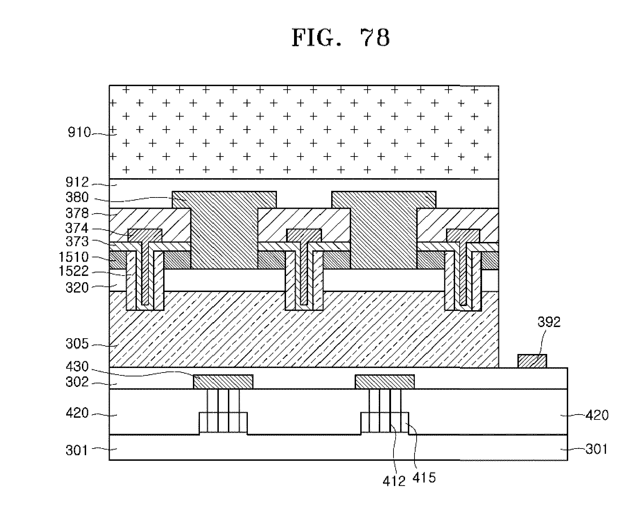

In some other embodiments, after the source electrodes 380 illustrated in FIG. 76 are formed, the first, second and upper nitride-based semiconductor layers 305, 320 and 1510 may be patterned to expose a portion of the lower nitride-based semiconductor layer 302, as illustrated in FIG. 78. Subsequently, a drain electrode 392 may be formed on the exposed portion of the lower nitride-based semiconductor layer 302. Even in this case, a heat sink may also be additionally formed on the source electrodes 380.

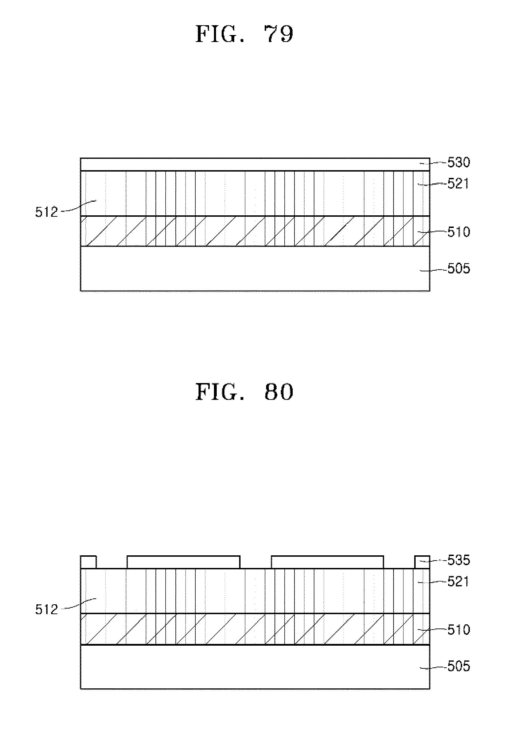

FIGS. 79 to 93 are cross-sectional views illustrating a method of fabricating a vertical nitride-based transistor according to yet another embodiment of the present disclosure. In the following embodiment, a nitride-based semiconductor layer may include a nitride material such as an AlₓIn_{y}Ga_{1-x-y}N (where, 0≤x≤1 and 0≤y≤1) layer. In some embodiments, the nitride-based semiconductor layer may be formed using an MOCVD process, an MBE process, or a hydride vapor phase epitaxy process.

Referring to FIG. 79, a lower nitride-based semiconductor layer 510 heavily doped with dopants having a first type and a first nitride-based semiconductor layer 521 doped with dopants having the first type may be sequentially formed on a substrate 505. The substrate 505 may be one selected from the group consisting of a silicon substrate, a sapphire substrate, a SiC substrate, and an AlN substrate. However, the substrate 505 is not limited to the above-listed substrates. For example, any substrate on which a nitride-based layer can be grown may be used as the substrate 505.

The first type means a conductivity type such as an N-type or a P-type. In some embodiments, the dopants having an N-type may include silicon ions, and the dopants having a P-type may include beryllium (Be) ions, magnesium (Mg) ions, calcium (Ca) ions, carbon (C) ions, iron (Fe) ions and manganese (Mn) ions. The N-type dopants or the P-type dopants may be injected into nitride-based semiconductor layers during growth of the nitride-based semiconductor layers. That is, the lower nitride-based semiconductor layer 510 and first nitride-based semiconductor layer 521 may be formed using an in-situ doping process. In some embodiments, the lower nitride-based semiconductor layer 510 may be formed of a GaN layer heavily doped with N-type dopants, and the first nitride-based semiconductor layer 521 may be formed of a GaN layer lightly doped with N-type dopants.

While the lower nitride-based semiconductor layer 510 is grown on the substrate 505 using an epitaxial growth process, line-shaped dislocations 512 (also, referred to as vertical threading dislocations) may be formed in the lower nitride-based semiconductor layer 510 due to a lattice constant difference between the substrate 505 and the lower nitride-based semiconductor layer 510. The line-shaped dislocations 512 may be formed in a vertical direction which is orthogonal to a surface of the substrate 505. Moreover, while the first nitride-based semiconductor layer 521 may be grown on the lower nitride-based semiconductor layer 510 using an epitaxial growth process, the line-shaped dislocations 512 in the lower nitride-based semiconductor layer 510 may extend into the first nitride-based semiconductor layer 521. This is because the epitaxial layers are grown to have the same crystalline structure as the underlying layer.

Referring again to FIG. 79, a mask layer 530 may be formed on the first nitride-based semiconductor layer 521. The mask layer 530 may be formed to include an oxide layer, a nitride layer, an oxynitride layer, or a combination including at least two thereof. For example, the mask layer 530 may be formed of a silicon oxide layer, a silicon nitride layer, a silicon oxynitride layer or a combination thereof. The mask layer 530 may be formed to have an amorphous structure using a CVD process, an evaporation process or a coating process. Moreover, the mask layer 530 may be formed of a material having a composition and a lattice structure which are different from those of the first nitride-based semiconductor layer 521. Thus, the line-shaped dislocations 512 in the first nitride-based semiconductor layer 521 are not grown into the mask layer 530.

Referring to FIG. 80, the mask layer 530 may be patterned to form mask patterns 535 exposing portions of the first nitride-based semiconductor layer 521. The mask patterns 535 may be formed by anisotropically or isotropically etching the mask layer 530 with an etch mask (not shown).

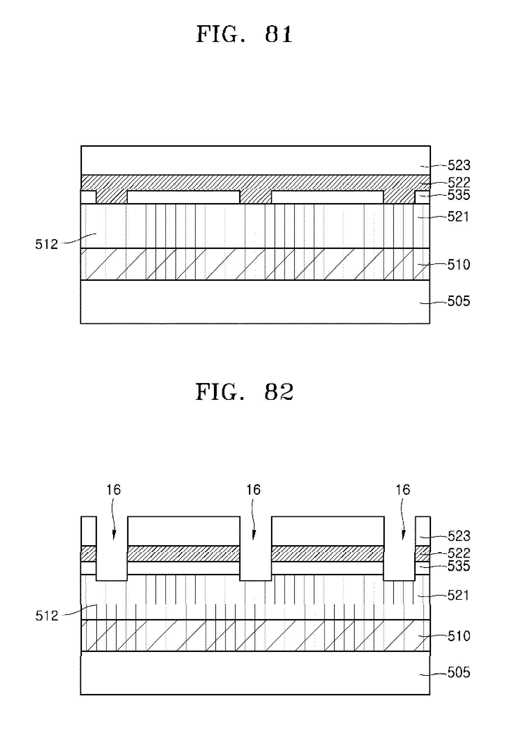

Referring to FIG. 81, a second nitride-based semiconductor layer 522 doped with dopants having a second type may be grown on the exposed portions of the first nitride-based semiconductor layer 521 to cover the mask patterns 535. Subsequently, a third nitride-based semiconductor layer 523 doped with dopants having the first type may be grown on the second nitride-based semiconductor layer 522.

The first, second and third nitride-based semiconductor layers 521, 522 and 523 may be formed of the same material layer except for the conductivity type. If the first type is an N-type, the second type may be a P-type. On the contrary, if the first type is a P-type, the second type may be an N-type. Silicon (Si) ions may be used as N-type dopants, and beryllium (Be) ions, magnesium (Mg) ions, calcium (Ca) ions, carbon (C) ions, iron (Fe) ions, or manganese (Mn) ions may be used as P-type dopants.

In some embodiments, the lower nitride-based semiconductor layer 510 may be formed of a GaN layer heavily doped with N-type dopants, and the first nitride-based semiconductor layer 521 may be formed of a GaN layer doped with N-type dopants. In addition, the second nitride-based semiconductor layer 522 may be formed of a GaN layer doped with P-type dopants, and the third nitride-based semiconductor layer 523 may be formed of a GaN layer doped with N-type dopants.

The second nitride-based semiconductor layer 522 may be vertically and laterally grown on the first nitride-based semiconductor layer 521 using an epitaxial growth process. During the epitaxial growth process, P-type dopants may be injected into the second nitride-based semiconductor layer 522.

While the second nitride-based semiconductor layer 522 is grown on the first nitride-based semiconductor layer 521, the line-shaped dislocations 512 in the first nitride-based semiconductor layer 521 may also be grown to extend into the second nitride-based semiconductor layer 522. However, in such a case, a density of the line-shaped dislocations 512 in the second nitride-based semiconductor layer 522 may be remarkably lower than that of the line-shaped dislocations 512 in the first nitride-based semiconductor layer 521. This is because the second nitride-based semiconductor layer 522 on the top surfaces of the mask patterns 535 is not directly grown from the first nitride-based semiconductor layer 521 but indirectly and laterally grown from the first nitride-based semiconductor layer 521. That is, the mask patterns 535 may function as blocking masks that disturb vertical growth of the line-shaped dislocations 512 under the mask patterns 535. Accordingly, a density of the line-shaped dislocations 512 in the second nitride-based semiconductor layer 522 may be remarkably lower than that of the line-shaped dislocations 512 in the first nitride-based semiconductor layer 521, as described above.

Because the density of the line-shaped dislocations 512 in the second nitride-based semiconductor layer 522 is remarkably lower than that of the line-shaped dislocations 512 in the first nitride-based semiconductor layer 521, the third nitride-based semiconductor layer 523 epitaxially grown on the second nitride-based semiconductor layer 522 may also have a line-shaped dislocation density which is remarkably lower than that of the first nitride-based semiconductor layer 521.

Referring to FIG. 82, first trenches 16 may be formed to penetrate the third and second nitride-based semiconductor layers 523 and 522 and to extend into the first nitride-based semiconductor layer 521. The first trenches 16 may be formed by etching the third and second nitride-based semiconductor layers 523 and 522, the mask patterns 535, and the first nitride-based semiconductor layer 521. Alternatively, the first trenches 16 may be formed by etching the third, second and first nitride-based semiconductor layers 523, 522 and 521 using an etch recipe exhibiting an etch selectivity with respect to the mask patterns 535. In such a case, the first trenches 16 may be self-aligned with the mask patterns 535 to penetrate regions between the mask patterns 535. Each of the first trenches 16 may be formed to include a bottom surface and sidewalls perpendicular to the bottom surface. Alternatively, each of the first trenches 16 may be formed to include a bottom surface and sidewalls non-perpendicular to the bottom surface. In such a case, the sidewalls of the first trenches 16 may have a sloped profile. A tilt angle of the sloped sidewalls of the first trenches 16 to the bottom surfaces of the first trenches 16 may be different according to the etch process for forming the first trenches 16. In addition, the tilt angle of the sloped sidewalls of the first trenches 16 to the bottom surfaces of the first trenches 16 may be within a range of about 30 degrees to about 90 degrees according to lattice planes of the first, second and third nitride-based semiconductor layers 521, 522 and 523 (e.g., GaN layers). In some embodiments, the tilt angle of the sloped sidewalls of the first trenches 16 to the bottom surfaces of the first trenches 16 may be within a range of about 60 degrees to about 70 degrees when the first trenches 16 are formed using a dry etch process or a wet etch process.

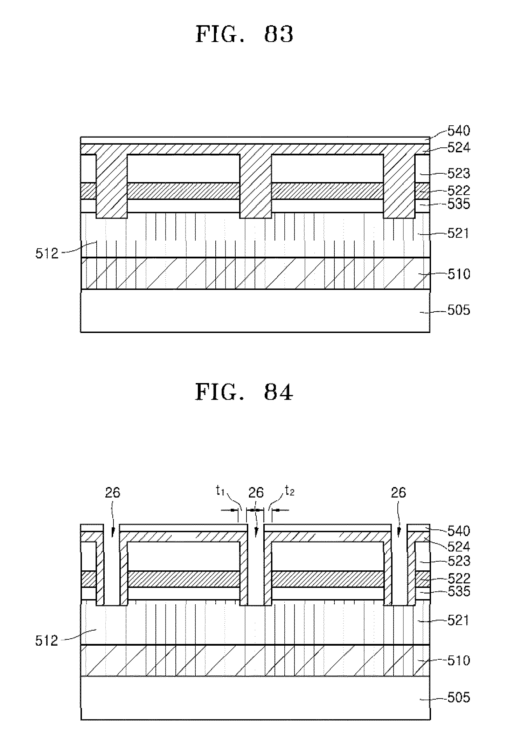

Referring to FIG. 83, a fourth nitride-based semiconductor layer 524 doped with dopants having the first type may be formed on the third nitride-based semiconductor layer 523 to fill the first trenches 16. Subsequently, an upper nitride-based semiconductor layer 540 heavily doped with dopants having the first type may be formed on the fourth nitride-based semiconductor layer 524. In some embodiments, the fourth nitride-based semiconductor layer 524 may be formed of an N-type GaN layer having an impurity concentration of about 1×10¹⁷ /cm³ to about 1×10¹⁹ /cm³, and the upper nitride-based semiconductor layer 540 may be formed of an N-type GaN layer having an impurity concentration which is equal to or higher than 1×10¹⁹ /cm³. The second nitride-based semiconductor patterns 522 may be surrounded by the third nitride-based semiconductor patterns 523, the fourth nitride-based semiconductor layer 524 and the mask patterns 535.

Referring to FIG. 84, the upper nitride-based semiconductor layer 540 and the fourth nitride-based semiconductor layer 524 may be patterned to form second trenches 26. The second trenches 26 may be formed in respective ones of the first trenches 16.

More specifically, the second trenches 26 may be formed by etching the upper nitride-based semiconductor layer 540 and the fourth nitride-based semiconductor layer 524 such that portions of the fourth nitride-based semiconductor layer 524 remain on the sidewalls of the first trenches 16 to have predetermined thicknesses T1 and T2. The remaining portions of the fourth nitride-based semiconductor layer 524 on the sidewalls of the first trenches 16 may act as channel body layers of the nitride-based transistor. Thus, the thicknesses T1 and T2 (i.e., widths in a horizontal direction) of the remaining portions of the fourth nitride-based semiconductor layer 524 on the sidewalls of the first trenches 16 may be determined in consideration of a width of depletion regions which are formed between the second nitride-based semiconductor patterns 522 and gate electrodes to be formed in the second trenches 26. Although FIG. 84 illustrates an example in which bottom surfaces of the second trenches 26 are coplanar with bottom surfaces of the first trenches 16, the inventive concept is not limited thereto. For example, the second trenches 26 may be formed such that a level of the bottom surfaces of the second trenches 26 is lower or higher than a level of the bottom surfaces of the first trenches 16.

The second trenches 26 may be formed such that the sidewalls of the second trenches 26 are perpendicular to the bottom surfaces of the second trenches 26. Alternatively, the second trenches 26 may be formed such that the sidewalls of the second trenches 26 are non-perpendicular to the bottom surfaces of the second trenches 26. In such a case, the sidewalls of the second trenches 26 may have a sloped profile. A tilt angle of the sloped sidewalls of the second trenches 26 to the bottom surfaces of the second trenches 26 may be different according to the etch process for forming the second trenches 26. In addition, the tilt angle of the sloped sidewalls of the second trenches 26 to the bottom surfaces of the second trenches 26 may be within a range of about 30 degrees to about 90 degrees according to lattice planes of the fourth and upper nitride-based semiconductor layers 524 and 540 (e.g., GaN layers). In some embodiments, the tilt angle of the sloped sidewalls of the second trenches 26 to the bottom surfaces of the second trenches 26 may be within a range of about 60 degrees to about 70 degrees when the second trenches 26 are formed using a dry etch process or a wet etch process.

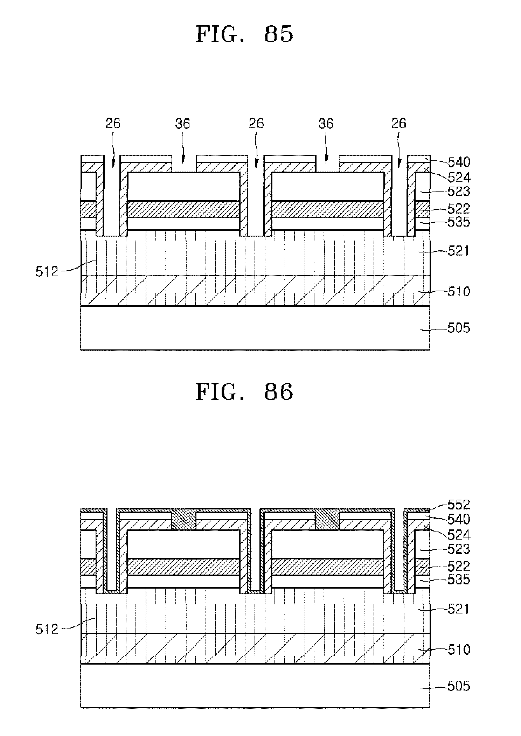

Referring to FIG. 85, the upper nitride-based semiconductor layer 540 and the fourth nitride-based semiconductor layer 524 may be patterned to form third trenches 36 that are disposed between the second trenches 26 to expose portions of the third nitride-based semiconductor patterns 523. The third trenches 36 may be formed such that sidewalls of the third trenches 36 are perpendicular to bottom surfaces of the third trenches 36. Alternatively, the third trenches 36 may be formed such that the sidewalls of the third trenches 36 are non-perpendicular to the bottom surfaces of the third trenches 36. That is, the sidewalls of the third trenches 36 may have a sloped profile. The third trenches 36 may function as source contact holes in which source electrodes 570 are formed in a subsequent process.

Referring to FIG. 86, a gate dielectric layer 552 may be formed in the second and third trenches 26 and 36 and on the upper nitride-based semiconductor layer 540. As illustrated in FIG. 86, the gate dielectric layer 552 may be formed to fill the third trenches 36, but the gate dielectric layer 552 may be conformably formed in the second trenches 26.

The gate dielectric layer 552 may be formed to include an oxide layer, a nitride layer or an oxynitride layer. The gate dielectric layer 552 may be formed using a CVD process, a sputtering process, an ALD process or an evaporation process.

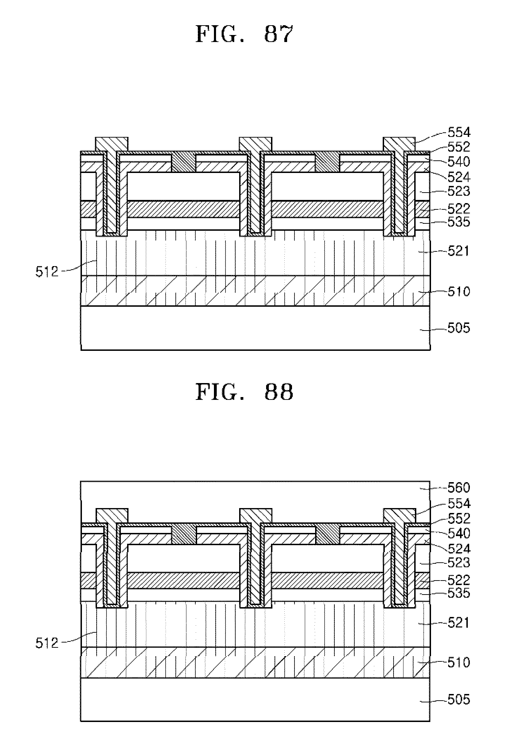

Referring to FIG. 87, a gate conductive layer may be formed on the gate dielectric layer 552 to fill the second trenches 26. The gate conductive layer may be patterned to form gate electrodes 554 covering the second trenches 26. The gate conductive layer may be formed to include a GaN layer doped with P-type dopants such as beryllium (Be) ions, magnesium (Mg) ions, calcium (Ca) ions, carbon (C) ions, iron (Fe) ions, manganese (Mn) ions, or mixed ions containing at least two different ions among the above-listed ions. Alternatively, gate conductive layer may be formed to include a metal layer such as a nickel (Ni) layer, a gold (Au) layer, a titanium (Ti) layer or an aluminum (Al) layer. The gate conductive layer may be formed using a CVD process, a sputtering process, an ALD process or an evaporation process.

Referring to FIG. 88, an interlayer insulation layer 560 may be formed on the gate dielectric layer 552 and the gate electrodes 554. The interlayer insulation layer 560 may be formed to include an oxide layer, a nitride layer or an oxynitride layer. The interlayer insulation layer 560 may be formed using a CVD process, a sputtering process, an ALD process or an evaporation process.

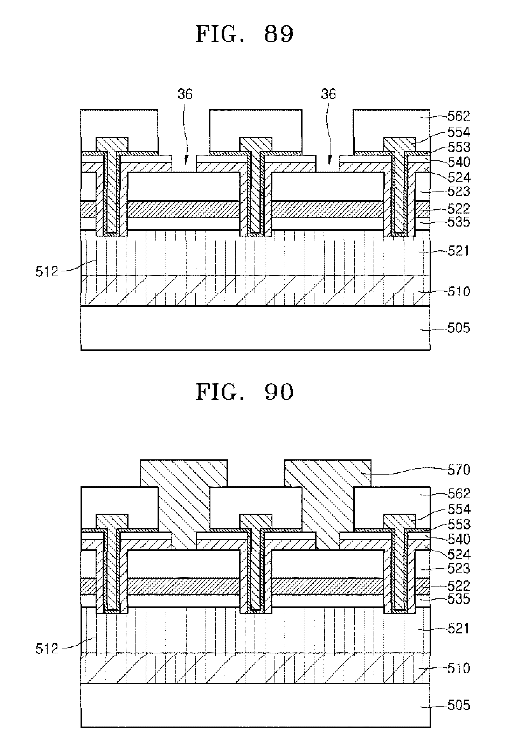

Referring to FIG. 89, the interlayer insulation layer 560 and the gate dielectric layer 552 may be patterned to form interlayer insulation patterns 562 and gate dielectric patterns 553. As a result of the etch process for forming the interlayer insulation patterns 562 and gate dielectric patterns 553, the gate dielectric layer 552 in the third trenches 36 may be removed to expose the sidewalls and bottom surfaces of the third trenches 36. That is, the interlayer insulation layer 560 and the gate dielectric layer 552 may be patterned to expose portions of the third nitride-based semiconductor patterns 523. The third trenches 36 may function as source contact holes in which source electrodes 570 are formed in a subsequent process.

Referring to FIG. 90, source electrodes 570 may be formed in the source contact holes 44. The source electrodes 570 may be formed to extend into gap regions between the interlayer insulation patterns 562. The source electrodes 570 may be formed of a material exhibiting an ohmic contact with respect to the third nitride-based semiconductor patterns 523, the fourth nitride-based semiconductor layer 524 or the upper nitride-based semiconductor patterns 540. In some embodiments, the source electrodes 570 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. The source electrodes 380 may be formed using a CVD process, a sputtering process, an ALD process or an evaporation process.

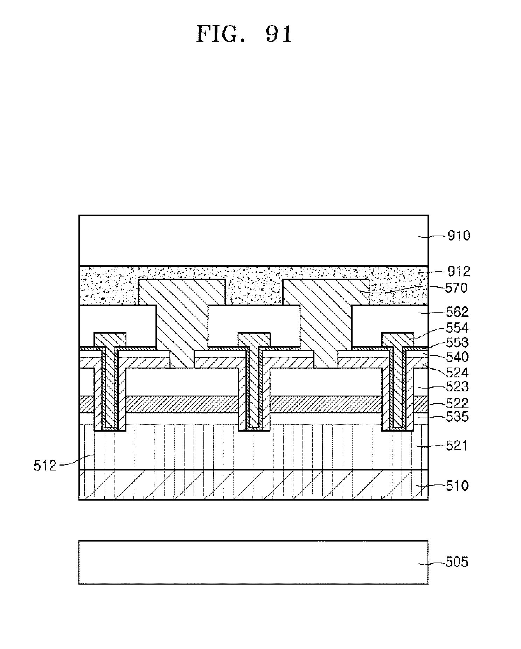

Referring to FIG. 91, a heat sink 910 may be formed on the source electrodes 570. The heat sink 910 may act as a heat radiator for emitting heat generated in a nitride-based transistor. Thus, the heat sink 910 may be formed to include a material having an excellent heat conductivity, for example, a metal material. The heat sink 910 may be attached to the source electrodes 570 using an adhesion member 912. The adhesion member 912 may include a solder material or a metal paste material having an excellent heat conductivity, but not limited thereto. For example, in some embodiments, the adhesion member 912 may include another adhesion member well known in the art.

Referring again to FIG. 91, the substrate 505 may be detached from the lower nitride-based semiconductor layer 510. The substrate 505 may be detached from the lower nitride-based semiconductor layer 510 using a laser lift-off process.

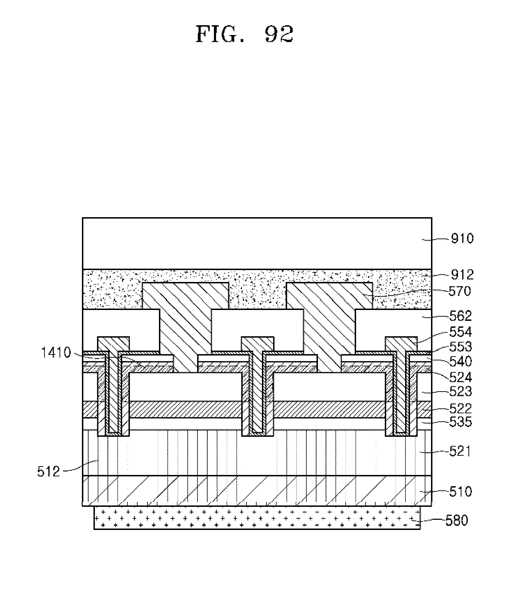

Referring to FIG. 92, a drain electrode 580 may be formed on the exposed surface of the lower nitride-based semiconductor layer 510 opposite to the first nitride-based semiconductor layer 521. The drain electrode 580 may be formed of a material exhibiting an ohmic contact with respect to the lower nitride-based semiconductor layer 510. In some embodiments, the drain electrode 580 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof. The drain electrode 580 may be formed using a CVD process, a sputtering process, an ALD process or an evaporation process. A nitride-based transistor according to an embodiment may be fabricated through the aforementioned processes.

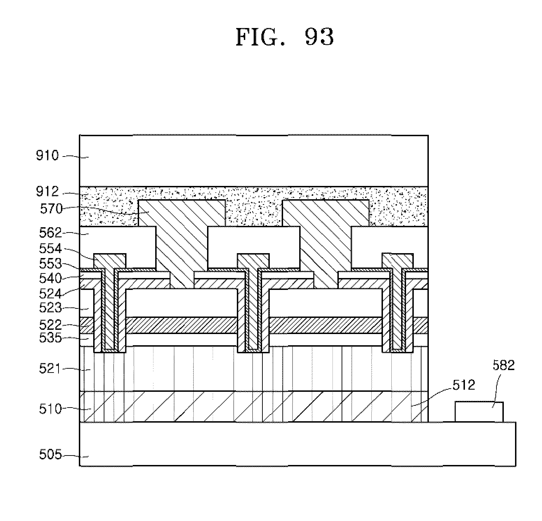

In some other embodiments, after the source electrodes 570 illustrated in FIG. 90 are formed, the first, second, third, fourth and upper nitride-based semiconductor layers 521, 522, 523, 524 and 540 and the mask patterns 535 may be patterned to expose a portion of the lower nitride-based semiconductor layer 510. Subsequently, a drain electrode 582 may be formed on the exposed portion of the lower nitride-based semiconductor layer 510. As a result, a nitride-based transistor illustrated in FIG. 93 can be fabricated. Even in this case, the heat sink 910 may also be additionally formed on the source electrodes 570.

Hereinafter, a method of operating the nitride-based transistor illustrated in FIG. 92 will be described. First, the fourth nitride-based semiconductor layer 524 located between the second nitride-based semiconductor patterns 522 and the gate electrodes 554 may be fully depleted to from depletion regions (not shown) at an equilibrium state. Thus, even though an operating voltage is applied between the source electrodes 570 and the drain electrode 580 without a gate bias, no carriers may be drifted from the source electrodes 570 toward the drain electrode 580 because of the presence of the depletion regions. If a gate voltage (e.g., a positive gate voltage) higher than a threshold voltage is applied to the gate electrodes 554, the width of the depletion regions may be reduced or the depletion regions may be removed. As a result, channel layers may be formed in the fourth nitride-based semiconductor layer 524 adjacent to sidewalls of the second trenches 26. In some embodiments, if the fourth nitride-based semiconductor layer 524 includes an N-type GaN layer and each of the second nitride-based semiconductor patterns 522 includes a P-type GaN layer, the channel layers, that is, N-type channel layers may be vertically formed in the fourth nitride-based semiconductor layer 524 adjacent to the sidewalls of the second trenches 26 because of the positive gate voltage applied to the gate electrodes 554. In such a case, electrons emitted from the source electrodes 570 may be drifted toward the drain electrode 580 through the upper nitride-based semiconductor layer 540, the channel layers, the first nitride-based semiconductor layer 521 and the lower nitride-based semiconductor layer 510. According to the present embodiment, the channel layers controlled by the gate electrodes 554 may be formed in a vertical direction and may be formed in an N-type GaN layer to increase a mobility of carriers (i.e., electrons) drifted therein.

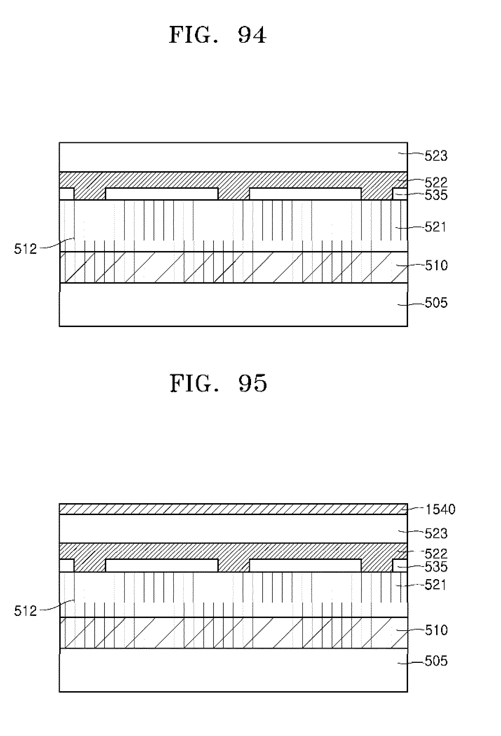

FIGS. 94 to 104 are cross-sectional views illustrating a method of fabricating a vertical nitride-based transistor according to still another embodiment of the present disclosure. Referring to FIG. 94, lower, first, second and third nitride-based semiconductor layers 510, 521, 522 and 523 and mask patterns 535 may be formed on a substrate 505 using the same manners as described with respect to FIGS. 79, 80 and 81. That is, the lower, first, second and third nitride-based semiconductor layers 510, 521, 522 and 523 may be stacked on the substrate 505 and the second nitride-based semiconductor layer 522 may be epitaxially grown from the first nitride-based semiconductor layer 521 to cover the mask patterns 535.

Referring to FIG. 95, an upper nitride-based semiconductor layer 1540 heavily doped with dopants having a first type may be formed on the third nitride-based semiconductor layer 523. In some embodiments, the lower nitride-based semiconductor layer 510 may be formed of a GaN layer heavily doped with N-type dopants, and the first nitride-based semiconductor layer 521 may be formed of a GaN layer doped with N-type dopants. In addition, the second nitride-based semiconductor layer 522 may be formed of a GaN layer doped with P-type dopants, and the third nitride-based semiconductor layer 523 may be formed of a GaN layer doped with N-type dopants. Moreover, the upper nitride-based semiconductor layer 1540 may be formed of a GaN layer heavily doped with N-type dopants.

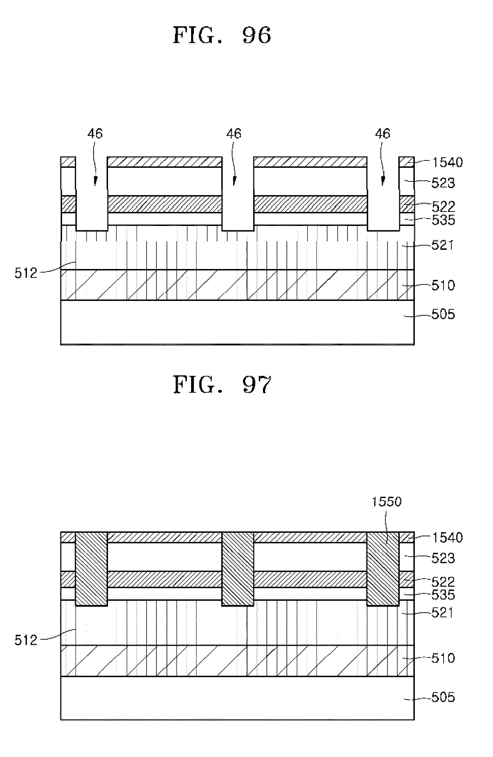

Referring to FIG. 96, first trenches 46 may be formed to penetrate the upper, third and second nitride-based semiconductor layers 1540, 523 and 522 as well as the mask patterns 535 and to extend into the first nitride-based semiconductor layer 521. That is, the first trenches 46 may be formed by etching the upper, third and second nitride-based semiconductor layers 1540, 523 and 522, the mask patterns 535, and the first nitride-based semiconductor layer 521 with a mask (not shown). Each of the first trenches 46 may be formed to have a bottom surface and sidewalls perpendicular to the bottom surface. Alternatively, each of the first trenches 46 may be formed to have a bottom surface and sidewalls non-perpendicular to the bottom surface. In such a case, the sidewalls of the first trenches 46 may have a sloped profile. A tilt angle of the sloped sidewalls of the first trenches 46 to the bottom surfaces of the first trenches 46 may be different according to the etch process for forming the first trenches 46. In addition, the tilt angle of the sloped sidewalls of the first trenches 46 to the bottom surfaces of the first trenches 46 may be within a range of about 30 degrees to about 90 degrees according to lattice planes of the second, third and upper nitride-based semiconductor layers 522, 523 and 1540 (e.g., GaN layers). In some embodiments, the tilt angle of the sloped sidewalls of the first trenches 46 to the bottom surfaces of the first trenches 46 may be within a range of about 60 degrees to about 70 degrees when the first trenches 46 are formed using a dry etch process or a wet etch process.

Referring to FIG. 97, fourth nitride-based semiconductor patterns 1550 may be formed in respective ones of the first trenches 46. The fourth nitride-based semiconductor patterns 1550 may be formed using a planarization process such that top surfaces of the fourth nitride-based semiconductor patterns 1550 are coplanar with a top surface of the upper nitride-based semiconductor layer 1540. As such, the third nitride-based semiconductor patterns 523 may be surrounded by the second nitride-based semiconductor patterns 522, the upper nitride-based semiconductor patterns 1540 and the fourth nitride-based semiconductor patterns 1550.

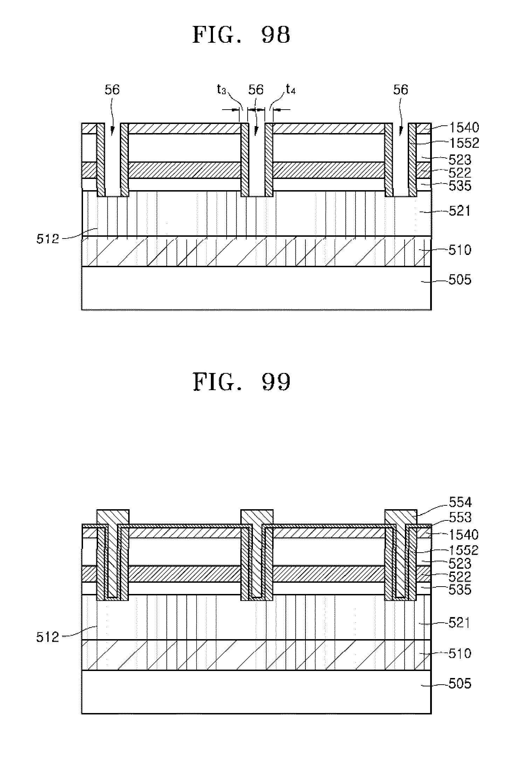

Referring to FIG. 98, the fourth nitride-based semiconductor patterns 1550 may be patterned to form second trenches 56. The second trenches 56 may be formed in respective ones of the first trenches 46. The second trenches 56 may be formed by etching the fourth nitride-based semiconductor patterns 1550 such that portions 1552 of the fourth nitride-based semiconductor patterns 1550 remain on the sidewalls of the first trenches 46 to have predetermined thicknesses T3 and T4. The remaining portions 1552 of the fourth nitride-based semiconductor patterns 1550 on the sidewalls of the first trenches 46 may act as channel body layers of the nitride-based transistor. Thus, the thicknesses T3 and T4 (i.e., widths in a horizontal direction) of the remaining portions 1552 of the fourth nitride-based semiconductor patterns 1550 on the sidewalls of the first trenches 46 may be determined in consideration of a width of depletion regions which are formed between the remaining second nitride-based semiconductor patterns 1552 and gate electrodes to be formed in the second trenches 56. Although FIG. 98 illustrates an example in which bottom surfaces of the second trenches 56 are coplanar with bottom surfaces of the first trenches 46, the inventive concept is not limited thereto. For example, the second trenches 56 may be formed such that a level of the bottom surfaces of the second trenches 56 is lower or higher than a level of the bottom surfaces of the first trenches 46.

Referring to FIG. 99, a gate dielectric layer 552 may be formed in the second trenches 56 and on the upper nitride-based semiconductor layer 1540. The gate dielectric layer 552 may be conformably formed in the second trenches 56.

Subsequently, a gate conductive layer may be formed on the gate dielectric layer 552 to fill the second trenches 56, and the gate conductive layer may be patterned to form gate electrodes 554 covering the second trenches 56.

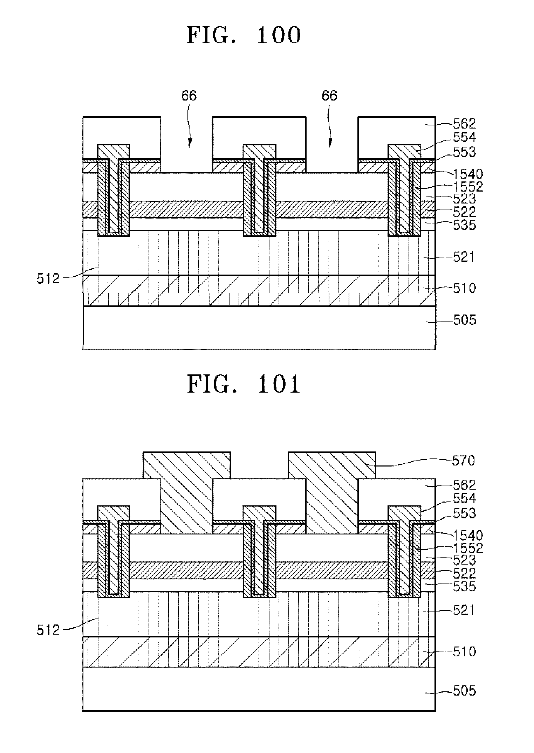

Referring to FIG. 100, an insulation layer may be formed on the gate dielectric layer 552 and the gate electrodes 554. Subsequently, the insulation layer, the gate dielectric layer 552 and the upper nitride-based semiconductor layer 1540 may be patterned to form third trenches 66 exposing portions of the third nitride-based semiconductor patterns 523. As a result of the formation of the third trenches 66, insulation patterns 562 and gate dielectric patterns 553 are formed. The third trenches 66 may function as source contact holes in which source electrodes 570 are formed in a subsequent process.

Referring to FIG. 101, source electrodes 570 may be formed in the source contact holes 66. The source electrodes 570 may be formed of a material exhibiting an ohmic contact with respect to the upper nitride-based semiconductor patterns 1540.

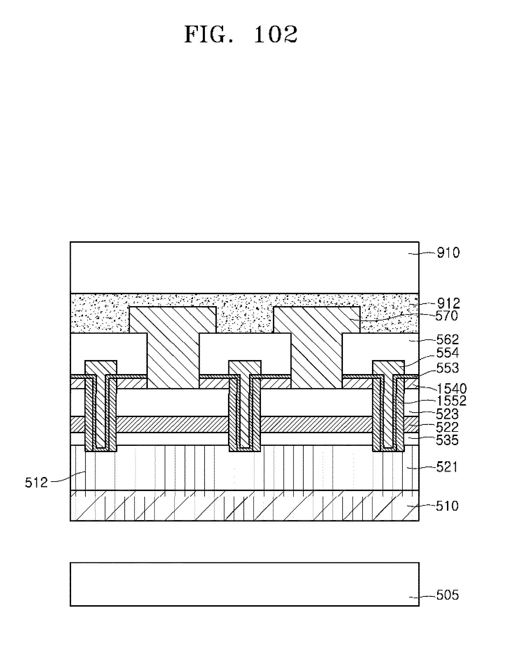

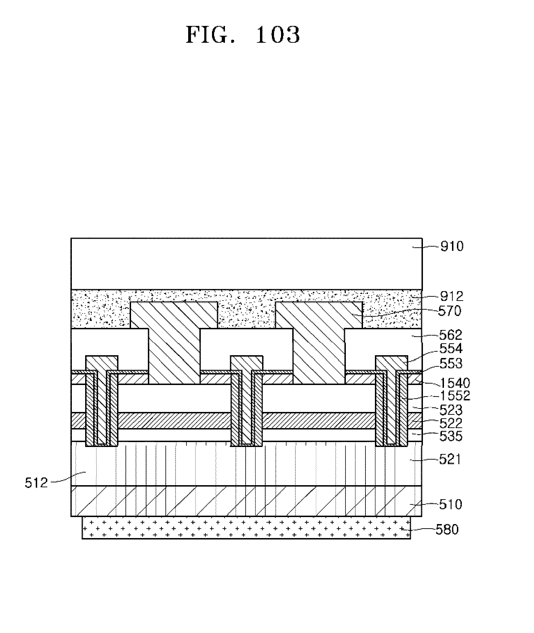

Referring to FIG. 102, a heat sink 910 may be attached to the source electrodes 570 using an adhesion member 912. Subsequently, the substrate 505 may be detached from the lower nitride-based semiconductor layer 510. The substrate 505 may be detached from the lower nitride-based semiconductor layer 510 using a laser lift-off process. Referring to FIG. 103, a drain electrode 580 may be formed on the exposed surface of the lower nitride-based semiconductor layer 510 opposite to the first nitride-based semiconductor layer 521. The drain electrode 580 may be formed of a material exhibiting an ohmic contact with respect to the lower nitride-based semiconductor layer 510. In some embodiments, the drain electrode 580 may be formed to include a titanium (Ti) layer, an aluminum (Al) layer, a palladium (Pd) layer, a tungsten (W) layer, a nickel (Ni) layer, a chrome (Cr) layer, a platinum (Pt) layer, a gold (Au) layer, a silver (Ag) layer, or an alloy containing at least two thereof.

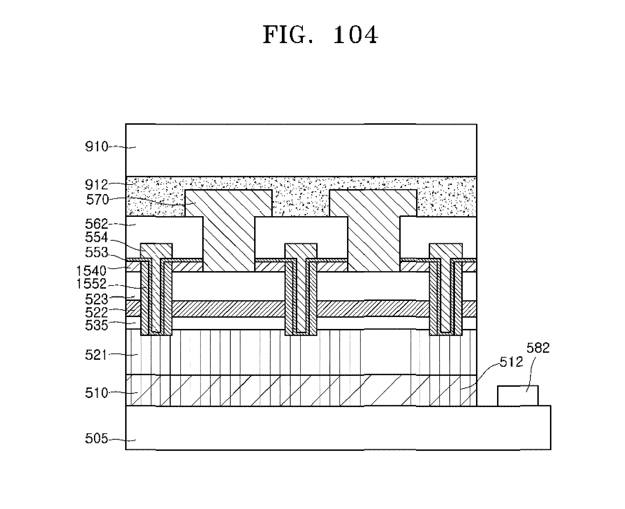

In some other embodiments, after the source electrodes 570 illustrated in FIG. 101 are formed, the first, second, third and upper nitride-based semiconductor layers 521, 522, 523 and 1540 and the mask patterns 535 may be patterned to expose a portion of the lower nitride-based semiconductor layer 510. Subsequently, a drain electrode 582 may be formed on the exposed portion of the lower nitride-based semiconductor layer 510. As a result, a nitride-based transistor illustrated in FIG. 104 can be fabricated. Even in this case, the heat sink 910 may also be additionally formed on the source electrodes 570.

According to the embodiments as set forth above, in a nitride-based transistor having a vertical channel, a first nitride-based semiconductor layer doped with first-type dopants may be disposed between a gate dielectric layer and a second nitride-based semiconductor layer doped with second-type dopants. In addition, a gate electrode may be disposed on a sidewall of the gate dielectric layer opposite to the first nitride-based semiconductor layer doped with first-type dopants. Thus, a depletion region may be formed in the first nitride-based semiconductor layer doped with first-type dopants at an equilibrium state, and a width of the depletion region in the first nitride-based semiconductor layer doped with first-type dopants may be controlled by a gate bias applied to the gate electrode. That is, a vertical channel layer may be formed in the first nitride-based semiconductor layer doped with first-type dopants if the gate bias applied to the gate electrode is higher than a threshold voltage of the nitride-based transistor. Accordingly, if the first nitride-based semiconductor layer doped with first-type dopants is an N-type semiconductor layer and the second nitride-based semiconductor layer doped with second-type dopants is a P-type semiconductor layer, an N-type channel layer may be formed in the N-type semiconductor layer to increase a channel mobility of the nitride-based transistor.

In addition, a current blocking insulation layer may be disposed under the second nitride-based semiconductor layer doped with second-type dopants. In such a case, the current blocking insulation layer may block a leakage current that flows through the second nitride-based semiconductor layer doped with second-type dopants. The current blocking insulation layer may be formed of a nitride-based material layer doped with carbon ions or iron ions, which has substantially the same lattice constant as the first and second nitride-based semiconductor layers. Accordingly, the first nitride-based semiconductor layer and the current blocking insulation layer may not be deformed because the first nitride-based semiconductor layer and the current blocking insulation layer have substantially the same lattice constant.

Moreover, even though the first and second nitride-based semiconductor layers are grown on a substrate having a different lattice constant from the first and second nitride-based semiconductor layers, a density of line-shaped dislocations in the first and second nitride-based semiconductor layers may be remarkably reduced because of the presence of mask patterns which are disposed between the first nitride-based semiconductor layer and the substrate. Accordingly, the mask patterns may also block a leakage current that flows between a source electrode and a drain electrode of the nitride-based transistor. As a result, the reliability of the nitride-based transistor may be improved.

The embodiments of the present disclosure have been disclosed above for illustrative purposes. Those skilled in the art will appreciate that various modifications, additions and substitutions are possible, without departing from the scope and spirit of the present disclosure as disclosed in the accompanying claims.

## Claims

1. A method of fabricating a nitride-based transistor, the method comprising:
(a) sequentially forming a first nitride-based semiconductor layer doped with dopants having a first type, a second nitride-based semiconductor layer doped with dopants having a second type, and a third nitride-based semiconductor layer doped with dopants having the first type on a substrate;
(b) forming a first trench that penetrates the third nitride-based semiconductor layer and the second nitride-based semiconductor layer and extends into the first nitride-based semiconductor layer;
(c) forming a fourth nitride-based semiconductor layer doped with dopants having the first type to fill the first trench;
(d) forming a second trench in the fourth nitride-based semiconductor layer;
(e) forming a gate electrode in the second trench;
(f) forming a source electrode electrically connected to at least one of the third and fourth nitride-based semiconductor layers; and
(g) forming a drain electrode electrically connected to the first nitride-based semiconductor layer.

2. A method of fabricating a nitride-based transistor, the method comprising:
(a) sequentially forming a lower nitride-based semiconductor layer heavily doped with dopants having a first type, a first nitride-based semiconductor layer lightly doped with dopants having the first type, a second nitride-based semiconductor layer doped with dopants having a second type, and a third nitride-based semiconductor layer doped with dopants having the first type on a substrate;
(b) forming a first trench that penetrates the third and second nitride-based semiconductor layers and the current blocking insulation layer and extends into the first nitride-based semiconductor layer;
(c) forming a fourth nitride-based semiconductor layer doped with dopants having the first type on the third nitride-based semiconductor layer to fill the first trench;
(d) forming an upper nitride-based semiconductor layer heavily doped with dopants having the first type on the fourth nitride-based semiconductor layer;
(e) pattering at least the upper nitride-based semiconductor layer and the fourth nitride-based semiconductor layer to form a second trench in the first trench;
(f) forming a gate electrode in the second trench;
(g) forming a source electrode that contacts the upper nitride-based semiconductor layer and exhibits an ohmic contact with respect to the upper nitride-based semiconductor layer; and
(h) forming a drain electrode that contacts the lower nitride-based semiconductor layer and exhibits an ohmic contact with respect to the lower nitride-based semiconductor layer.

3. A method of fabricating a nitride-based transistor, the method comprising:
(a) sequentially forming a lower nitride-based semiconductor layer heavily doped with dopants having a first type, a first nitride-based semiconductor layer lightly doped with dopants having the first type, a second nitride-based semiconductor layer doped with dopants having a second type, and an upper nitride-based semiconductor layer doped with dopants having the first type on a substrate;
(b) forming a first trench that penetrates the upper and second nitride-based semiconductor layers and extends into the first nitride-based semiconductor layer;
(c) forming a third nitride-based semiconductor layer doped with dopants having the first type to fill the first trench;
(d) pattering the third nitride-based semiconductor layer to form a second trench in the first trench;
(e) forming a gate electrode in the second trench;
(f) forming a source electrode that contacts the upper nitride-based semiconductor layer and exhibits an ohmic contact with respect to the upper nitride-based semiconductor layer; and
(g) forming a drain electrode that contacts the lower nitride-based semiconductor layer and exhibits an ohmic contact with respect to the lower nitride-based semiconductor layer.

4. A nitride-based transistor comprising:
a first nitride-based semiconductor layer doped with dopants having a first type;
a pair of second nitride-based semiconductor patterns doped with dopants having a second type and disposed in the first nitride-based semiconductor layer;
a third nitride-based semiconductor layer doped with dopants having the first type and disposed on the first nitride-based semiconductor layer;
a gate dielectric layer disposed on sidewalls and a bottom surface of a trench vertically penetrating the first nitride-based semiconductor layer between the pair of second nitride-based semiconductor patterns;
a gate electrode disposed in the trench surrounded by the gate dielectric layer;
a source electrode electrically connected to the third nitride-based semiconductor layer; and
a drain electrode electrically connected to the first nitride-based semiconductor layer.

5. A method of fabricating a nitride-based transistor, the method comprising:
(a) sequentially forming a first nitride-based semiconductor layer doped with dopants having a first type, a current blocking insulation layer, a second nitride-based semiconductor layer doped with dopants having a second type, and a third nitride-based semiconductor layer doped with dopants having the first type on a substrate;
(b) forming a first trench that penetrates the third and second nitride-based semiconductor layers and the current blocking insulation layer and extends into the first nitride-based semiconductor layer;
(c) forming a fourth nitride-based semiconductor layer doped with dopants having the first type to fill the first trench;
(d) forming a second trench in the fourth nitride-based semiconductor layer;
(e) forming a gate electrode in the second trench;
(f) forming a source electrode electrically connected to at least one of the third and fourth nitride-based semiconductor layers; and
(g) forming a drain electrode electrically connected to the first nitride-based semiconductor layer.

6. A method of fabricating a nitride-based transistor, the method comprising:
(a) sequentially forming a lower nitride-based semiconductor layer heavily doped with dopants having a first type, a first nitride-based semiconductor layer lightly doped with dopants having the first type, a current blocking insulation layer, a second nitride-based semiconductor layer doped with dopants having a second type, and a third nitride-based semiconductor layer doped with dopants having the first type on a substrate;
(b) forming a first trench that penetrates the third and second nitride-based semiconductor layers and the current blocking insulation layer and extends into the first nitride-based semiconductor layer;
(c) forming a fourth nitride-based semiconductor layer doped with dopants having the first type on the third nitride-based semiconductor layer to fill the first trench;
(d) forming an upper nitride-based semiconductor layer heavily doped with dopants having the first type on the fourth nitride-based semiconductor layer;
(e) pattering at least the upper nitride-based semiconductor layer and the fourth nitride-based semiconductor layer to form a second trench in the first trench;
(f) forming a gate electrode in the second trench;
(g) forming a source electrode that contacts the upper nitride-based semiconductor layer and exhibits an ohmic contact with respect to the upper nitride-based semiconductor layer; and
(h) forming a drain electrode that contacts the lower nitride-based semiconductor layer and exhibits an ohmic contact with respect to the lower nitride-based semiconductor layer.

7. A method of fabricating a nitride-based transistor, the method comprising:
(a) sequentially forming a lower nitride-based semiconductor layer heavily doped with dopants having a first type, a first nitride-based semiconductor layer lightly doped with dopants having the first type, a current blocking insulation layer, a second nitride-based semiconductor layer doped with dopants having a second type, and an upper nitride-based semiconductor layer doped with dopants having the first type on a substrate;
(b) forming a first trench that penetrates the upper and second nitride-based semiconductor layers and the current blocking insulation layer and extends into the first nitride-based semiconductor layer;
(c) forming a third nitride-based semiconductor layer doped with dopants having the first type to fill the first trench;
(d) pattering the third nitride-based semiconductor layer to form a second trench in the first trench;
(e) forming a gate electrode in the second trench;
(f) forming a source electrode that contacts the upper nitride-based semiconductor layer and exhibits an ohmic contact with respect to the upper nitride-based semiconductor layer; and
(g) forming a drain electrode that contacts the lower nitride-based semiconductor layer and exhibits an ohmic contact with respect to the lower nitride-based semiconductor layer.

8. A nitride-based transistor comprising:
a first nitride-based semiconductor layer doped with dopants having a first type;
a pair of second nitride-based semiconductor patterns doped with dopants having a second type and disposed in the first nitride-based semiconductor layer;
current blocking insulation patterns disposed between the first nitride-based semiconductor layer and bottom surfaces of the second nitride-based semiconductor patterns;
a third nitride-based semiconductor layer doped with dopants having the first type and disposed on the first nitride-based semiconductor layer;
a gate dielectric layer disposed on sidewalls and a bottom surface of a trench vertically penetrating the first nitride-based semiconductor layer between the pair of second nitride-based semiconductor patterns;
a gate electrode disposed in the trench surrounded by the gate dielectric layer;
a source electrode electrically connected to the third nitride-based semiconductor layer; and
a drain electrode electrically connected to the first nitride-based semiconductor layer.

9. A method of fabricating a nitride-based transistor, the method comprising:
(a) forming nitride seed patterns on a substrate;
(b) forming a nitride buffer layer on the substrate to cover the nitride seed patterns;
(c) forming mask patterns on the nitride buffer layer to overlap with the nitride seed patterns;
(d) growing a lower nitride-based semiconductor layer heavily doped with dopants having a first type on the nitride buffer layer to cover the mask patterns;
(e) sequentially forming a first nitride-based semiconductor layer doped with dopants having the first type, a second nitride-based semiconductor layer doped with dopants having a second type, and a third nitride-based semiconductor layer doped with dopants having the first type on the lower nitride-based semiconductor layer;
(f) forming a first trench that penetrates the third and second nitride-based semiconductor layers and extends into the first nitride-based semiconductor layer;
(g) forming a fourth nitride-based semiconductor layer doped with dopants having the first type on the third nitride-based semiconductor layer to fill the first trench;
(h) forming an upper nitride-based semiconductor layer heavily doped with dopants having the first type on the fourth nitride-based semiconductor layer;
(i) pattering at least the upper and fourth nitride-based semiconductor layers to form a second trench in the first trench;
(j) forming a gate electrode in the second trench; and
(k) forming a source electrode that contacts the upper nitride-based semiconductor layer and a drain electrode that contacts the lower nitride-based semiconductor layer,
wherein the source electrode exhibits an ohmic contact with respect to the upper nitride-based semiconductor layer and the drain electrode exhibits an ohmic contact with respect to the lower nitride-based semiconductor layer.

10. A method of fabricating a nitride-based transistor, the method comprising:
(a) forming nitride seed patterns on a substrate;
(b) forming a nitride buffer layer on the substrate to cover the nitride seed patterns;
(c) forming mask patterns on the nitride buffer layer to overlap with the nitride seed patterns;
(d) growing a lower nitride-based semiconductor layer heavily doped with dopants having a first type on the nitride buffer layer to cover the mask patterns;
(e) sequentially forming a first nitride-based semiconductor layer doped with dopants having the first type, a second nitride-based semiconductor layer doped with dopants having a second type, and an upper nitride-based semiconductor layer doped with dopants having the first type on the lower nitride-based semiconductor layer;
(f) forming a first trench that penetrates the upper and second nitride-based semiconductor layers and extends into the first nitride-based semiconductor layer;
(g) forming a third nitride-based semiconductor layer doped with dopants having the first type to fill the first trench;
(h) patterning the third nitride-based semiconductor layer to form a second trench in the first trench;
(i) forming a gate electrode in the second trench;
(j) forming a source electrode that contacts the upper nitride-based semiconductor layer and exhibits an ohmic contact with respect to the upper nitride-based semiconductor layer; and
(k) forming a drain electrode that contacts the lower nitride-based semiconductor layer and exhibits an ohmic contact with respect to the lower nitride-based semiconductor layer.

11. A method of fabricating a nitride-based transistor, the method comprising:
(a) forming a first nitride-based semiconductor layer doped with dopants having a first type on a substrate;
(b) forming mask patterns on the first nitride-based semiconductor layer;
(c) growing a second nitride-based semiconductor layer doped with dopants having a second type on the first nitride-based semiconductor layer to cover the mask patterns;
(d) forming a third nitride-based semiconductor layer doped with dopants having the first type on the second nitride-based semiconductor layer;
(e) forming a first trench that penetrates the third and second nitride-based semiconductor layers and extends into the first nitride-based semiconductor layer;
(f) forming a fourth nitride-based semiconductor layer doped with dopants having the first type to fill the first trench;
(g) forming a second trench in the fourth nitride-based semiconductor layer;
(h) forming a gate electrode in the second trench;
(i) forming a source electrode electrically connected to the fourth nitride-based semiconductor layer; and
(j) forming a drain electrode electrically connected to the first nitride-based semiconductor layer.

12. A method of fabricating a nitride-based transistor, the method comprising:
(a) sequentially forming a lower nitride-based semiconductor layer heavily doped with dopants having a first type and a first nitride-based semiconductor layer doped with dopants having the first type on a substrate;
(b) forming mask patterns on the first nitride-based semiconductor layer;
(c) growing a second nitride-based semiconductor layer doped with dopants having a second type on the first nitride-based semiconductor layer to cover the mask patterns;
(d) forming a third nitride-based semiconductor layer doped with dopants having the first type on the second nitride-based semiconductor layer;
(e) forming a first trench that penetrates the third and second nitride-based semiconductor layers and extends into the first nitride-based semiconductor layer;
(f) forming a fourth nitride-based semiconductor layer doped with dopants having the first type to fill the first trench;
(g) forming an upper nitride-based semiconductor layer heavily doped with dopants having the first type on the fourth nitride-based semiconductor layer;
(h) patterning at least the upper and fourth nitride-based semiconductor layers to form a second trench in the first trench;
(i) forming a gate electrode in the second trench;
(j) forming a source electrode that contacts the upper nitride-based semiconductor layer and exhibits an ohmic contact with respect to the upper nitride-based semiconductor layer; and
(k) forming a drain electrode that contacts the lower nitride-based semiconductor layer and exhibits an ohmic contact with respect to the lower nitride-based semiconductor layer.

13. A method of fabricating a nitride-based transistor, the method comprising:
(a) sequentially forming a lower nitride-based semiconductor layer heavily doped with dopants having a first type and a first nitride-based semiconductor layer doped with dopants having the first type on a substrate;
(b) forming mask patterns on the first nitride-based semiconductor layer;
(c) growing a second nitride-based semiconductor layer doped with dopants having a second type on the first nitride-based semiconductor layer to cover the mask patterns;
(d) sequentially forming a third nitride-based semiconductor layer doped with dopants having the first type and an upper nitride-based semiconductor layer heavily doped with dopants having the first type on the second nitride-based semiconductor layer;
(e) forming a first trench that penetrates the upper, third and second nitride-based semiconductor layers and extends into the first nitride-based semiconductor layer;
(f) forming a fourth nitride-based semiconductor layer doped with dopants having the first type to fill the first trench;
(g) patterning the fourth nitride-based semiconductor layers to form a second trench in the first trench;
(h) forming a gate electrode in the second trench;
(i) forming a source electrode that contacts the upper nitride-based semiconductor layer and exhibits an ohmic contact with respect to the upper nitride-based semiconductor layer; and
(j) forming a drain electrode that contacts the lower nitride-based semiconductor layer and exhibits an ohmic contact with respect to the lower nitride-based semiconductor layer.
